(19) Europäisches Patentamt
European Patent Office
Office européen des brevets

(11) EP 2 135 911 B1

(12) **EUROPEAN PATENT SPECIFICATION**

(45) Date of publication and mention of the grant of the patent:
**28.05.2014 Bulletin 2014/22**

(21) Application number: **08739478.9**

(22) Date of filing: **31.03.2008**

(51) Int Cl.:
***C09K 3/00*** *(2006.01)*
***C08K 5/3435*** *(2006.01)*
***C08K 5/45*** *(2006.01)*
***C08L 101/00*** *(2006.01)*
***H01L 31/0216*** *(2014.01)*
*C08K 5/13* *(2006.01)*

(86) International application number:
**PCT/JP2008/056365**

(87) International publication number:
**WO 2008/123504 (16.10.2008 Gazette 2008/42)**

(54) **ULTRAVIOLET RAY ABSORBER COMPOSITION**

ULTRAVIOLETTSTRAHLENABSORBIERENDE ZUSAMMENSETZUNG

COMPOSITION ABSORBANTE DE RAYONS ULTRAVIOLETS

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.03.2007 JP 2007093061**
**20.08.2007 JP 2007213951**

(43) Date of publication of application:
**23.12.2009 Bulletin 2009/52**

(73) Proprietor: **FUJIFILM Corporation**
**Tokyo 106-8620 (JP)**

(72) Inventors:
- **HANAKI, Naoyuki**
**Minami-ashigara-shi**
**Kanagawa 250-0193 (JP)**
- **YAWATA, Toshihiko**
**Minami-ashigara-shi**
**Kanagawa 250-0193 (JP)**

(74) Representative: **Grünecker, Kinkeldey, Stockmair & Schwanhäusser**
**Leopoldstrasse 4**
**80802 München (DE)**

(56) References cited:
**EP-A1- 2 113 536**
**EP-A1- 2 116 585**
**WO-A1-2007/091716**
**GB-A- 1 309 349**
**JP-A- 11 147 974**
**JP-B1- 46 035 721**
**JP-B1- 49 011 155**

EP 2 135 911 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

TECHNICAL FIELD

The present invention relates to an ultraviolet absorbent composition. More specifically, the present invention relates to an ultraviolet absorbent composition that causes neither deposition of an ultraviolet absorbent nor bleed-out owing to a long-term use, and that is excellent in a long-wavelength ultraviolet absorption capability as well as light stability by virtue of maintaining the capability for a long period of time.

BACKGROUND ART

Ultraviolet absorbents have been used in combination with various resins for providing the resins with ultraviolet-absorptivity. Both inorganic and organic ultraviolet absorbents are used. The inorganic ultraviolet absorbents (see, for example, JP-A-5-339033 ("JP-A" means unexamined published Japanese patent application), JP-A-5-345639 and JP-A-6-56466) are superior in durability such as weather resistance and heat resistance. However, the freedom in selecting the compound is limited, because the absorption wavelength is determined by the band gap of the compound. In addition, there is no inorganic absorbent that absorbs the light in a long-wavelength ultraviolet (UV-A) range of 320 to 400 nm. And any such absorbent that absorbs long-wavelength ultraviolet would have color because it would have absorption also in the visible range.

In contrast, the freedom in designing the absorbent structure is much wider for organic ultraviolet absorbents, and thus, it is possible to obtain absorbents having various absorption wavelengths by designing the absorbent chemical structure properly.

Various organic ultraviolet absorbent systems have been studied, and for absorption in the long-wavelength ultraviolet range, it is conceivable either to use an absorbent having the wavelength of maximal absorption in the long-wavelength ultraviolet range or to use a high concentration of absorbent. However, the absorbents described in, for example, JP-A-6-145387 and JP-A-2003-177235 having the wavelength of maximal absorption in the long-wavelength ultraviolet range are inferior in light stability, and their absorption capability declines with time.

In contrast, benzophenone- and benzotriazole-based ultraviolet absorbents are relatively higher in light stability, and increase in concentration or film thickness leads to relatively clean blocking of the light in the longer-wavelength range (see, for example, JP-T-2005-517787 ("JP-T" means published Japanese translation of PCT application) and JP-A-7-285927). However, when such an ultraviolet absorbent is applied as mixed with a resin or the like, the film thickness is limited to several tens of $\mu$m at the most. For utilizing the film thickness to block the light in the longer-wavelength range, it is necessary to add the ultraviolet absorbent to a considerably high concentration. However, simple addition of highly-concentrated ultraviolet absorbent only results in a coloring problem. There are some ultraviolet absorbents that are irritative to skin and accumulate in the body among the benzophenone- and benzotriazole-based ultraviolet absorbents, and thus, intensive care should have been given to these compounds in use. Further, JP-A-60-170842 and JP-B-49-11155 ("JP-B" means examined Japanese patent publication) each describe five-membered ring compound containing two sulfur atoms. The ultraviolet absorbent contained in the ultraviolet absorbent composition of the present invention has a sharp waveform, and is able to absorb ultraviolet light up to a long-wavelength range. Accordingly, the ultraviolet absorbent used in the present invention has an advantage that there is no possibility of coloring, when compared to known ultraviolet absorbents described above.

Various kinds of additives are added to polymer materials or resins to prevent them from deterioration. The deterioration of the polymer material is essentially caused by autoxidation. In many polymer materials, inhibition of the autoxidation has been tackled by adding thereto several kinds of additives selected from an ultraviolet absorbent, an antioxidant, a peroxide decomposer, a radical inhibitor, a metal deactivator, an acid trapping agent and the like (JP-A-2008-52041 and JP-A-2004-117997). However, it is known that when an ultraviolet absorbent and other additives are simply added to a polymer material, reduction of compatibility with the polymer generally causes such a phenomenon that particles come up to the polymer surface, namely "bleed out". In the ultraviolet absorbent used in the present invention that is able to absorb ultraviolet light up to a long-wavelength ultraviolet range (UV-A), problems also arise that when the ultraviolet absorbent is simply mixed with other proper additives to form a mixture, compatibility of the formed mixture at the time of addition to the polymer and solubility of the formed mixture at the time of dissolution to a solvent become insufficient, and consequently solid deposits, which results in a powder-mottled polymer material.

DISCLOSURE OF INVENTION

As a result of intensive investigation, the present inventors have found that when a composition containing a combination of at least one ultraviolet absorbent represented by formula (2) or (B-1) that is excellent in a long-wavelength ultraviolet absorption capability and at least one compound represented by formula (TS-I) or (TS-II) is mixed with a resin

or the like, thereby using them as a composition, suppression function of light deterioration to the resin is maintained as it is, without occurrence of both deposition of the ultraviolet absorbent and bleed out owing to a long-term use.

The present invention has been made on the basis of the above-described findings.

The present invention provides the following means:

<1> An ultraviolet absorbent composition, comprising an ultraviolet absorbent represented by formula (2) or (B-I), and a compound represented by formula (TS-I) or (TS-II):

[Chemical formula 1]

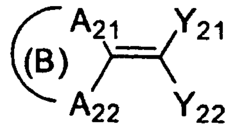

Formula (2)

wherein $A_{21}$ and $A_{22}$ each represent a hetero atom; $Y_2$ and $Y_{22}$ each independently represent a hydrogen atom or a monovalent substituent; at least one of $Y_{21}$ and $Y_{22}$ represents a substituent having a Hammett substituent constant $\sigma p$ of 0.2 or more; $Y_{21}$ and $Y_{22}$ may bind to each other to form a ring; and (B) represents a group of atoms necessary for forming a five- or six-membered ring with $A_{21}$, $A_{22}$ and the carbon atom;

[Chemical formula 2]

Formula (B－I)

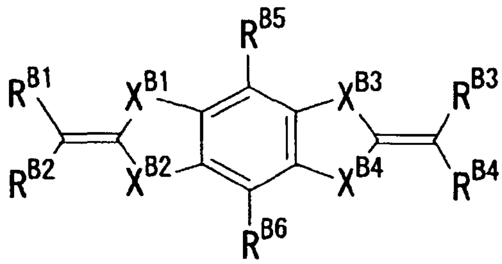

wherein $R^{B1}$, $R^{B2}$, $R^{B3}$ and $R^{B4}$ each independently represent a hydrogen atom or a monovalent substituent; $R^{B5}$ and $R^{B6}$ each independently represent a hydrogen atom or a monovalent substituent; and $X^{B1}$, $X^{B2}$, $X^{B3}$ and $X^{B4}$ each independently represent a hetero atom;

[Chemical formula 3]

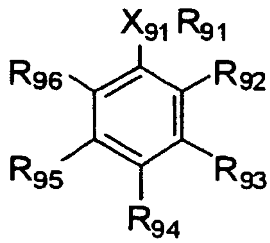

(TS-I)

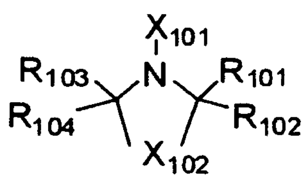

(TS-II)

wherein, in formula (TS-1), $R_{91}$ represents a hydrogen atom, a substituted or unsubstituted alkyl group, a substituted or unsubstituted alkenyl group, a substituted or unsubstituted aryl group, a substituted or unsubstituted heterocyclic group, a substituted or unsubstituted acyl group, a substituted or unsubstituted alkyl- or alkenyl-oxycarbonyl group, a substituted or unsubstituted aryloxycarbonyl group, a substituted or unsubstituted alkyl sulfonyl group, a substituted or unsubstituted arylsulfonyl group, or $-Si(R_{97})(R_{98})(R_{99})$, in which $R_{97}$, $R_{98}$, and $R_{99}$, which may be the same as or different from each other, each independently represent an alkyl group, an alkenyl group, an aryl group, an alkoxy group, an alkenyloxy group or an aryloxy group; $-X_{91}-$ represents -O-,- S-, or $-N(-R_{100})-$, in which $R_{1000}$ has the same meaning as $R_{91}$; $R_{92}$, $R_{93}$, $R_{94}$, $R_{95}$ and $R_{96}$, which may be the same as or different from each other, each independently represent a hydrogen atom or a substituent; and all of $R_{91}$, $R_{92}$, $R_{93}$, $R_{94}$, $R_{95}$, $R_{96}$, and $R_{100}$ cannot

simultaneously represent a hydrogen atom, respectively, and the total number of carbon atoms is 10 or more; and wherein, in formula (TS-II), $R_{101}$, $R_{102}$, $R_{103}$, and $R_{104}$ each independently represent a hydrogen atom, a substituted or unsubstituted alkyl group, or a substituted or unsubstituted alkenyl group; each combination of $R_{101}$ and $R_{102}$, and/or $R_{103}$ and $R_{104}$ may bind to each other to form a 5- to 7-membered ring; $X_{101}$ represents a hydrogen atom, a substituted or unsubstituted alkyl group, a substituted or unsubstituted alkenyl group, a substituted or unsubstituted alkoxy group, a substituted or unsubstituted alkenyloxy group, a substituted or unsubstituted alkyl- or alkenyl-oxycarbonyl group, a substituted or unsubstituted aryloxycarbonyl group, a substituted or unsubstituted acyl group, a substituted or unsubstituted acyloxy group, a substituted or unsubstituted alkyloxycarbonyloxy group, a substituted or unsubstituted alkenyloxycarbonyloxy group, a substituted or unsubstituted aryloxycarbonyloxy group, a substituted or unsubstituted alkyl- or alkenyl-sulfonyl group, a substituted or unsubstituted arylsulfonyl group, a substituted or unsubstituted alkyl- or alkenyl-sulfinyl group, a substituted or unsubstituted arylsulfinyl group, a substituted or unsubstituted sulfamoyl group, a substituted or unsubstituted carbamoyl group, a hydroxy group or an oxy radical group; and $X_{102}$ represents a group of hetero atoms necessary for forming a 5- to 7-membered ring.

<2> The ultraviolet absorbent composition described in the above item <1>, wherein the ultraviolet absorbent represented by formula (2) is an ultraviolet absorbent represented by formula (3):

[Chemical formula 4]

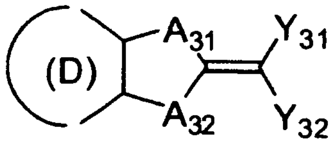

Formula (3)

wherein $A_{31}$ and $A_{32}$ each independently represent a hetero atom selected from the group consisting of an oxygen atom, a nitrogen atom and a sulfur atom; $Y_{31}$ and $Y_{32}$ each independently represent a hydrogen atom or a monovalent substituent; at least one of $Y_{31}$ and $Y_{32}$ represents a substituent having a Hammett substituent constant $\sigma p$ of 0.2 or more; $Y_{31}$ and $Y_{32}$ may bind to each other to form a ring; and (D) represents a group of atoms necessary for forming a five- or six-membered ring with the carbon atoms.

<3> The ultraviolet absorbent composition described in the above item <2>, wherein the ultraviolet absorbent represented by formula (3) is an ultraviolet absorbent represented by formula (4):

[Chemical formula 5]

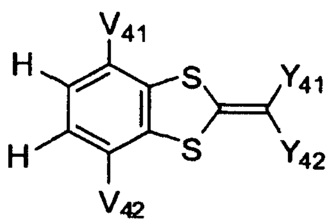

Formula (4)

wherein $Y_{41}$ and $Y_{42}$ each independently represent a monovalent substituent; at least one of $Y_{41}$ and $Y_{42}$ represents a cyano group, and the other represents a substituted or unsubstituted alkylcarbonyl group, a substituted or unsubstituted arylcarbonyl group, a substituted or unsubstituted heterocyclic carbonyl group, a substituted or unsubstituted alkylsulfonyl group, or a substituted or unsubstituted arylsulfonyl group; and $V_{41}$ and $V_{42}$ each independently represent a hydrogen atom or a monovalent substituent.

<4> The ultraviolet absorbent composition described in the above item <1>, wherein the ultraviolet absorbent represented by formula (B-1) is an ultraviolet absorbent represented by formula (B-Ia):

[Chemical formula 6]

Formula (B− I a)

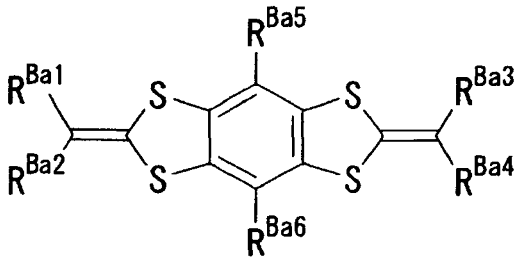

wherein $R^{Ba1}$, $R^{Ba2}$, $R^{Ba3}$ and $R^{Ba4}$ each represent a monovalent substituent; at least one of $R^{Ba1}$, $R^{Ba2}$, $R^{Ba3}$ and $R^{Ba4}$ represents a cyano group, a substituted or unsubstituted alkoxycarbonyl group, a substituted or unsubstituted aryloxycarbonyl group, a substituted or unsubstituted carbamoyl group, a substituted or unsubstituted alkylcarbonyl group, a substituted or unsubstituted arylcarbonyl group, a substituted or unsubstituted alkylsulfonyl group, or a substituted or unsubstituted arylsulfonyl group, and the others are a cyano group, a substituted or unsubstituted carbamoyl group, a substituted or unsubstituted sulfamoyl group, a nitro group, a substituted or unsubstituted acyl group, a substituted or unsubstituted alkylsulfonyl group, a substituted or unsubstituted arylsulfonyl group, a substituted or unsubstituted alkylsulfinyl group, a substituted or unsubstituted arylsulfinyl group, a substituted or unsubstituted alkoxycarbonyl group, a substituted or unsubstituted aryloxycarbonyl group, a substituted or unsubstituted alkyl group, a substituted or unsubstituted aryl group, or a substituted or unsubstituted heterocyclic group; and $R^{Ba5}$ and $R^{Ba6}$ each independently represent a substituted or unsubstituted alkoxy group, a substituted or unsubstituted aryloxy group, a substituted or unsubstituted acyloxy group, a substituted or unsubstituted alkoxycarbonyloxy group, a substituted or unsubstituted aryloxycarbonyloxy group, a substituted or unsubstituted carbamoyloxy group, a substituted or unsubstituted amino group, a substituted or unsubstituted acylamino group, or a substituted or unsubstituted carbamoylamino group.

<5> The ultraviolet absorbent composition described in any one of the above items <1> to <4>, wherein the total content of the ultraviolet absorbent represented by formula (2) or (B-1) is more than 0% by mass and 80% by mass or less of the composition in all.

<6> The ultraviolet absorbent composition described in any one of the above items <1> to <5>, wherein the total content of the compound represented by formula (TS-I) or (TS-II) is more than 0% by mass and 80% by mass or less of the composition in all.

<7> The ultraviolet absorbent composition described in any one of the above items <1> to <6>, wherein a mixing ratio of the ultraviolet absorbent represented by formula (2) or (B-1) and the compound represented by formula (TS-I) or (TS-II) is 1:5 to 5:1.

<8> The ultraviolet absorbent composition described in any one of the above items <1> to <7>, comprising the compound represented by formula (TS-II).

<9> The ultraviolet absorbent composition described in any one of the above items <1> to <8>, wherein the compound represented by formula (TS-II) is a compound represented by formula (TS-IIa):

[Chemical formula 7]

Formula (TS-IIa)

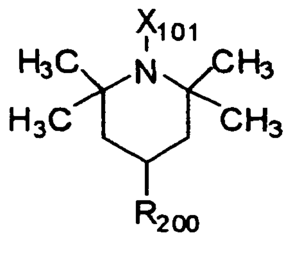

wherein $X_{101}$ represents a hydrogen atom, a substituted or unsubstituted alkyl group, a substituted or unsubstituted alkenyl group, a substituted or unsubstituted alkoxy group, a substituted or unsubstituted alkenyloxy group, a substituted or unsubstituted alkyl- or alkenyl-oxycarbonyl group, a substituted or unsubstituted aryloxycarbonyl group, a substituted or unsubstituted acyl group, a substituted or unsubstituted acyloxy group, a substituted or unsubstituted alkyloxycarbonyloxy group, a substituted or unsubstituted alkenyloxycarbonyloxy group, a substituted or unsubstituted aryloxycarbonyloxy group, a substituted or unsubstituted alkyl- or alkenyl-sulfonyl group, a substituted or unsubstituted arylsulfonyl group, a substituted or unsubstituted alkyl- or alkenyl-sulfinyl group, a substituted or unsubstituted arylsulfinyl group, a substituted or unsubstituted sulfamoyl group, a substituted or unsubstituted carbamoyl group, a hydroxy group or an oxy radical group; and $R_{200}$ represents a monovalent substituent.

<10> An ultraviolet absorbent dispersion, comprising the ultraviolet absorbent composition described in any one of the above items <1> to <9>.

<11> An ultraviolet absorbent solution, comprising the ultraviolet absorbent composition described in any one of the above items <1> to <9>.

<12> A polymer material, comprising the ultraviolet absorbent composition described in any one of the above items <1> to <9>.

Other and further features and advantages of the invention will appear more fully from the following description.

BEST MODE FOR CARRYING OUT INVENTION

Hereinafter, the present invention will be described in detail.

The ultraviolet absorbent composition of the present invention is characterized in that the composition contains at least one ultraviolet absorbent represented by formula (2) or (B-1) and at least one compound represented by the formula (TS-I) or (TS-II). The compound represented by formula (TS-I) or (TS-II), when used together with a variety of resin and the like, functions as a light stabilizer capable of preventing the resin from decomposition. In the ultraviolet absorbent composition of the present invention containing the above-described compound together with the ultraviolet absorbent represented by formula (2) or (B-1), not only light stability of the composition itself is improved, but also the ultraviolet absorbent is stabilized. Resultantly, the long-wavelength ultraviolet absorption capability of the ultraviolet absorbent can be maintained over a long period of time.

Hereinafter, the ultraviolet absorbent represented by formula (2) will be described.

[Chemical formula 8]

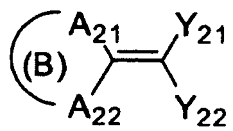

Formula (2)

$A_{21}$ and $A_{22}$ each independently represent a hetero atom. Examples of $A_{21}$ and $A_{22}$ include boron, nitrogen, oxygen, fluorine, silicon, phosphorus, sulfur and selenium atoms.

Preferable examples of $A_{21}$ and $A_{22}$ include nitrogen, oxygen and sulfur. Of these atoms, sulfur is especially preferable. Preferable combinations of $A_{21}$ and $A_{22}$ are oxygen-nitrogen, nitrogen-sulfur, nitrogen-nitrogen or sulfur-sulfur. Especially preferable combination is sulfur-sulfur.

$Y_{21}$ and $Y_{22}$ each independently represent a hydrogen atom or a monovalent substituent. Examples of the monovalent substituent include a cyano group, a substituted or unsubstituted carbamoyl group, a substituted or unsubstituted sulfamoyl group, a nitro group, a substituted or unsubstituted acyl group, a substituted or unsubstituted alkylsulfonyl group, a substituted or unsubstituted arylsulfonyl group, a substituted or unsubstituted alkylsulfinyl group, a substituted or unsubstituted arylsulfinyl group, a substituted or unsubstituted alkoxycarbonyl group, a substituted or unsubstituted aryloxycarbonyl group, a substituted or unsubstituted alkyl group, a substituted or unsubstituted aryl group, and a substituted or unsubstituted heterocyclic group. The substituent may be further substituted, and multiple substituents, if present, may be the same as or different from each other. In the present case, the substituent is the above-described monovalent substituent. In addition, the substituents may bind to each other to form a ring.

Examples of $Y_{21}$ and $Y_{22}$ include a cyano group, a carbamoyl group having 1 to 10 carbon atoms (preferably 2 to 8 carbon atoms, more preferably 2 to 5 carbon atoms) (e.g., methylcarbamoyl, ethylcarbamoyl, morpholinocarbonyl), a sulfamoyl group having 0 to 10 carbon atoms (preferably 2 to 8 carbon atoms, more preferably 2 to 5 carbon atoms) (e.g., methylsulfamoyl, ethylsulfamoyl, piperidinosulfonyl), a nitro group, an acyl group having 1 to 20 carbon atoms (preferably 1 to 12 carbon atoms, more preferably 1 to 8 carbon atoms) (e.g., formyl, acetyl, benzoyl, trichloroacetyl), an alkylsulfonyl group having 1 to 20 carbon atoms (preferably 1 to 10 carbon atoms, more preferably 1 to 8 carbon atoms), an arylsulfonyl group having 6 to 20 carbon atoms (preferably 6 to 10 carbon atoms) (e.g., methanesulfonyl,

ethanesulfonyl, benzenesulfonyl), an alkylsulfinyl group having 1 to 20 carbon atoms (preferably 1 to 10 carbon atoms, more preferably 1 to 8 carbon atoms), an arylsulfinyl group having 6 to 20 carbon atoms (preferably 6 to 10 carbon atoms) (e.g., methanesulfinyl, benzenesulfinyl), an alkoxycarbonyl group having 2 to 20 carbon atoms (preferably 2 to 12 carbon atoms, more preferably 2 to 8 carbon atoms) (e.g., methoxycarbonyl, ethoxycarbonyl, benzyloxycarbonyl), an aryloxycarbonyl group having 6 to 20 carbon atoms (preferably 6 to 12 carbon atoms, more preferably 6 to 8 carbon atoms) (e.g., phenoxycarbonyl),

an unsubstituted alkyl group having 1 to 18 carbon atoms (preferably 1 to 10 carbon atoms, more preferably 1 to 5 carbon atoms) (e.g., methyl, ethyl, propyl, butyl), a substituted alkyl group having 1 to 18 carbon atoms (preferably 1 to 10 carbon atoms, more preferably 1 to 5 carbon atoms) (e.g., hydroxymethyl, trifluoromethyl, benzyl, carboxyethyl, ethoxycarbonylmethyl, acetylaminomethyl), a substituted or unsubstituted aryl group having 6 to 20 carbon atoms (preferably 6 to 15 carbon atoms, more preferably 6 to 10 carbon atoms) (e.g., phenyl, naphthyl, p-carboxyphenyl, p-nitrophenyl, 3,5-dichlorophenyl, p-cyanophenyl, m-fluorophenyl, p-tolyl, p-bromophenyl), and a heterocyclic group (which may be substituted) having 1 to 20 carbon atoms (preferably 2 to 10 carbon atoms, more preferably 4 to 6 carbon atoms) (e.g., pyridyl, 5-methylpyridyl, thienyl, furyl, morpholino, tetrahydrofurfuryl). The substituent may be further substituted, and multiple substituents, if present, may be the same as or different from each other. In the present case, the substituent is the above-described substituent. In addition, the substituents may bind to each other to form a ring.

As $Y_{21}$ and $Y_{22}$, it is preferable that at least one of $Y_{21}$ and $Y_{22}$ has a Hammett substituent constant $\sigma p$ value of 0.2 or more.

The expression "Hammett substituent constant $\sigma$ value" used herein will be described. Hammett's rule is a rule of thumb advocated by L. P. Hammett in 1935 for quantitatively considering the effect of substituents on the reaction or equilibrium of benzene derivatives, and the appropriateness thereof is now widely recognized. The substituent constant determined in the Hammett's rule involves $\sigma_p$ value and $\sigma_m$ value. These values can be found in a multiplicity of general publications, and are detailed in, for example, "Lange's Handbook of Chemistry" 12th edition by J. A. Dean, 1979 (McGraw-Hill), "Kagaku no Ryoiki" special issue, No. 122, pp. 96 to 103, 1979 (Nankodo) and Chem.Rev., vol. 91, pp. 165 to 195, 1991. The substituent having a Hammett substituent constant $\sigma p$ of 0.2 or more in the present invention is an electron-withdrawing group. The $\sigma p$ value is preferably 0.25 or more, more preferably 0.3 or more, and particularly preferably 0.35 or more.

Examples thereof include a cyano group (0.66), a carboxyl group (-COOH: 0.45), an alkoxycarbonyl group (e.g. -COOMe: 0.45), an aryloxycarbonyl group (e.g. -COOPh: 0.44), a carbamoyl group ($-CONH_2$: 0.36), an alkylcarbonyl group (e.g. -COMe: 0.50), an arylcarbonyl group (e.g. -COPh: 0.43), an alkylsulfonyl group (e.g. $-SO_2Me$: 0.72), an arylsulfonyl group (e.g. $-SO_2Ph$: 0.68) and the like. In the present description, Me represents a methyl group and Ph represents a phenyl group. The values in parentheses are the $\sigma p$ values of typical substituents, as extracted from Chem. Rev., 1991, vol. 91, pp. 165 to 195.

$Y_{21}$ and $Y_{22}$ may bind to each other to form a ring. The $\sigma p$ values of $Y_{21}$ and $Y_{22}$ may not be specified when a ring is formed, but in the present invention, the $\sigma p$ values thereof when a ring is formed are defined, assuming that partial ring structures are substituted respectively as $Y_{21}$ and $Y_{22}$. For example, when a 1,3-indandione ring is formed, benzoyl groups are considered to be substituted respectively as $Y_{21}$ and $Y_{22}$.

Preferred examples of each of $Y_{21}$ and $Y_{22}$ include a cyano group, an alkylcarbonyl group, an arylcarbonyl group, an alkoxycarbonyl group, an aryloxycarbonyl, a carbamoyl group, a sulfinyl group, a sulfonyl group and a sulfamoyl group.

It is especially preferable that at least one of $Y_{21}$ and $Y_{22}$ is a cyano group, and the other is an alkylcarbonyl group, an arylcarbonyl group, a heterocyclic carbonyl group, an alkylsulfonyl group, or an arylsulfonyl group. It is preferable that $Y_{21}$ and $Y_{22}$ do not bind to each other to form any ring.

(B) represents a ring formed by binding $A_{21}$, $A_{22}$ and the carbon atom.

As the ring (B) formed by binding $A_{21}$, $A_{22}$ and the carbon atom, a five- or six-membered ring is preferable. Specifically, examples of the ring include a pyrimidine ring, an imidazolidine ring, an imidazoline ring, an oxazoline ring, a thiazoline ring, and a dithiole ring. These rings may have a monovalent substituent. Further, these rings may form a fused ring with an aromatic ring or the like.

As the ring (B), an imidazoline ring, an oxazoline ring, a thiazoline ring, a dithiole ring, or a benzo-fused ring thereof is preferable. More preferable ring is a benzodithiole ring, a benzoxazoline ring, a benzothiazoline ring, or a benzimidazoline ring. Especially preferable ring is a benzodithiole ring.

A preferable combination of the substituents in formula (2) is such a combination that at least one of $Y_{21}$ and $Y_{22}$ is a cyano group, and the other is an alkylcarbonyl group, an arylcarbonyl group, a heterocyclic carbonyl group, an alkylsulfonyl group, or an arylsulfonyl group; both $A_{21}$ and $A_{22}$ are a sulfur atom; and the ring formed by (B) is a benzodithiole ring.

The ultraviolet absorbent represented by formula (2) is preferably an ultraviolet absorbent represented by formula (3). Hereinafter, formula (3) will be described in detail.

[Chemical formula 9]

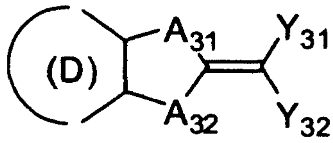

Formula (3)

(In formula (3), $A_{31}$ and $A_{32}$ each independently represent a hetero atom selected from the group consisting of an oxygen atom, a nitrogen atom and a sulfur atom; $Y_{31}$ and $Y_{32}$ each independently represent a hydrogen atom or a monovalent substituent; at least one of $Y_{31}$ and $Y_{32}$ represents a substituent having a Hammett substituent constant $\sigma p$ of 0.2 or more; $Y_{31}$ and $Y_{32}$ may bind to each other to form a ring; and (D) represents a group of atoms necessary for forming a five- or six-membered ring with the carbon atoms.)

$A_{31}$ and $A_{32}$ each independently represent a hetero atom selected from the group consisting of an oxygen atom, a nitrogen atom and a sulfur atom; preferably a sulfur atom. Preferable combinations of $A_{31}$ and $A_{32}$ are oxygen-nitrogen, nitrogen-sulfur, nitrogen-nitrogen or sulfur-sulfur. Especially preferable combination is sulfur-sulfur.

$Y_{31}$ and $Y_{32}$ each independently represent a hydrogen atom or a monovalent substituent. Examples of the monovalent substituent include a cyano group, a substituted or unsubstituted carbamoyl group, a substituted or unsubstituted sulfamoyl group, a nitro group, a substituted or unsubstituted acyl group, a substituted or unsubstituted alkylsulfonyl group, a substituted or unsubstituted arylsulfonyl group, a substituted or unsubstituted alkylsulfinyl group, a substituted or unsubstituted arylsulfinyl group, a substituted or unsubstituted alkoxycarbonyl group, a substituted or unsubstituted aryloxycarbonyl group, a substituted or unsubstituted alkyl group, a substituted or unsubstituted aryl group, and a substituted or unsubstituted heterocyclic group. Herein, at least one of $Y_{31}$ and $Y_{32}$ represents a substituent having a Hammett substituent constant $\sigma p$ of 0.2 or more. Examples of the substituent having a Hammett substituent constant $\sigma p$ of 0.2 or more include a cyano group, an alkylcarbonyl group, an arylcarbonyl group, an alkoxycarbonyl group, an aryloxycarbonyl group, a carbamoyl group, a sulfinyl group, a sulfonyl group and a sulfamoyl group.

It is especially preferable that at least one of $Y_{31}$ and $Y_{32}$ is a cyano group, and the other is a substituted or unsubstituted alkylcarbonyl group, a substituted or unsubstituted arylcarbonyl group, a substituted or unsubstituted heterocyclic carbonyl group, a substituted or unsubstituted alkylsulfonyl group, or a substituted or unsubstituted arylsulfonyl group.

Ring (D) represents a group of atoms necessary for forming a five- or six-membered ring with the carbon atoms.

Specific examples of the ring (D) include cycloalkanes such as cyclohexane and cyclopentane; aryls such as benzene; and heterocycles such as a pyridine ring, a pyrrole ring, a thiophene ring, a thiazole ring, an oxazole ring, and a pyrazole ring, and benzo-fused rings thereof. The ring is more preferable is a benzene ring.

A preferable combination of the substituents in formula (3) is such a combination that at least one of $Y_{31}$ and $Y_{32}$ is a cyano group, and the other is a substituted or unsubstituted alkylcarbonyl group, a substituted or unsubstituted arylcarbonyl group, a substituted or unsubstituted heterocyclic carbonyl group, a substituted or unsubstituted alkylsulfonyl group, or a substituted or unsubstituted arylsulfonyl group; both $A_{31}$ and $A_{32}$ are a sulfur atom; and the ring (D) is a benzene ring thereby forming a benzodithiole ring with $A_{31}$ and $A_{32}$.

The ultraviolet absorbent represented by formula (3) is preferably an ultraviolet absorbent represented by formula (4). Hereinafter, formula (4) will be described in detail.

[Chemical formula 10]

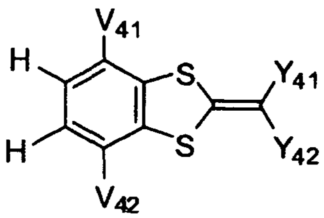

Formula (4)

(In formula (4), $Y_{41}$ and $Y_{42}$ each independently represent a monovalent substituent; at least one of $Y_{41}$ and $Y_{42}$ represents a cyano group, and the other represents a substituted or unsubstituted alkylcarbonyl group, a substituted or unsubstituted arylcarbonyl group, a substituted or unsubstituted heterocyclic carbonyl group, a substituted or unsubstituted alkylsulfonyl group, or a substituted or unsubstituted arylsulfonyl group.)

It is preferable that at least one of $Y_{41}$ and $Y_{42}$ is a cyano group, and the other is a substituted or unsubstituted

alkylcarbonyl group, a substituted or unsubstituted arylcarbonyl group, or a substituted or unsubstituted heterocyclic carbonyl group. It is especially preferable that at least one of $Y_{41}$ and $Y_{42}$ is a cyano group, and the other is a substituted or unsubstituted alkylcarbonyl group, or a substituted or unsubstituted arylcarbonyl group. Further, it is preferable that $Y_{41}$ and $Y_{42}$ do not bind to each other to form any ring with other atom. It is further preferable that at least one of $Y_{41}$ and $Y_{42}$ is a cyano group, and the other is a substituted or unsubstituted alkylcarbonyl group having 3 to 18 carbon atoms, or a substituted or unsubstituted arylcarbonyl group having 7 to 18 carbon atoms.

$V_{41}$ and $V_{42}$ each independently represent a hydrogen atom or a monovalent substituent. Examples of the monovalent substituent include a halogen atom, a mercapto group, a cyano group, a carboxyl group, a phosphoric acid group, a sulfo group, a hydroxy group, a carbamoyl group, a sulfamoyl group, a nitro group, an alkoxy group, an aryloxy group, an acyl group, an acyloxy group, an acylamino group, a sulfonyl group, a sulfinyl group, a sulfonylamino group, an amino group, a substituted amino group, an ammonium group, a hydrazino group, a ureido group, an imido group, an alkyl- or aryl-thio group, a substituted or unsubstituted alkenylthio group, an alkoxycarbonyl group, an aryloxycarbonyl group, an unsubstiteted alkyl group, a substituted alkyl group, a substituted or unsubstituted aryl group, and a substituted or unsubstituted heterocyclic group. Specific examples of these substituents include those groups recited as examples of $Y_{41}$ and $Y_{42}$. The substituent may be further substituted, and multiple substituents, if present, may be the same as or different from each other. In the present case, the substituent is the above-described substituent. In addition, the substituents may bind to each other to form a ring.

$V_{41}$ and $V_{42}$ each independently are preferably a cyano group, a nitro group, a hydroxyl group, an alkoxy group, an aryloxy group, or an acyloxy group; and particularly preferably an alkoxy group, an aryloxy group, or an acyloxy group.

A preferable combination of the substituents in formula (4) is such a combination that at least one of $Y_{41}$ and $Y_{42}$ is a cyano group, and the other is a substituted or unsubstituted alkylcarbonyl group having 3 to 18 carbon atoms, or a substituted or unsubstituted arylcarbonyl group having 7 to 18 carbon atoms; and both $V_{41}$ and $V_{42}$ are an alkoxy group, an aryloxy group, or an acyloxy group.

The ultraviolet absorbent represented by formula (4) is particularly preferably an ultraviolet absorbent represented by formula (5).

[Chemical formula 11]

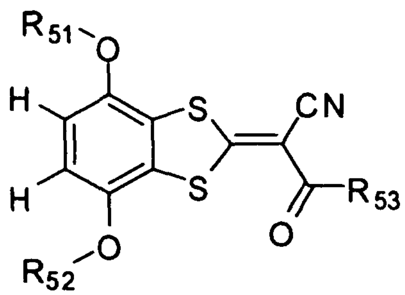

Formula (5)

(In formula (5), $R_{51}$ and $R_{52}$ each independently represent an unsubstituted alkyl group having 1 to 18 carbon atoms, or an unsubstituted alkylcarbonyl group having 2 to 18 carbon atoms; and $R_{53}$ represents an unsubstituted alkyl group having 2 to 18 carbon atoms, or an unsubstituted aryl group having 6 to 10 carbon atoms.)

$R_{51}$ and $R_{52}$ each independently represent an unsubstituted alkyl group having 1 to 18 carbon atoms, or an unsubstituted alkylcarbonyl group having 2 to 18 carbon atoms. Among these, $R_{51}$ and $R_{52}$ each are preferably a methyl group, an acetyl group, a 2-ethylhexyl group, or a 2-ethylhexanoyl group; particularly preferably a 2-ethylhexyl group or a 2-ethylhexanoyl group.

$R_{53}$ represents an unsubstituted alkyl group having 2 to 18 carbon atoms, or an unsubstituted aryl group having 6 to 10 carbon atoms. The unsubstituted alkyl group is preferably an ethyl group, a propyl group, an iso-propyl group, a butyl group, or a tert-butyl group; particularly preferably a tert-butyl group. The unsubstituted aryl group is preferably a phenyl group or a naphthyl group; particularly preferably a phenyl group.

A preferable combination of the substituents in formula (5) is such a combination that both $R_{51}$ and $R_{52}$ each are a 2-ethylhexyl group or a 2-ethylhexanoyl group, and $R_{53}$ is a tert-butyl group or a phenyl group.

The ultraviolet absorbent represented by any one of formulae (2) to (5) in the present invention can be synthesized according to any one of the methods described or cited in Journal of Chemical Crystallography, 27, 1997, p. 516, right column, line 3 to p. 520, right column, line 15; Liebigs Annalen der Chemie, 726, p. 106, line 15 to p. 109, line 37; JP-A-49-1115, p. 3, left column, line 7 to p. 5, left column, line 8; Bioorganic & Medicinal Chemistry Letters, 7, 1997, p.

652, lines 9 to 19; Journal of Organic Chemistry, 43, 1978, p. 2153, left column, lines 2 to 12; JP-A-4-338759, p. 4, left column, line 2 to p. 5, left column, line 2; JP-A-3-54566, p. 7, left column, line 6 to p. 8, left column, line 10; Synthesis, 1986, p. 968, left column, lines 1 to 22, or a method similar to that.

Hereinafter, typical preferred examples of the ultraviolet absorbent represented by any one of formulae (2) to (5) that can be used in the present invention will be described below, but the present invention is not restricted thereby.

[Examples of the compound corresponding to that represented by formula (4)]

[Chemical formula 12]

(S-01)

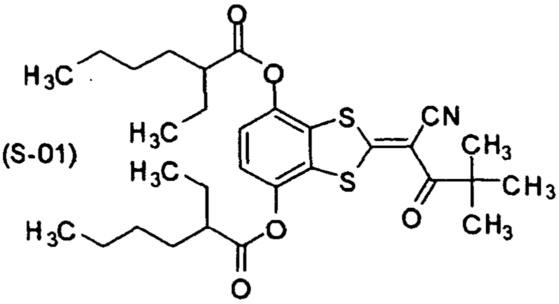

(S-02)

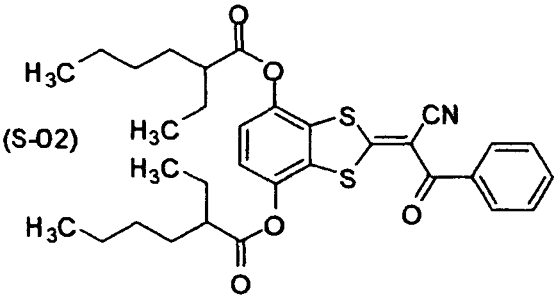

(S-03)

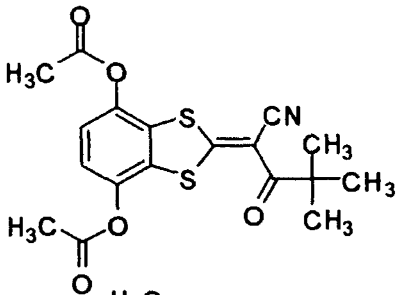

(S-04)

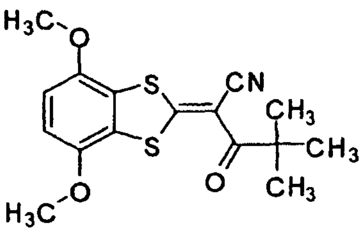

(S-05)

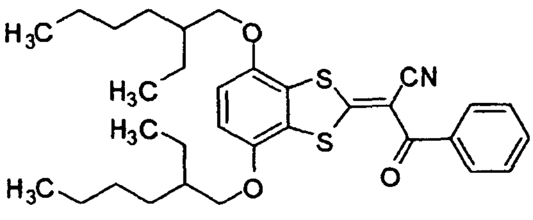

(S-06)

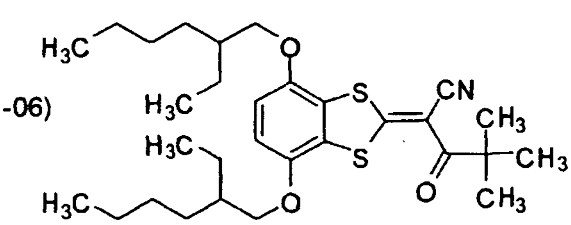

[Chemical formula 13]

(S-07)

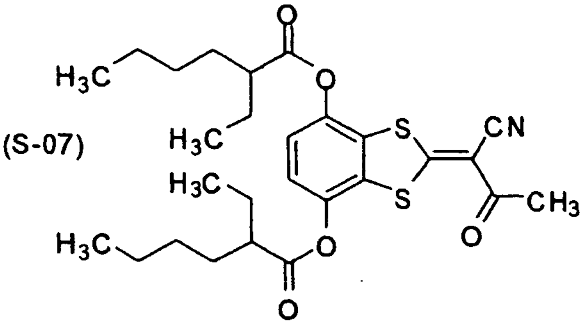

(S-08)

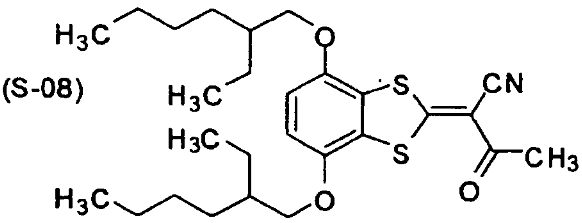

(S-09)

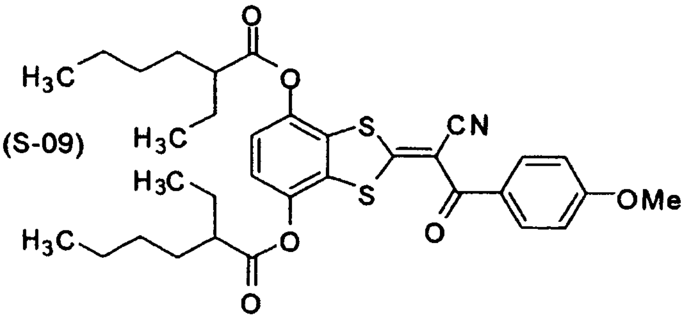

(S-10)

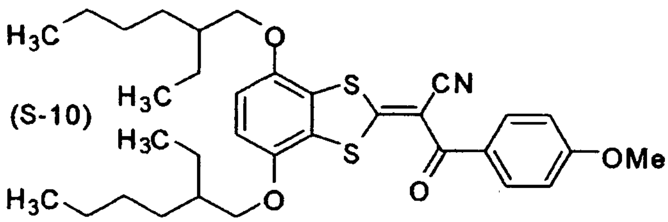

[Chemical formula 14]

(S-11)
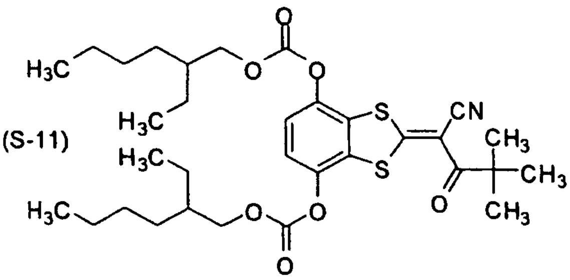

(S-12)
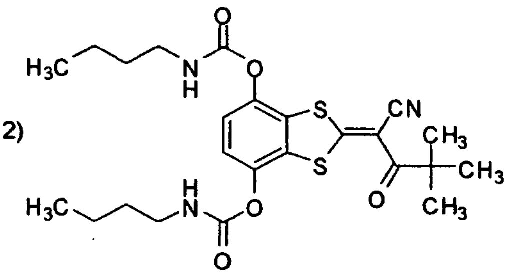

(S-13)
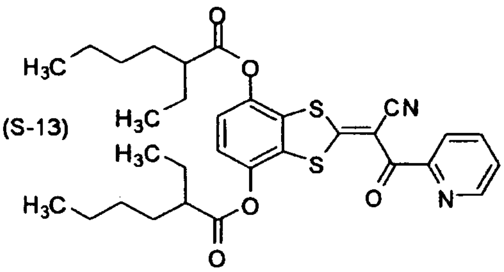

(S-14)
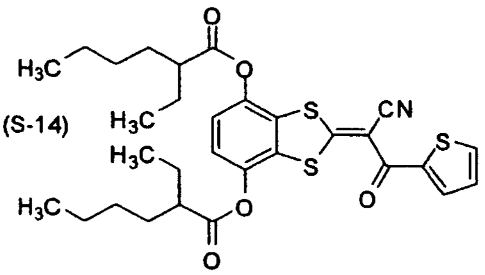

(S-15)
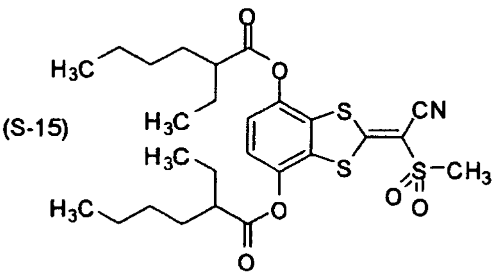

(S-16)
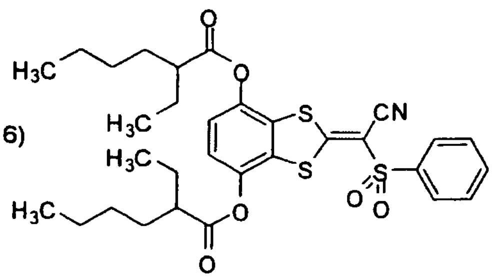

[Examples of the compound corresponding to that represented by not formula (4) but formula (3)]

[Chemical formula 15]

(S-17)

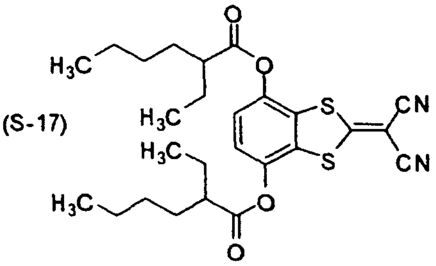

(S-18)

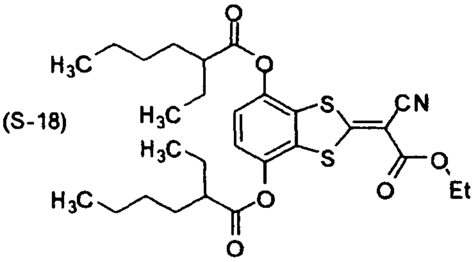

(S-19)

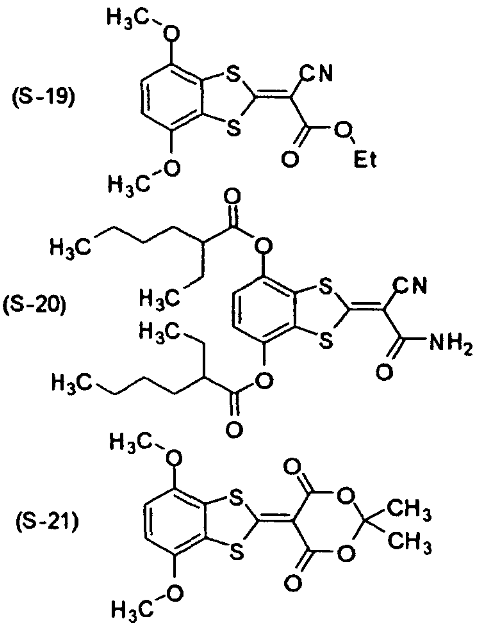

(S-20)

(S-21)

(S-22)

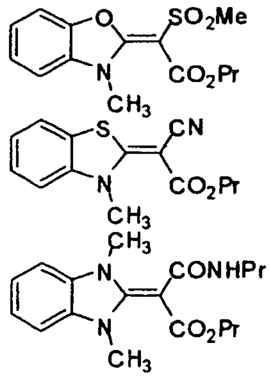

(S-23)

(S-24)

[Chemical formula 16]

(S-25)

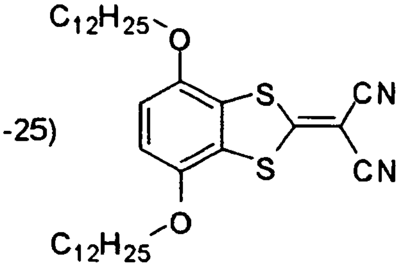

(S-26)

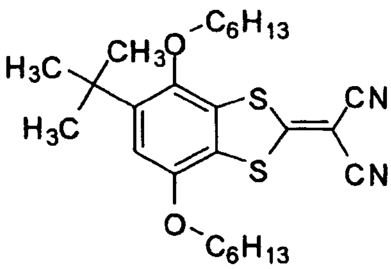

(S-27)

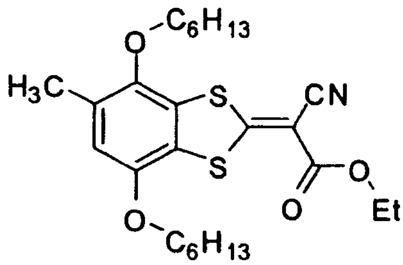

(S-28)

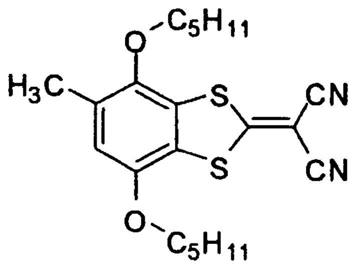

(S-29)

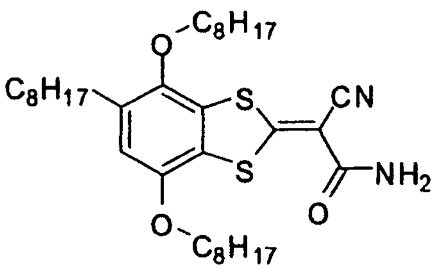

[Examples of the compound corresponding to that represented by not formula (3) but formula (2)]

[Chemical formula 17]

(S-30) 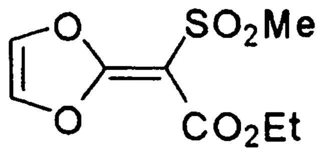

(S-31) 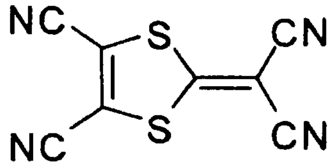

Next, the ultraviolet absorbent represented by formula (B-I) will be described.

[Chemical formula 18]

Formula (B－I)

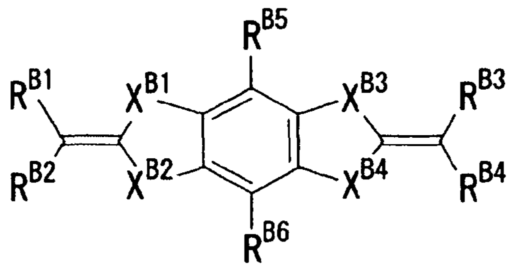

(In formula (B-I), $R^{B1}$, $R^{B2}$, $R^{B3}$ and $R^{B4}$ each independently represent a hydrogen atom or a monovalent substituent; $R^{B5}$ and $R^{B6}$ each independently represent a hydrogen atom or a monovalent substituent; and $X^{B1}$, $X^{B2}$, $X^{B3}$ and $X^{B4}$ each independently represent a hetero atom.)

In formula (B-I), $R^{B1}$, $R^{B2}$, $R^{B3}$ and $R^{B4}$ each independently represent a hydrogen atom or a monovalent substituent. Examples of the monovalent substituent include the monovalent substituent in formula (2) explained above. The substituent may be further substituted, and multiple substituents, if present, may be the same as or different from each other. In addition, the substituents may bind to each other to form a ring.

Examples of the monovalent substituent of $R^{B1}$, $R^{B2}$, $R^{B3}$ and $R^{B4}$ include a cyano group, a substituted or unsubstituted carbamoyl group, a substituted or unsubstituted sulfamoyl group, a nitro group, a substituted or unsubstituted acyl group, a substituted or unsubstituted alkylsulfonyl group, a substituted or unsubstituted arylsulfonyl group, a substituted or unsubstituted alkylsulfinyl group, a substituted or unsubstituted arylsulfinyl group, a substituted or unsubstituted alkoxycarbonyl group, a substituted or unsubstituted aryloxycarbonyl group, a substituted or unsubstituted alkyl group, a substituted or unsubstituted aryl group, and a substituted or unsubstituted heterocyclic group. The substituent may be further substituted, and multiple substituents, if present, may be the same as or different from each other. In the present case, the substituent is the above-described monovalent substituent. In addition, the substituents may bind to each other to form a ring.

Examples of $R^{B1}$, $R^{B2}$, $R^{B3}$ and $R^{B4}$ include a cyano group, a carbamoyl group having 1 to 10 carbon atoms (preferably 2 to 8 carbon atoms, more preferably 2 to 5 carbon atoms) (e.g., methylcarbamoyl, ethylcarbamoyl, morpholinocarbonyl), a sulfamoyl group having 0 to 10 carbon atoms (preferably 2 to 8 carbon atoms, more preferably 2 to 5 carbon atoms) (e.g., methylsulfamoyl, ethylsulfamoyl, piperidinosulfonyl), a nitro group, an acyl group having 1 to 20 carbon atoms (preferably 1 to 12 carbon atoms, more preferably 1 to 8 carbon atoms) (e.g., formyl, acetyl, benzoyl, trichloroacetyl), an alkylsulfonyl group having 1 to 20 carbon atoms (preferably 1 to 10 carbon atoms, more preferably 1 to 8 carbon atoms), an arylsulfonyl group (e.g., methanesulfonyl, ethanesulfonyl, benzenesulfonyl), an alkylsulfinyl group having 1 to 20 carbon atoms (preferably 1 to 10 carbon atoms, more preferably 1 to 8 carbon atoms), an arylsulfinyl group (e.g., methanesulfinyl, benzenesulfinyl), an alkoxycarbonyl group having 2 to 20 carbon atoms (preferably 2 to 12 carbon atoms, more preferably 2 to 8 carbon atoms) (e.g., methoxycarbonyl, ethoxycarbonyl, benzyloxycarbonyl),

an aryloxycarbonyl group having 6 to 20 carbon atoms (preferably 6 to 12 carbon atoms, more preferably 6 to 8 carbon atoms) (e.g., phenoxycarbonyl),

an unsubstituted alkyl group having 1 to 18 carbon atoms (preferably 1 to 10 carbon atoms, more preferably 1 to 5 carbon atoms) (e.g., methyl, ethyl, propyl, butyl), a substituted alkyl group having 1 to 18 carbon atoms (preferably 1 to 10 carbon atoms, more preferably 1 to 5 carbon atoms) (e.g., hydroxymethyl, trifluoromethyl, benzyl, carboxyethyl, ethoxycarbonylmethyl, acetylaminomethyl), a substituted or unsubstituted aryl group having 6 to 20 carbon atoms (preferably 6 to 15 carbon atoms, more preferably 6 to 10 carbon atoms) (e.g., phenyl, naphthyl, p-carboxyphenyl, p-nitrophenyl, 3,5-dichlorophenyl, p-cyanophenyl, m-fluorophenyl, p-tolyl, p-bromophenyl), and a heterocyclic group (which may be substituted) having 1 to 20 carbon atoms (preferably 2 to 10 carbon atoms, more preferably 4 to 6 carbon atoms) (e.g., pyridyl, 5-methylpyridyl, thienyl, furyl, morpholino, tetrahydrofurfuryl). The substituent may be further substituted, and multiple substituents, if present, may be the same as or different from each other. In the present case, the substituent is the above-described substituent. In addition, the substituents may bind to each other to form a ring.

It is preferable that at least one of $R^{B1}$, $R^{B2}$, $R^{B3}$ and $R^{B4}$ represents a substituent having a Hammett substituent constant $\sigma p$ of 0.2 or more

$R^{B1}$ and $R^{B2}$, and/or $R^{B3}$ and $R^{B4}$ may bind to each other to form a ring. As the $\sigma p$ value of each of $R^{B1}$, $R^{B2}$ , $R^{B3}$ and $R^{B4}$ when a ring is formed with these members, the same way as described in the foregoing formula (2) is applied.

At least one of $R^{B1}$, $R^{B2}$ , $R^{B3}$ and $R^{B4}$ preferably represents a substituent having a Hammett substituent constant $\sigma p$ of 0.2 or more. The groups in at least one of the combination of $R^{B1}$ and $R^{B2}$ and the combination of $R^{B3}$ and $R^{B4}$ are preferably the substituent above. More preferably, three groups of $R^{B1}$, $R^{B2}$, $R^{B3}$ and $R^{B4}$ are the substituent. Particularly preferably, all of $R^{B1}$, $R^{B2}$, $R^{B3}$ and $R^{B4}$ are the substituent.

At least one of $R^{B1}$, $R^{B2}$, $R^{B3}$ and $R^{B4}$ is more preferably -CN, $-COOR^{B8}$, $-CONR^{B9}RB^{10}$, $-COR^{B11}$ or $-SO_2R^{B12}$ (wherein, $R^{B8}$, $R^{B9}$, $R^{B10}$, $R^{B11}$ and $R^{B12}$ each represent a hydrogen atom or a monovalent substituent); more preferably, -CN, $-COOR^{B8}$, $-COR^{B11}$ or $-SO_2R^{B12}$; still more preferably -CN or $-COOR^{B8}$; and particularly preferably -CN.

At least one of $R^{B1}$, $R^{B2}$, $R^{B3}$ and $R^{B4}$ is still more preferably an alkoxycarbonyl group having 6 or more carbon atoms, still more preferably an alkoxylcarbony group having 6 or more and 20 or less carbon atoms, still more preferably an alkoxylcarbony group having 6 or more and 12 or less carbon atoms. The alkoxy group may have any substituent on any positions. Examples of the substituent include those described above. Examples of the alkoxy group in the alkoxycarbonyl group include a hexyloxy group, a 2-ethylhexyloxy group, an octyloxy group, a decyloxy group, and a dodecyloxy group.

The combination of $R^{B1}$ and $R^{B2}$ and the combination of $R^{B3}$ and $R^{B4}$ may be arbitrary as long as the conditions described above are satisfied, but the combination of $R^{B1}$ and $R^{B2}$ and that of $R^{B3}$ and $R^{B4}$ are preferably the same as each other.

$R^{B1}$ and $R^{B2}$ and/or $R^{B3}$ and $R^{B4}$ may bind to each other to form a ring. The ring formed may be a saturated and unsaturated, hydrocarbon or heterocycle. However, the ring formed is not a dithiole or dithiolane ring. Examples of the carbon-atom containing ring formed by $R^{B1}$ and $R^{B2}$ defined in formula (B-I) include a cyclopropane ring, a cyclobutane ring, a cyclopentane ring, a cyclohexane ring, a cycloheptane ring, a pyrrolidine ring, a tetrahydrofuran ring, a tetrahydrothiophene ring, an oxazoline ring, a thiazoline ring, a pyrroline ring, a pyrazolidine ring, a pyrazoline ring, an imidazolidine ring, an imidazoline ring, a piperidine ring, a piperazine ring, and a pyran ring. Each of the rings may be substituted at any positions additionally. The substituent is, for example, the monovalent substituent described above. Examples of a bivalent substituent include a carbonyl group and an imino group. Multiple substituents, when present, may be the same as or different from each other. The substituents may bind to each other, forming a fused ring or a spiro ring.

Typical favorable examples of the combination of $R^{B1}$ and $R^{B2}$, or $R^{B3}$ and $R^{B4}$ are shown in the following Table 1, but the present invention is not restricted thereby. Et represents an ethyl group and Bu represents a butyl group in the present description. The wavy line in the Table indicates the binding site on the heterocycle shown in formula (B-I).

[Table 1-1]

Table 1 − 1

| Specific examples of the combination of 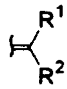 or 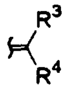 | | | | | |
|---|---|---|---|---|---|
| 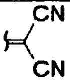 | 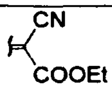 | 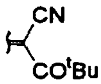 | 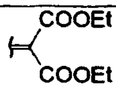 | 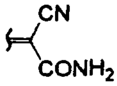 | 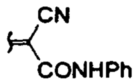 |
| 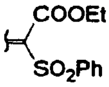 | 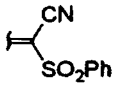 | 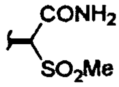 | 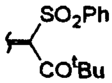 | 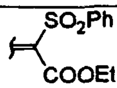 | 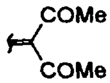 |
| 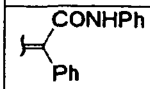 | 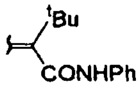 | 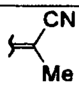 | 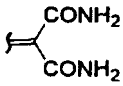 | 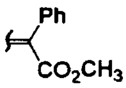 | 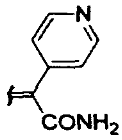 |
| 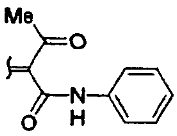 | 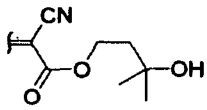 | 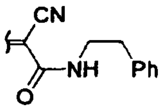 | 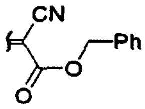 | 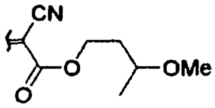 | |
| 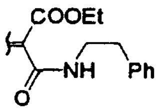 | 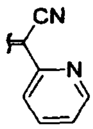 | 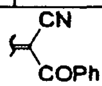 | 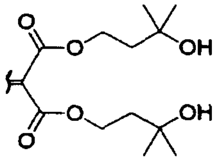 | 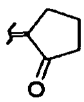 | |
| 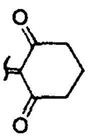 | 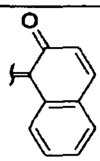 | 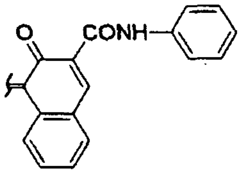 | 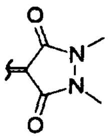 | 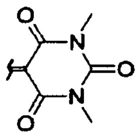 | |
| 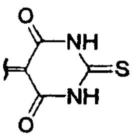 | 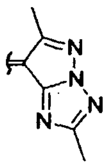 | 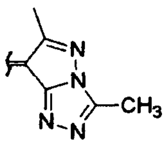 | 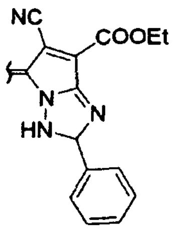 | 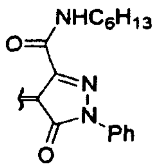 | |

[Table 1-2]

Table 1 – 2 (Continued to Table 1-1)

| Specific examples of the combination of 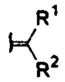 or 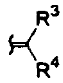 | | | | |
|---|---|---|---|---|
| 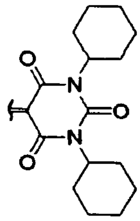 | 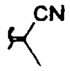 | 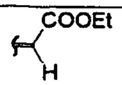 | 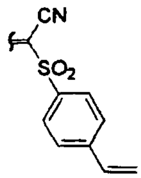 | 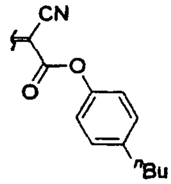 |
| 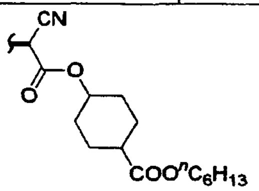 | | 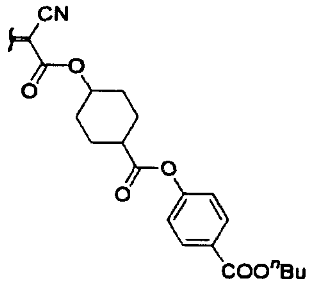 | | 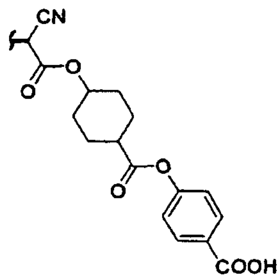 |
| 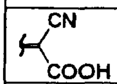 | 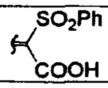 | 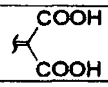 | | |
| 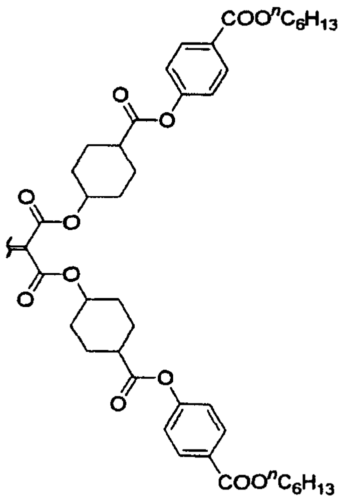 | | 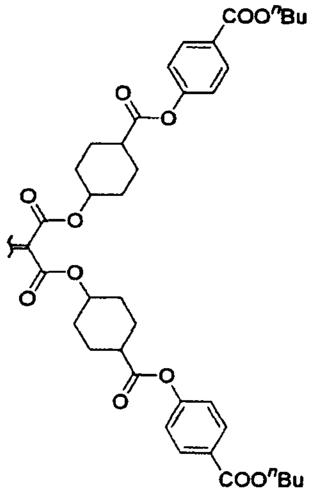 | | 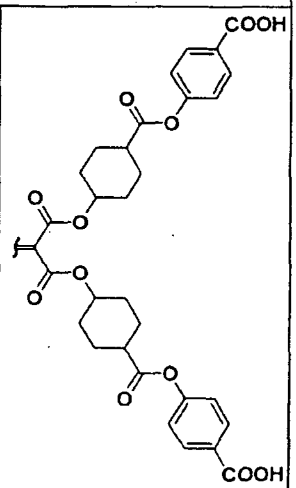 |
| 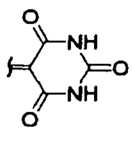 | 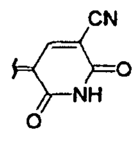 | 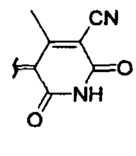 | 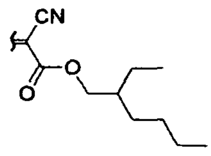 | |

In formula (B-I), $R^{B5}$ and $R^{B6}$ each independently represent a hydrogen atom or a monovalent substituent. The monovalent substituent is, for example, the monovalent substituent described above.

In particular, $R^{B5}$ and $R^{B6}$ are preferably a hydrogen atom, a halogen atom, an alkyl group, an aryl group, a cyano group, a carboxyl group, an alkoxycarbonyl group, an aryloxycarbonyl group, a carbamoyl group, an alkylcarbonyl group, an arylcarbonyl group, a nitro group, an amino group, an acylamino group, a sulfonamido group, a hydroxy group,

an alkoxy group, an aryloxy group, an acyloxy group, an alkylsulfonyloxy group, an arylsulfonyloxy group, a sulfo group, an alkylthio group, or an arylthio group. $R^{B5}$ and $R^{B6}$ are more preferably a hydrogen atom, a halogen atom, an amino group, an acylamino group, a hydroxy group, an alkoxy group, an aryloxy group, an acyloxy group, an alkylthio group or an arylthio group. $R^{B5}$ and $R^{B6}$ are further preferably an alkoxy group, an aryloxy group, an acyloxy group, an alkoxycarbonyloxy group, an aryloxycarbonyloxy group, an acylamino group, a carbamoyloxy group, or a carbamoylamino group. $R^{B5}$ and $R^{B6}$ are particularly preferably an alkoxy group, an aryloxy group or an acyloxy group. $R^{B5}$ and $R^{B6}$ are still more preferably an alkoxy group having 2 or more carbon atoms.

The alkyl group in the alkoxy group is preferably an alkyl group having 1 to 20 carbon atoms, such as a methyl group, an ethyl group, a propyl group, a hexyl group, and an octyl group. The alkyl group may be substituted with one or more monovalent substituents at any positions. The monovalent substituent is, for example, the monovalent substituent described above. Any of the substituents may bind to each other to form a ring. The alkyl group in the alkoxy group is preferably an alkyl group having 3 to 20 carbon atoms, more preferably an alkyl group having 5 to 18 carbon atoms, and particularly preferably an alkyl group having 6 to 12 carbon atoms.

The aryl group in the aryloxy group is preferably an aryl group having 6 to 20 carbon atoms, such as a phenyl group, and a naphthyl group. The aryl group may be substituted with one or more monovalent substituents at any position. The monovalent substituent is, for example, a monovalent substituent described above. Any of the substituents may bind to each other to form a ring. The aryl group in the aryloxy group is preferably an aryl group having 6 to 14 carbon atoms, more preferably an aryl group having 6 to 10 carbon atoms, and particularly preferably a phenyl group.

The acyl group in the acyloxy group is preferably an acyl group having 1 to 20 carbon atoms, such as an acetyl group, a propionyl group, a butanoyl group, a hexanoyl group, an octanoyl group, a benzoyl group, and a naphthoyl group. The acyl group may be substituted with one or more monovalent substituents at any position. The monovalent substituent is, for example, the monovalent substituent described above. Any of the substituents may bind to each other to form a ring. The acyl group in the acyloxy group is preferably an acyl group having 1 to 15 carbon atoms, more preferably an acyl group having 1 to 10 carbon atoms, and particularly preferably an acyl group having 4 to 8 carbon atoms.

The alkyl group in the alkoxycarbonyloxy group is preferably an alkyl group having 1 to 20 carbon atoms, such as a methyl group, an ethyl group, a propyl group, a hexyl group, and an octyl group. The alkyl group may be substituted with one or more monovalent substituents at any positions. The monovalent substituent is, for example, the monovalent substituent described above. Any of the substituents may bind to each other to form a ring. The alkyl group in the alkoxycarbonyloxy group is preferably an alkyl group having 3 to 20 carbon atoms, more preferably an alkyl group having 5 to 18 carbon atoms, and particularly preferably an alkyl group having 6 to 12 carbon atoms.

The aryl group in the aryloxycarbonyloxy group is preferably an aryl group having 6 to 20 carbon atoms, such as a phenyl group, and a naphthyl group. The aryl group may be substituted with one or more monovalent substituents at any position. The monovalent substituent is, for example, the monovalent substituent described above. Any of the substituents may bind to each other to form a ring. The aryl group in the aryloxycarbonyloxy group is preferably an aryl group having 6 to 14 carbon atoms, more preferably an aryl group having 6 to 10 carbon atoms, and particularly preferably a phenyl group.

The acyl group in the acylamino group is preferably an acyl group having 1 to 20 carbon atoms, such as an acetyl group, a propionyl group, a butanoyl group, a hexanoyl group, an octanoyl group, a benzoyl group, and a naphthoyl group. The acyl group may be substituted with one or more monovalent substituents at any position. The monovalent substituent is, for example, the monovalent substituent described above. Any of the substituents may bind to each other to form a ring. The acyl group in the acylamino group is preferably an acyl group having 1 to 15 carbon atoms, more preferably an acyl group having 1 to 10 carbon atoms, and particularly preferably an acyl group having 4 to 8 carbon atoms.

The substituent on the nitrogen atom in the case of the carbamoyloxy group is preferably a hydrogen atom, an alkyl group having 1 to 20 carbon atoms, or an aryl group having 6 to 20 carbon atoms. Examples thereof include a hydrogen atom, a methyl group, an ethyl group, a propyl group, a hexyl group, an octyl group, a phenyl group, and a naphthyl group. The alkyl group and the aryl group may be substituted with one or more monovalent substituents at any position. The monovalent substituent is, for example, the monovalent substituent described above. The alkyl group and the aryl group in the carbamoyloxy group is preferably an alkyl group having 3 to 20 carbon atoms or an aryl group having 6 to 14 carbon atoms, and more preferably an alkyl group having 6 to 12 carbon atoms or an aryl group having 6 to 10 carbon atoms.

The substituent on the nitrogen atom in the case of the carbamoylamino group is preferably a hydrogen atom, an alkyl group having 1 to 20 carbon atoms, or an aryl group having 6 to 20 carbon atoms. Examples thereof include a hydrogen atom, a methyl group, an ethyl group, a propyl group, a hexyl group, an octyl group, a phenyl group, and a naphthyl group. The alkyl group and the aryl group may be substituted with one or more monovalent substituents at any position. The monovalent substituent is, for example, the monovalent substituent described above. The alkyl group and the aryl group in the carbamoylamino group is preferably an alkyl group having 3 to 20 carbon atoms or an aryl group having 6 to 14 carbon atoms, and more preferably an alkyl group having 6 to 12 carbon atoms or an aryl group having 6 to 10 carbon atoms.

$R^{B5}$ and $R^{B6}$ may be different from each other, but are preferably the same as each other.

Typical favorable examples of the combination of $R^{B5}$ or $R^{B6}$ are shown in the following Table 2, but the present invention is not restricted thereby. The wavy line in the Table indicates the binding site on the benzene ring shown in formula (B-I).

[Table 2-1]

Table 2 − 1

Specific examples of the combination of or

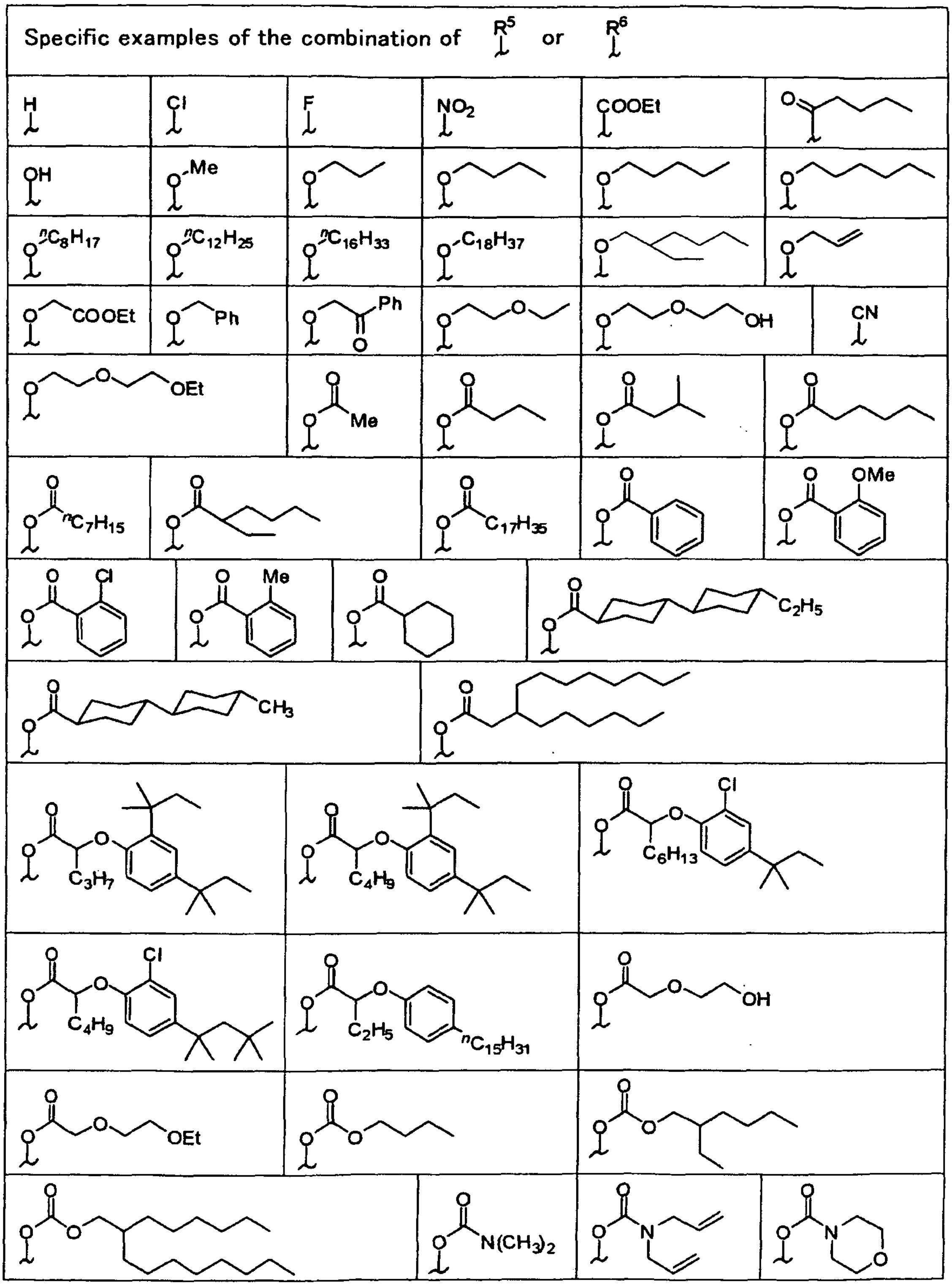

[Table 2-2]

Table 2 − 2 (Continued to Table 2-1)

| Specific examples of the combination of 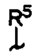 or 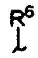 | | | | | |
|---|---|---|---|---|---|
| 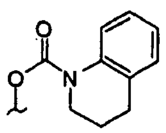 | | 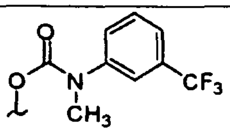 | | 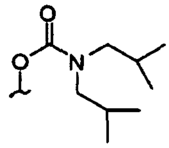 | 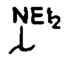 |
| 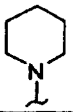 | 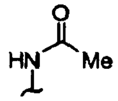 | 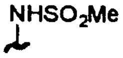 | 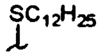 | 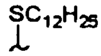 | 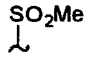 |
| 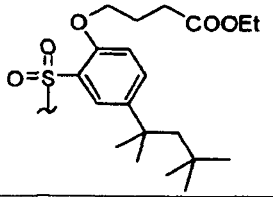 | | 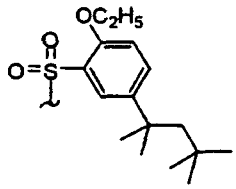 | | 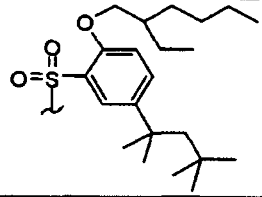 | |
| 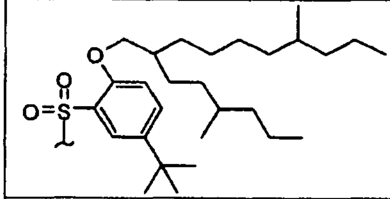 | | | 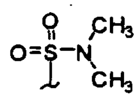 | 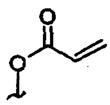 | 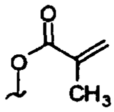 |
| 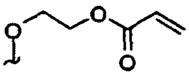 | | 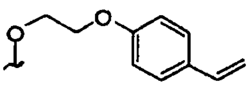 | | 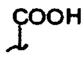 | 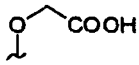 |
| 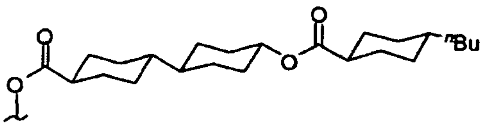 | | | 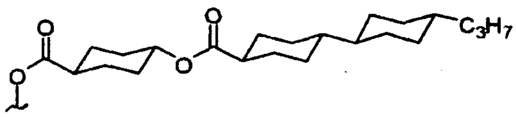 | | |
| 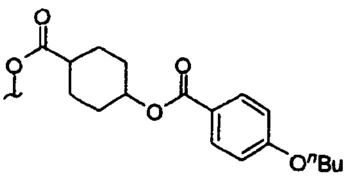 | | | 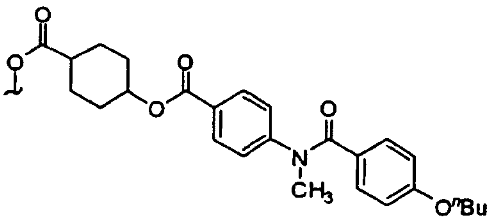 | | |

$X^{B1}$, $X^{B2}$, $X^{B3}$ and $X^{B4}$ each independently represent a hetero atom. Examples of the hetero atom include a boron atom, a nitrogen atom, an oxygen atom, a silicon atom, a phosphorus atom, a sulfur atom, a selenium atom, and a tellurium atom. $X^{B1}$, $X^{B2}$, $X^{B3}$ and $X^{B4}$ each are preferably a nitrogen atom, an oxygen atom or a sulfur atom; more preferably a nitrogen atom or a sulfur atom; and particularly preferably a sulfur atom.

$X^{B1}$, $X^{B2}$, $X^{B3}$ and $X^{B4}$ may be different from each other, but the combination of $X^{B1}$ and $X^{B2}$ and the combination of $X^{B3}$ and $X^{B4}$ are preferably the same as each other. Most preferably, all groups each represent a sulfur atom.

Typical favorable examples of the combination of $X^{B1}$ and $X^{B2}$ or the combination of $X^{B3}$ and $X^{B4}$ are shown in the following Table 3, but the present invention is not restricted thereby. Ac represents an acetyl group in the present description. The wavy line in the Table indicates the binding site on the carbon atoms in formula (B-I) to which $R^{B1}$ and $R^{B2}$ or $R^{B3}$ and $R^{B4}$ bind.

[Table 3]

Table 3

| Specific examples of the combination of 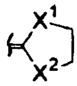 or 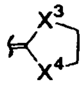 | | | | | | |
|---|---|---|---|---|---|---|
| 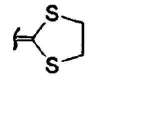 | 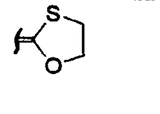 | 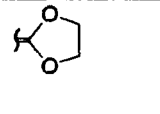 | 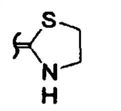 | 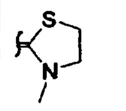 | 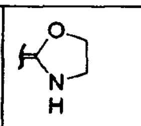 | 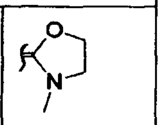 |
| 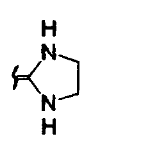 | 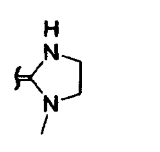 | 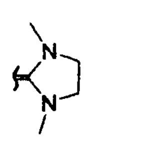 | 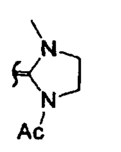 | 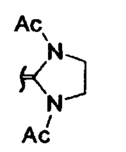 | 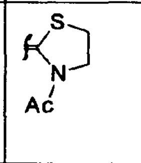 | 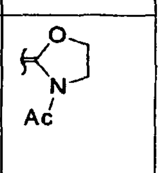 |
| 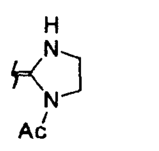 | 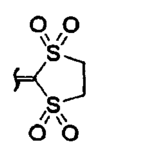 | 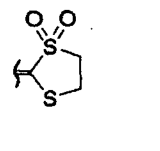 | 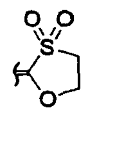 | 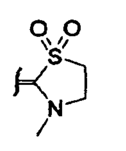 | 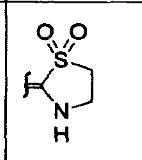 | 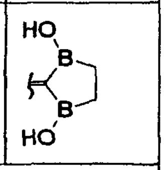 |
| 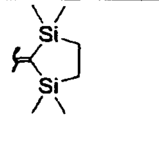 | 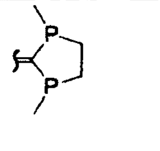 | 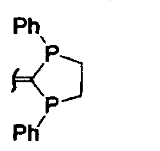 | 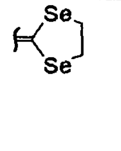 | 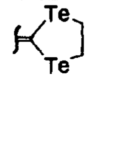 | | |

The ultraviolet absorbent represented by formula (B-I) is preferably an ultraviolet absorbent represented by formula (B-Ia).

[Chemical formula 19]

Formula (B − I a)

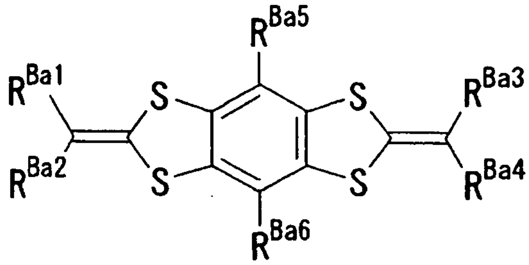

In formula (B-Ia), $R^{Ba1}$, $R^{Ba2}$, $R^{Ba3}$ and $R^{Ba4}$ each represent a monovalent substituent. However, at least one of $R^{Ba1}$, $R^{Ba2}$, $R^{Ba3}$ and $R^{Ba4}$ represents a cyano group, an alkoxycarbonyl group having 1 to 20 carbon atoms (preferably 1 to 10 carbon atoms), an aryloxycarbonyl group having 6 to 20 carbon atoms (preferably 6 to 10 carbon atoms), a carbamoyl group having 1 to 20 carbon atoms (preferably 1 to 10 carbon atoms), an alkylcarbonyl group having 1 to 20 carbon atoms (preferably 1 to 10 carbon atoms), an arylcarbonyl group having 6 to 20 carbon atoms (preferably 6 to 10 carbon atoms), an alkylsulfonyl group having 1 to 20 carbon atoms (preferably 1 to 10 carbon atoms) or an arylsulfonyl group having 6 to 20 carbon atoms (preferably 6 to 10 carbon atoms).

It is preferable that $R^{Ba1}$, $R^{Ba2}$, $R^{Ba3}$, and $R^{Ba4}$ are a monovalent substituent by which at least one of the combination of ($R^{Ba1}$, $R^{Ba2}$) and the combination of ($R^{Ba3}$, $R^{Ba4}$) form no ring.

It is especially preferable that each of $R^{Ba1}$, $R^{Ba2}$, $R^{Ba3}$, and $R^{Ba4}$ is a monovalent substituent by which neither the combination of ($R^{Ba1}$, $R^{Ba2}$) nor the combination of ($R^{Ba3}$, $R^{Ba4}$) forms a ring.

Absence of ring formation provides such advantages that the ultraviolet absorbent is able to exhibit an excellent long-wavelength ultraviolet absorption capability, and also a self-yellow color development of the ultraviolet absorbent can be prevented. Further, absence of ring formation provides such advantages that the ultraviolet absorbent is excellent in solubility in a solvent and compatibility with a polymer, compared to the case of ring formation.

In the present specification, examples of the monovalent substituent that does not form any ring include a straight-chain or branched alkyl group having 1 to 20 carbon atoms (preferably 1 to 10 carbon atoms) (e.g., methyl, ethyl), an aryl group having 6 to 20 carbon atoms (preferably 6 to 10 carbon atoms) (e.g., phenyl, naphthyl), a cyano group, an alkoxycarbonyl group having 1 to 20 carbon atoms (preferably 1 to 10 carbon atoms) (e.g., methoxycarbonyl), an aryloxycarbonyl group having 6 to 20 carbon atoms (preferably 6 to 10 carbon atoms) (e.g., phenoxycarbonyl), a substituted or unsubstituted carbamoyl group having 1 to 20 carbon atoms (preferably 1 to 10 carbon atoms) (e.g., carbamoyl, N-phenylcarbamoyl, N,N-dimethylcarbamoyl), an alkylcarbonyl group having 1 to 20 carbon atoms (preferably 1 to 10 carbon atoms) (e.g., acetyl), an arylcarbonyl group having 6 to 20 carbon atoms (preferably 6 to 10 carbon atoms) (e.g., benzoyl), a nitro group, a substituted or unsubstituted sulfamoyl group having 0 to 20 carbon atoms (preferably 0 to 10 carbon atoms) (e.g., sulfamoyl, N-phenylsulfamoyl), an alkylsulfonyl group having 1 to 20 carbon atoms (preferably 1 to 10 carbon atoms) (e.g., methansulfonyl), an arylsulfonyl group having 6 to 20 carbon atoms (preferably 6 to 10 carbon atoms) (e.g., benzenesulfonyl), and a four- to seven-membered (preferably five- to six-membered) heterocyclic group (e.g., pyridyl, morpholino). The substituent may be further substituted, and multiple substituents, if present, may be the same as or different from each other.

Herein, at least one of the monovalent substituents $R^{Ba1}$, $R^{Ba2}$, $R^{Ba3}$ and $R^{Ba4}$ is a cyano group, an alkoxycarbonyl group having 1 to 20 carbon atoms (preferably 1 to 10 carbon atoms), an aryloxycarbonyl group having 6 to 20 carbon atoms (preferably 6 to 10 carbon atoms), a carbamoyl group having 1 to 20 carbon atoms (preferably 1 to 10 carbon atoms), an alkylcarbonyl group having 1 to 20 carbon atoms (preferably 1 to 10 carbon atoms), an arylcarbonyl group having 6 to 20 carbon atoms (preferably 6 to 10 carbon atoms), an alkylsulfonyl group having 1 to 20 carbon atoms (preferably 1 to 10 carbon atoms) or an arylsulfonyl group having 6 to 20 carbon atoms (preferably 6 to 10 carbon atoms).

$R^{Ba1}$, $R^{Ba2}$, $R^{Ba3}$ and $R^{Ba4}$ each are particularly preferably selected from a cyano group, an alkoxycarbonyl group having 1 to 20 carbon atoms (preferably 1 to 10 carbon atoms), an aryloxycarbonyl group having 6 to 20 carbon atoms (preferably 6 to 10 carbon atoms), a carbamoyl group having 1 to 20 carbon atoms (preferably 1 to 10 carbon atoms), an alkylcarbonyl group having 1 to 20 carbon atoms (preferably 1 to 10 carbon atoms), an arylcarbonyl group having 6 to 20 carbon atoms (preferably 6 to 10 carbon atoms), an alkylsulfonyl group having 1 to 20 carbon atoms (preferably 1 to 10 carbon atoms) or an arylsulfonyl group having 6 to 20 carbon atoms (preferably 6 to 10 carbon atoms). It is more preferable that a pair of $R^{1a}$ and $R^{2a}$, and a pair of $R^{3a}$ and $R^{4a}$ are the same in terms of combination of the members in each pair.

$R^{Ba5}$ and $R^{Ba6}$ each represent an alkoxy group having 1 to 20 carbon atoms (preferably 1 to 10 carbon atoms), an aryloxy group having 6 to 20 carbon atoms (preferably 6 to 10 carbon atoms), an acyloxy group having 1 to 20 carbon atoms (preferably 1 to 10 carbon atoms), an alkoxycarbonyloxy group having 1 to 20 carbon atoms (preferably 1 to 10 carbon atoms), an aryloxycarbonyloxy group having 6 to 20 carbon atoms (preferably 6 to 10 carbon atoms), a carbamoyloxy group having 1 to 20 carbon atoms (preferably 1 to 10 carbon atoms), an amino group having 0 to 20 carbon atoms (preferably 0 to 10 carbon atoms), an acylamino group having 1 to 20 carbon atoms (preferably 1 to 10 carbon atoms), or a carbamoylamino group having 1 to 20 carbon atoms (preferably 1 to 10 carbon atoms).

$R^{Ba5}$ and $R^{Ba6}$ may further have a substituent. Examples of the substituent include the monovalent substituents described above. Examples of a bivalent substituent include a carbonyl group and an imino group. Multiple substituents, when present, may be the same as or different from each other. The substituents may bind to each other, forming a fused ring or a spiro ring.

Hereinafter, typical examples of the ultraviolet absorbent represented by formula (B-I) or (B-Ia) that can be used in the present invention will be described below, but the present invention is not restricted thereby.

[Chemical formula 20]

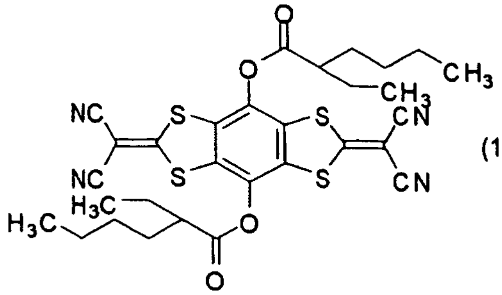
(1)

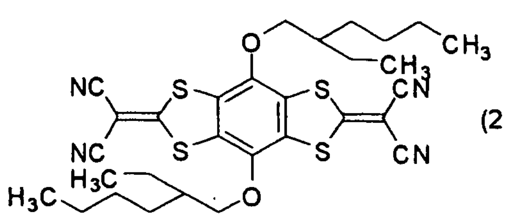
(2)

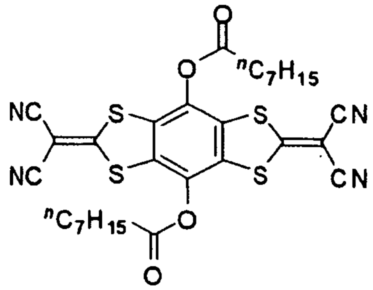
(3)

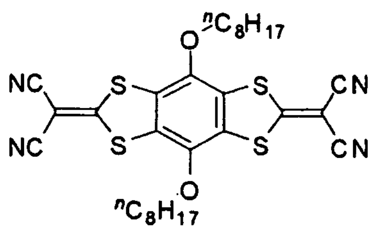
(4)

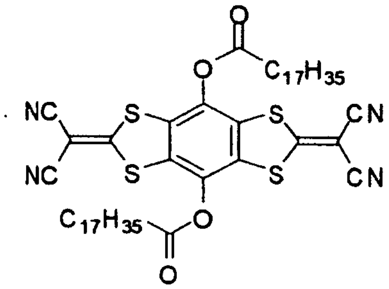
(5)

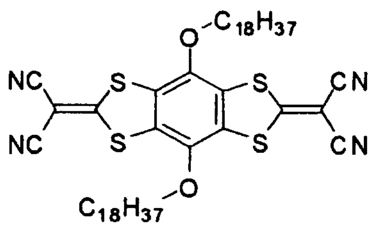
(6)

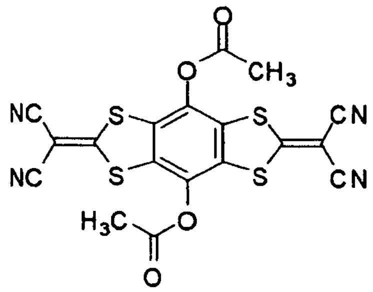
(7)

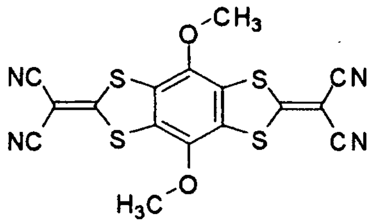
(8)

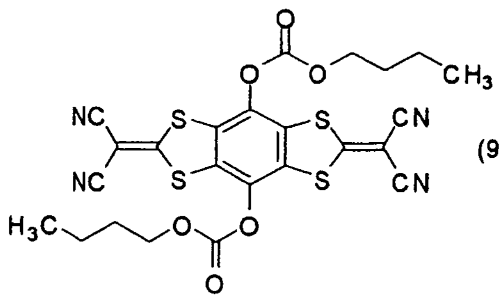
(9)

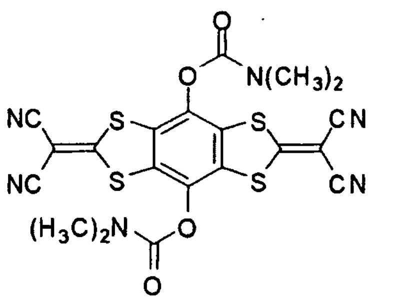
(10)

[Chemical formula 21]

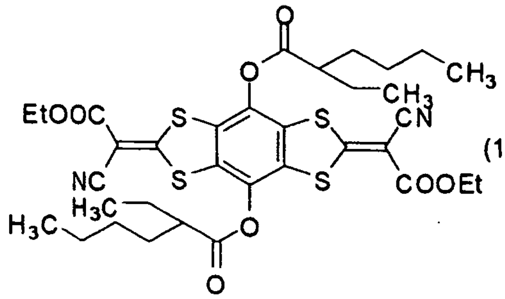
(11)

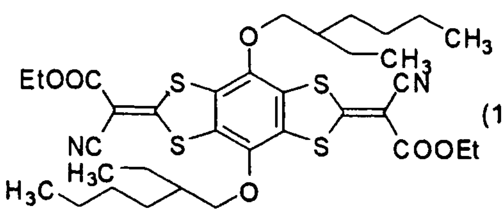
(12)

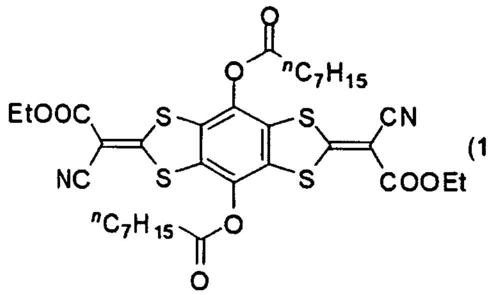
(13)

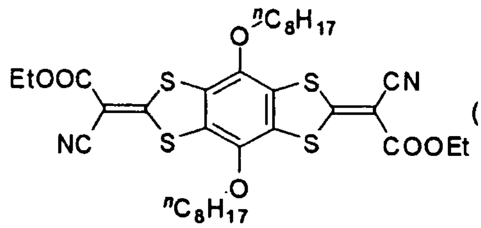
(14)

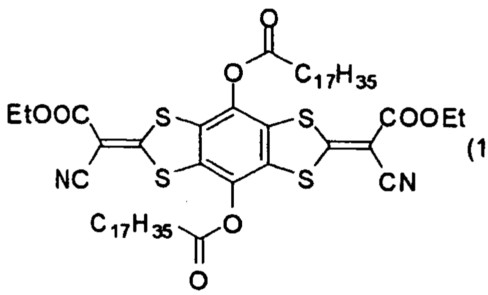
(15)

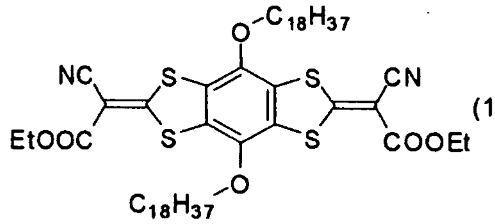
(16)

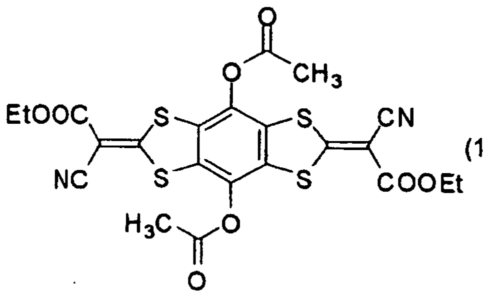
(17)

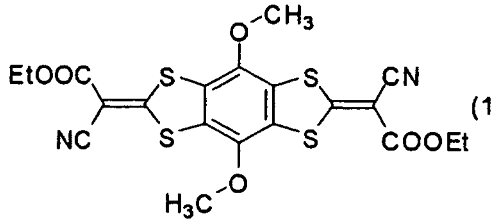
(18)

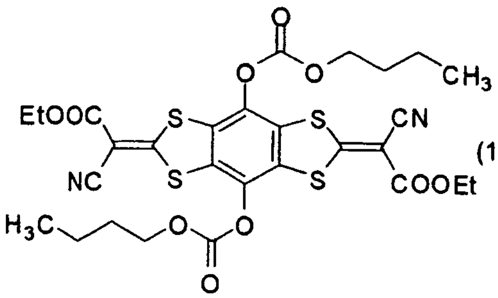
(19)

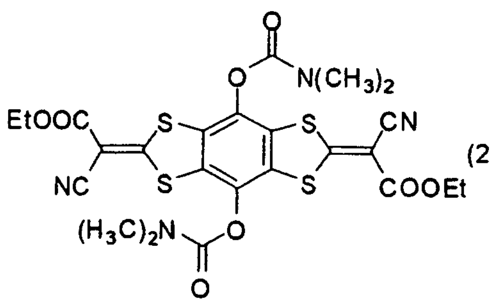
(20)

[Chemical formula 22]

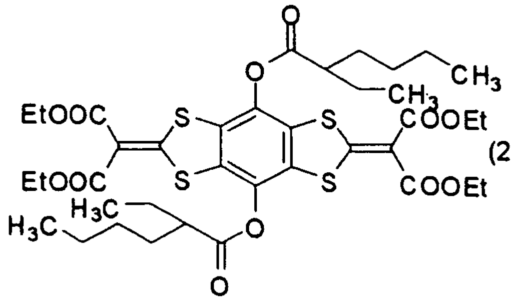
(21)

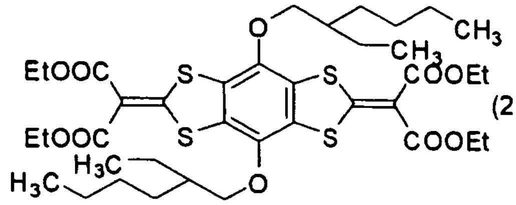
(22)

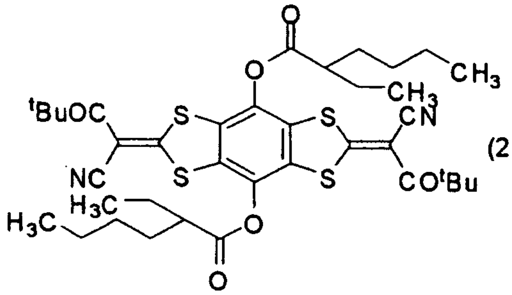
(23)

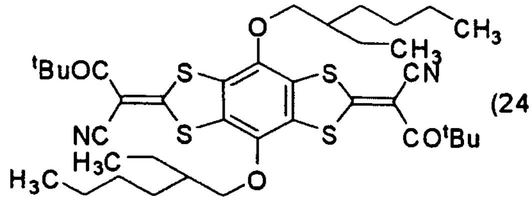
(24)

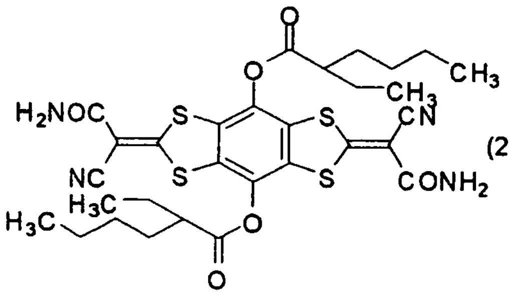
(25)

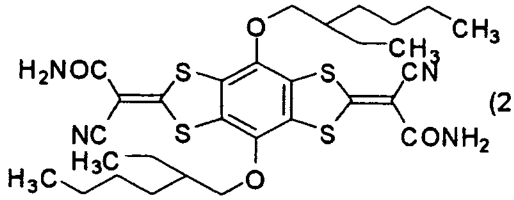
(26)

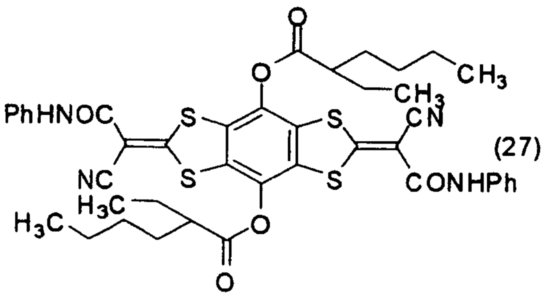
(27)

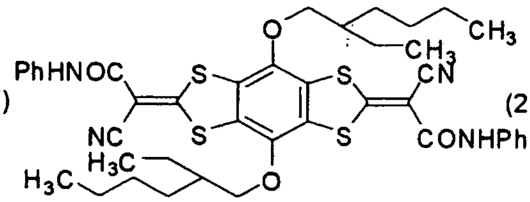
(28)

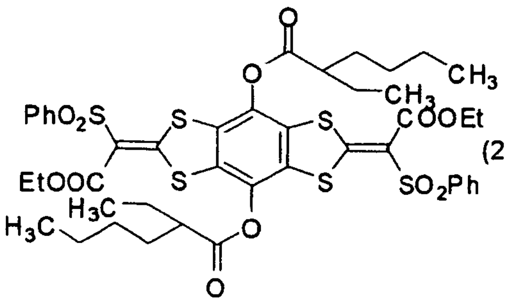
(29)

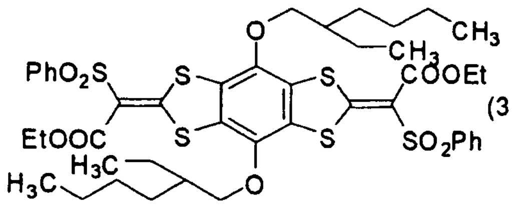
(30)

[Chemical formula 23]

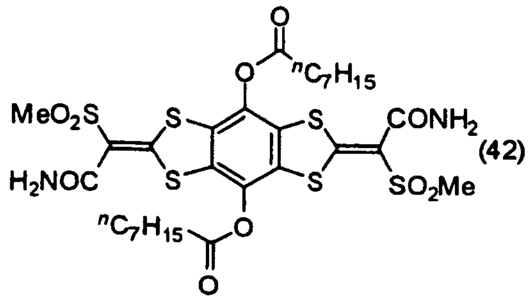

(42)

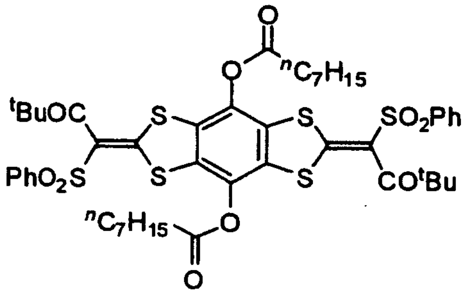

(43)

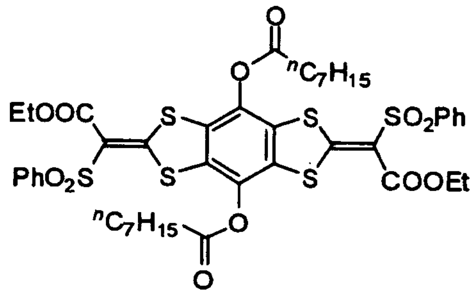

(44)

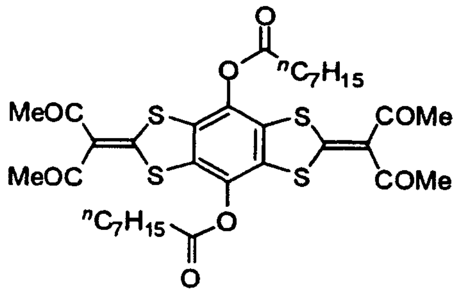

(45)

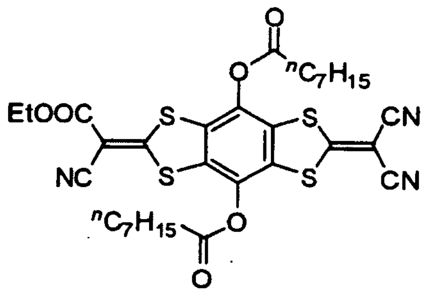

(46)

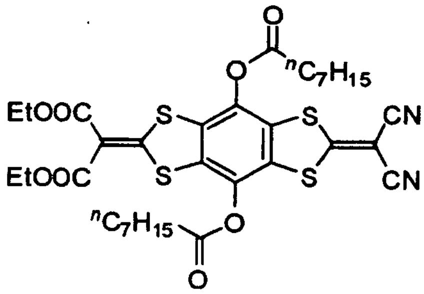

(47)

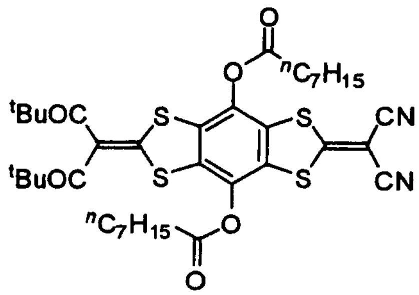

(48)

[Chemical formula 24]

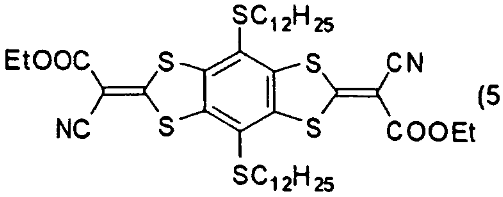
(51)

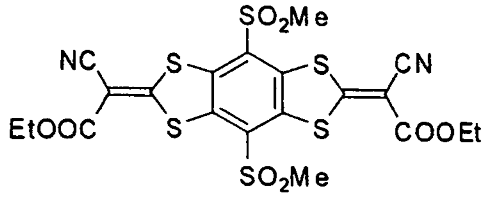
(52)

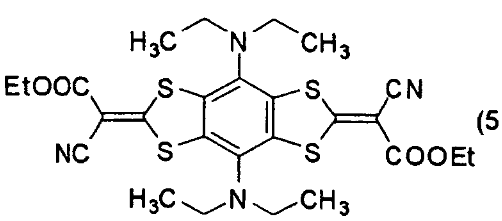
(53)

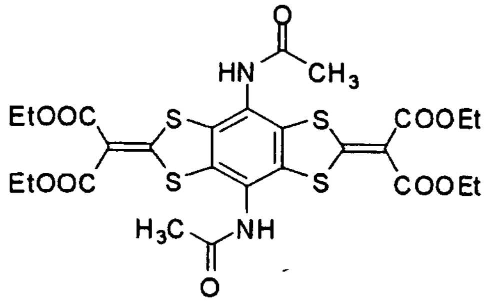
(54)

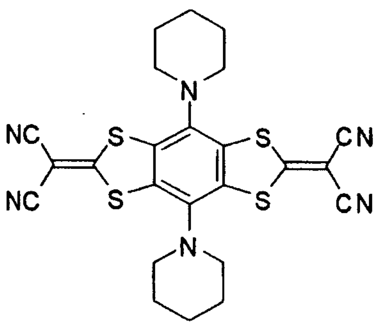
(55)

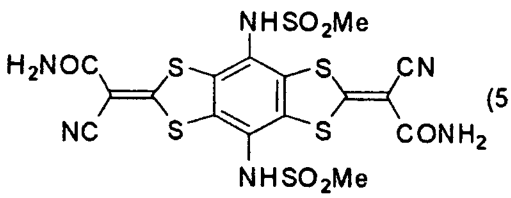
(56)

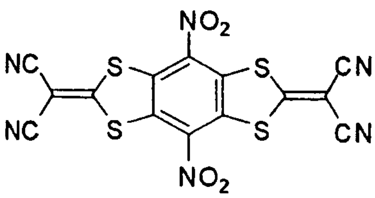
(57)

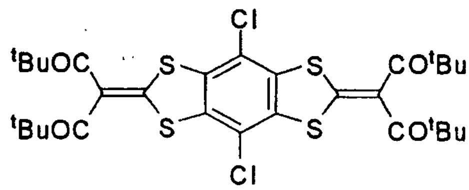
(58)

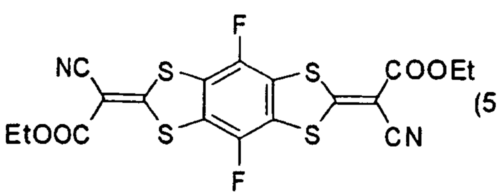
(59)

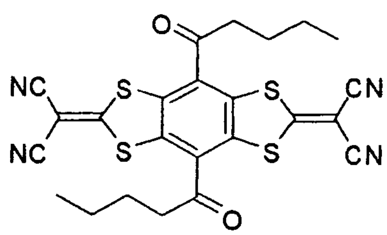
(60)

[Chemical formula 25]

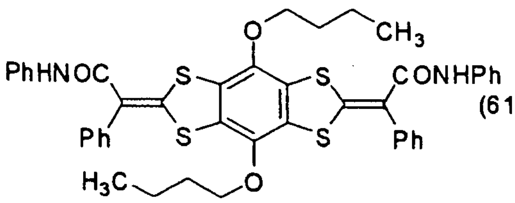
(61)

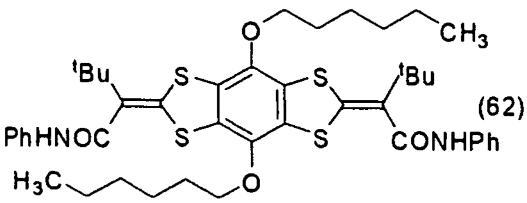
(62)

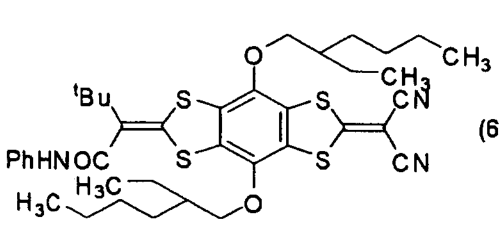
(63)

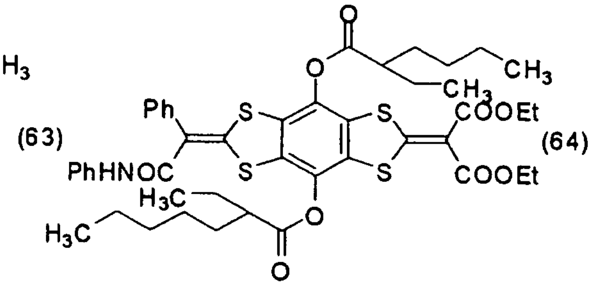
(64)

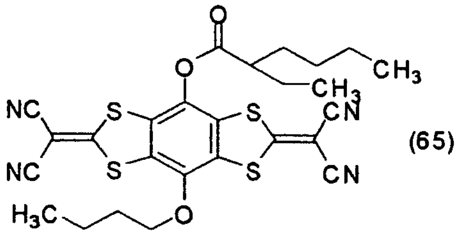
(65)

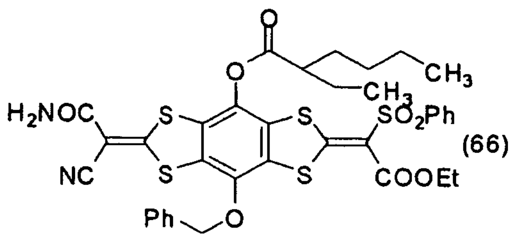
(66)

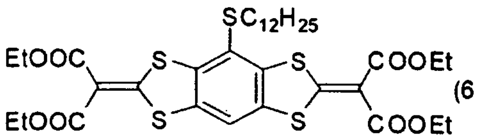
(67)

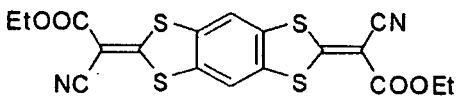
(68)

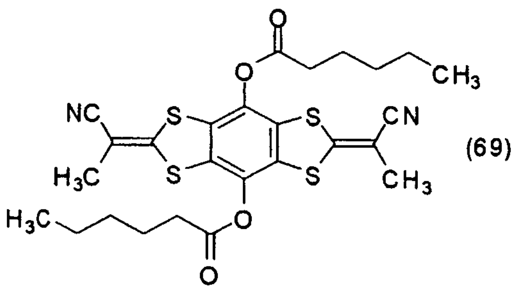
(69)

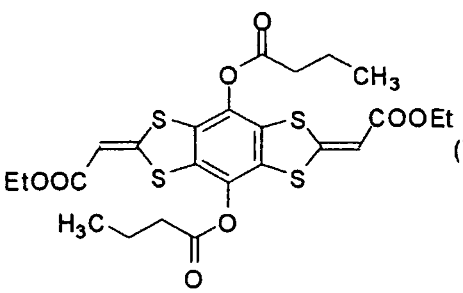
(70)

[Chemical formula 26]

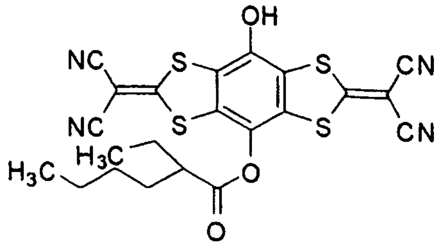
(71)

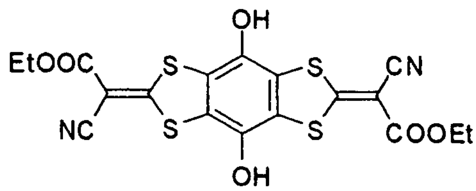
(72)

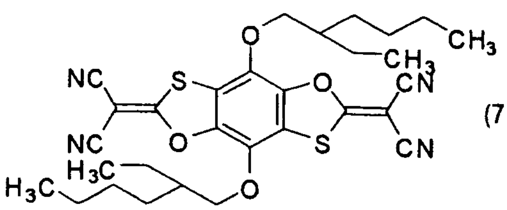
(73)

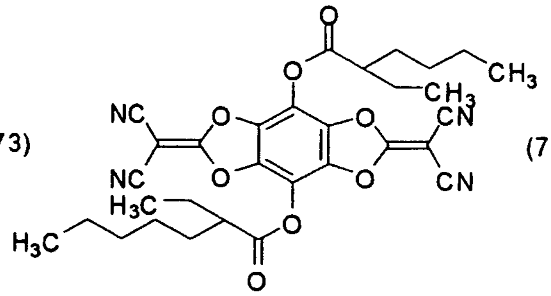
(74)

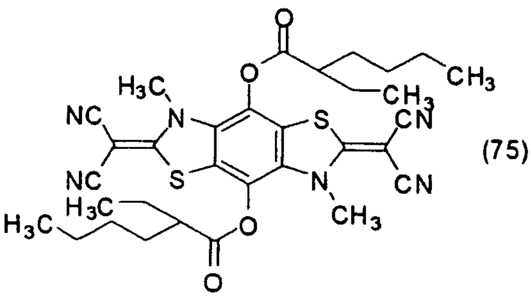
(75)

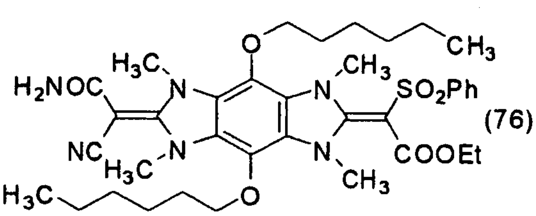
(76)

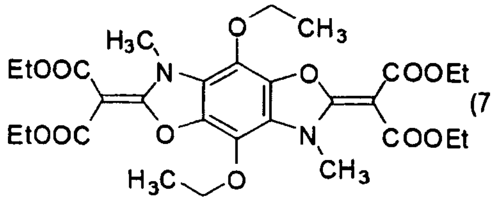
(77)

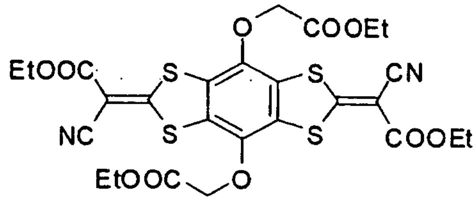
(78)

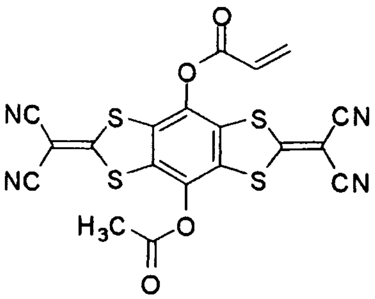
(79)

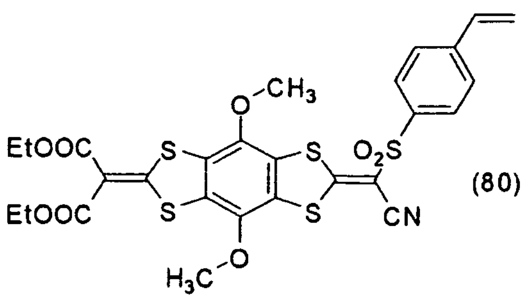
(80)

[Chemical formula 27]

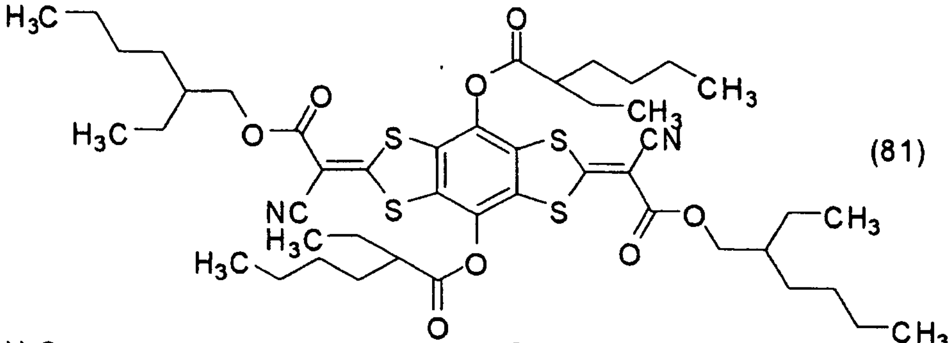

(81)

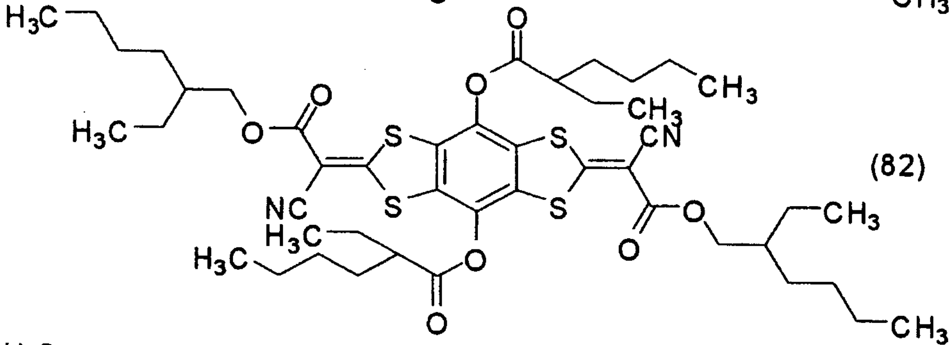

(82)

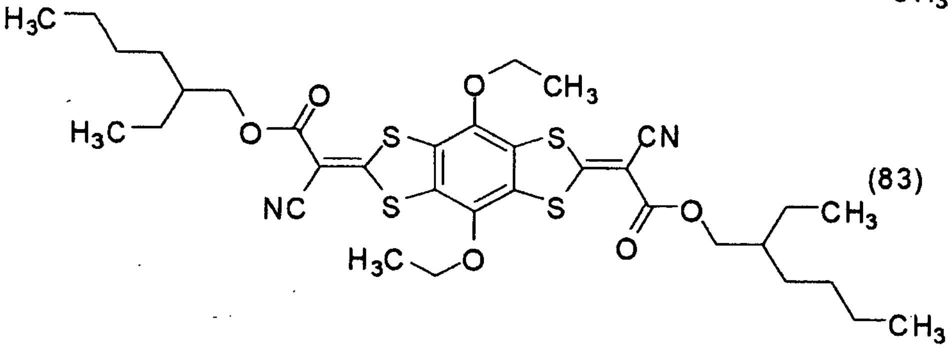

(83)

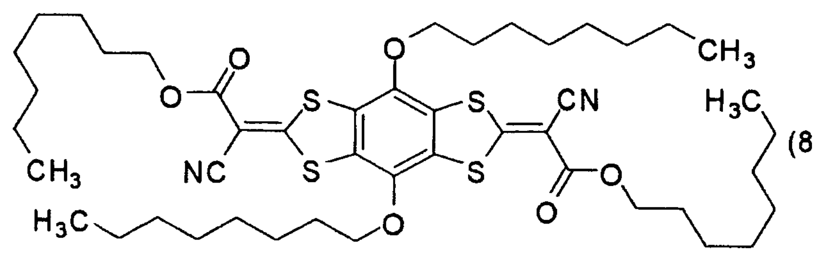

(84)

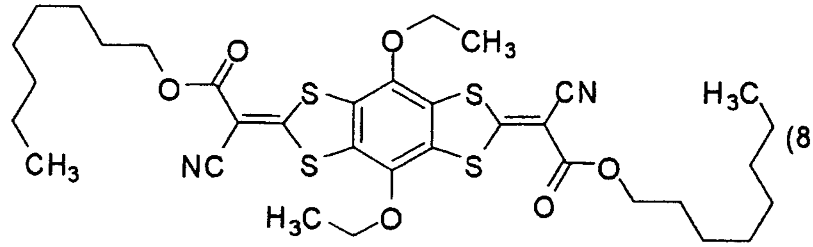

(85)

[Chemical formula 28]

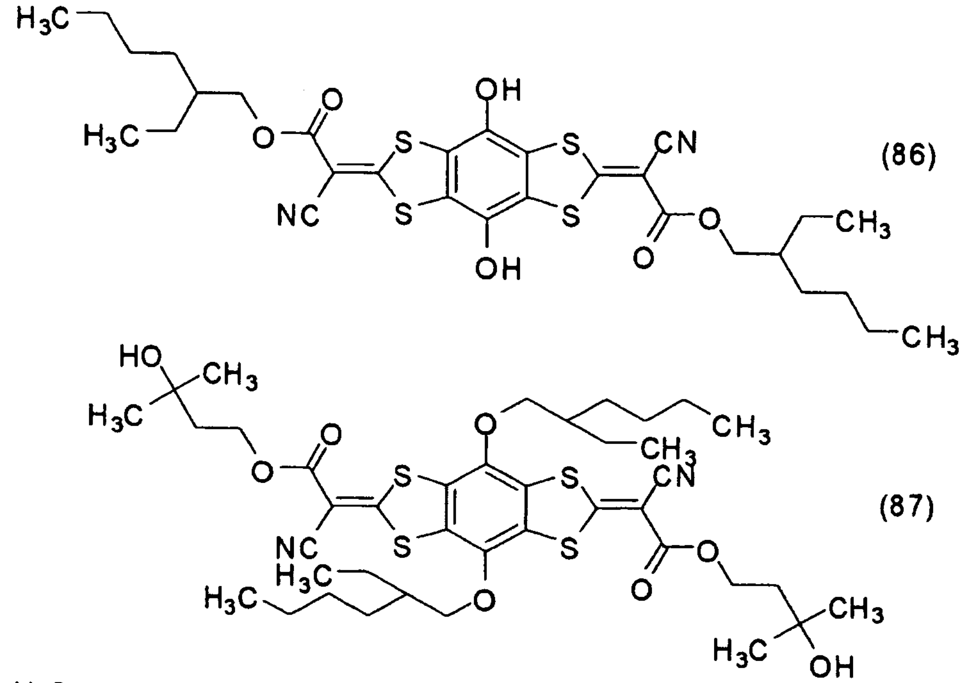

(86)

(87)

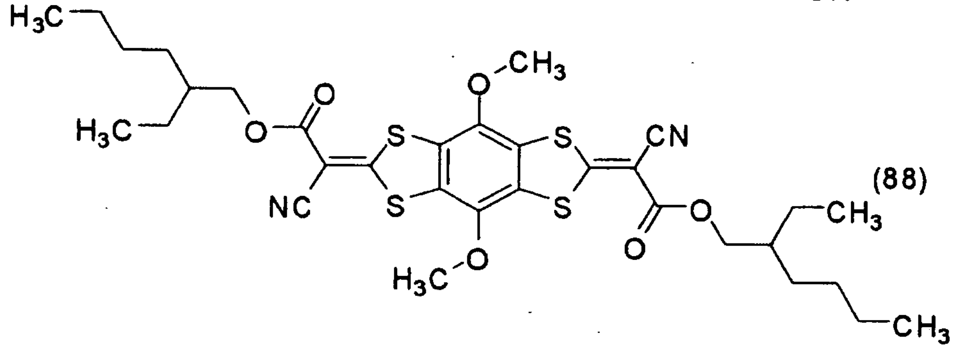

(88)

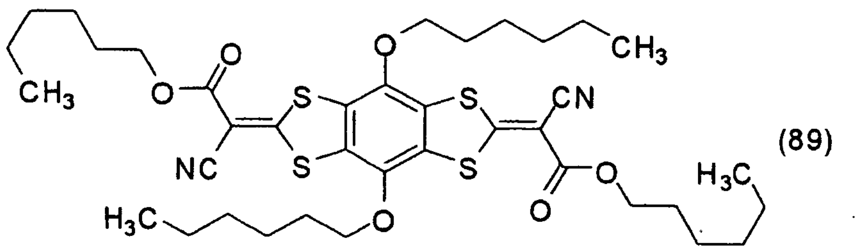

(89)

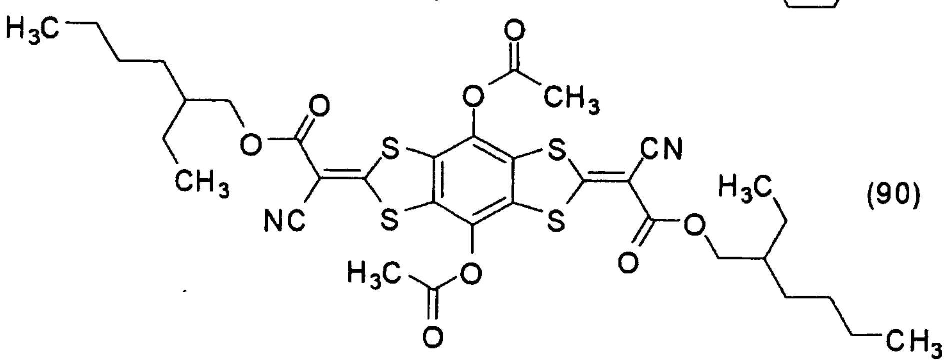

(90)

[Chemical formula 29]

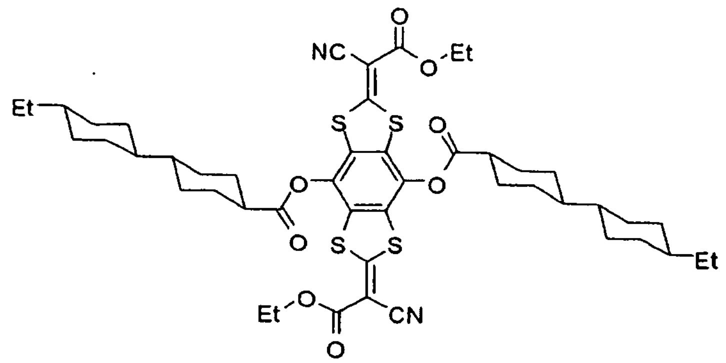

(91)

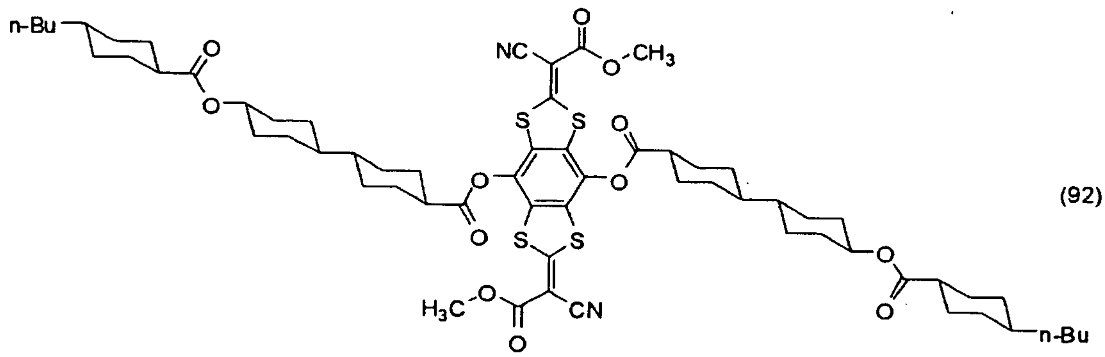

(92)

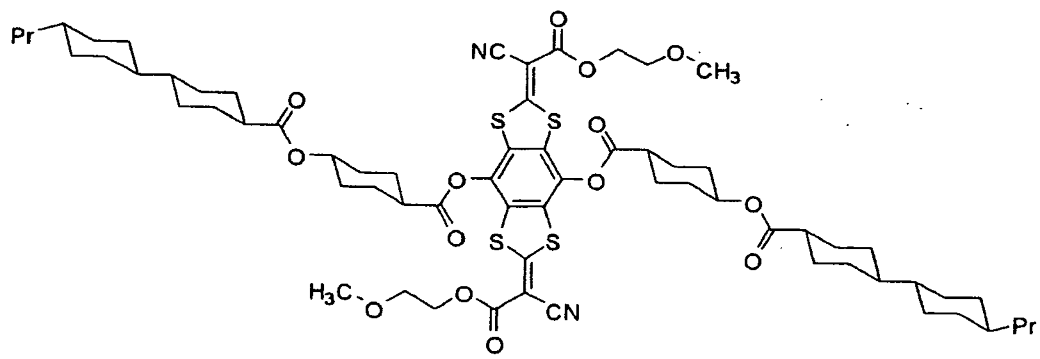

(93)

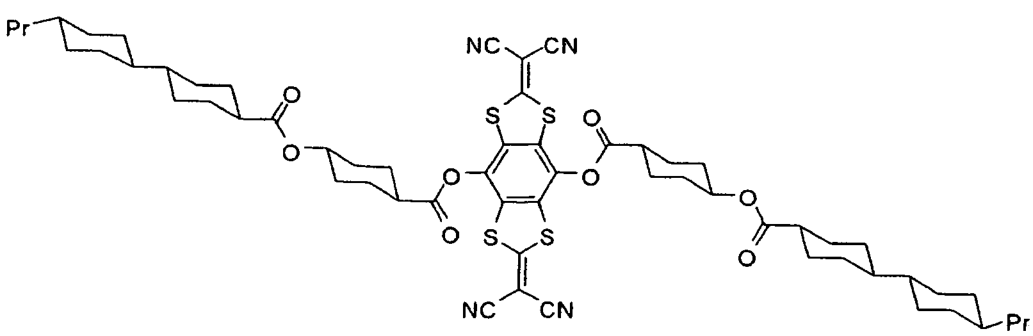

(94)

[Chemical formula 30]

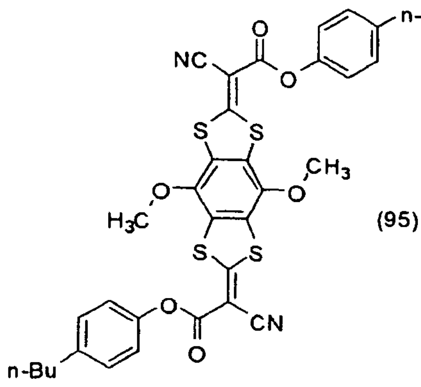

(95)

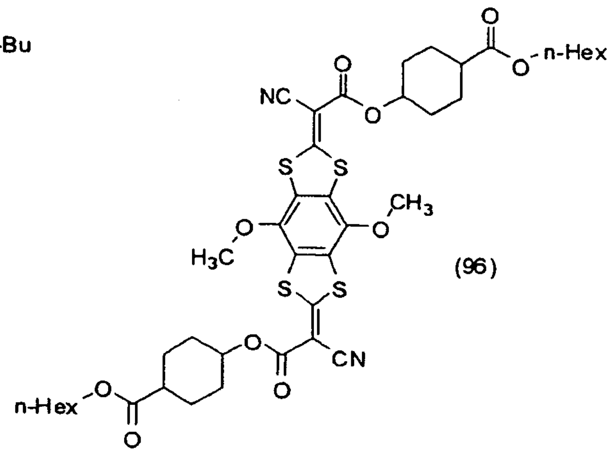

(96)

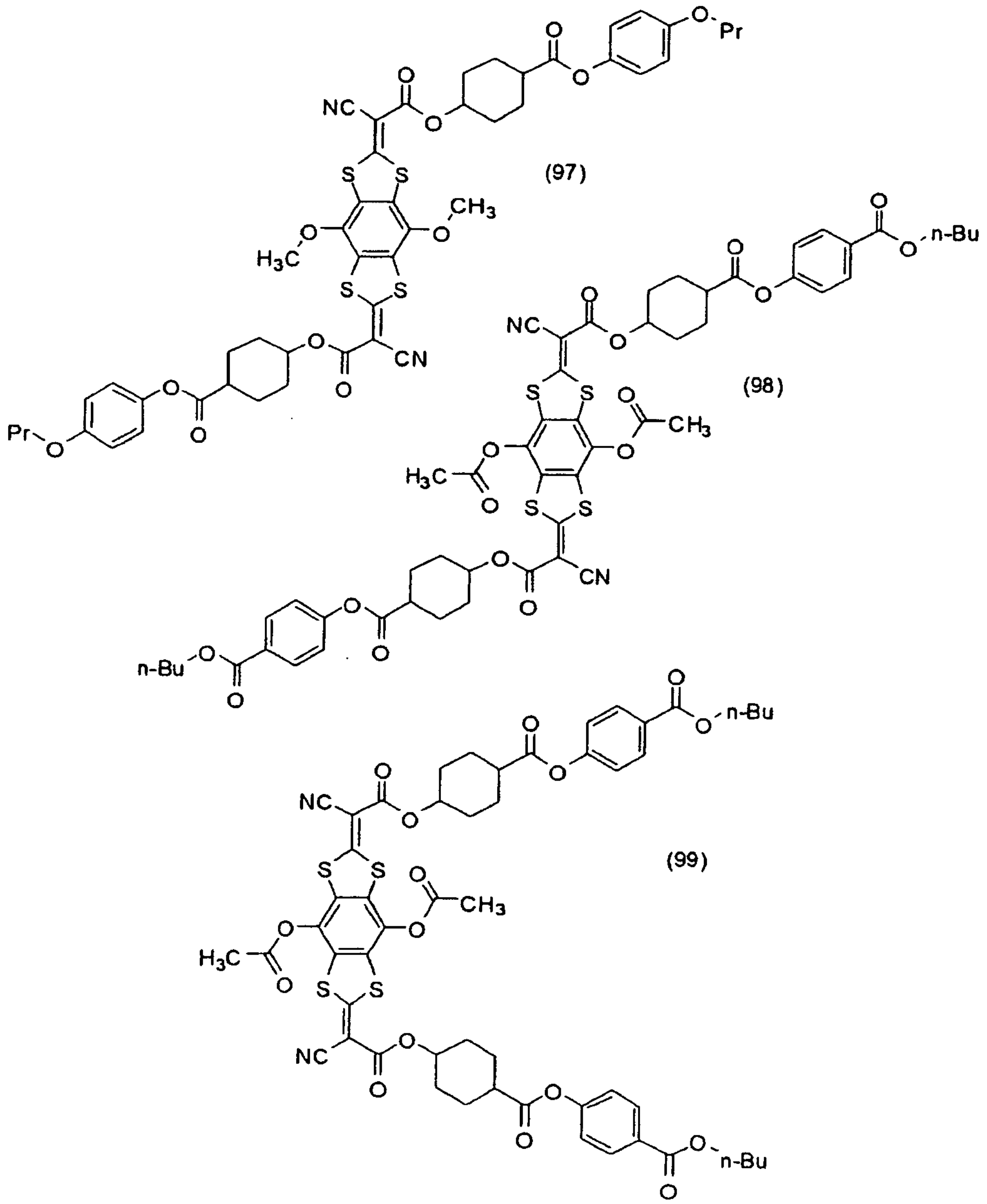

(97)

(98)

(99)

[Chemical formula 31]

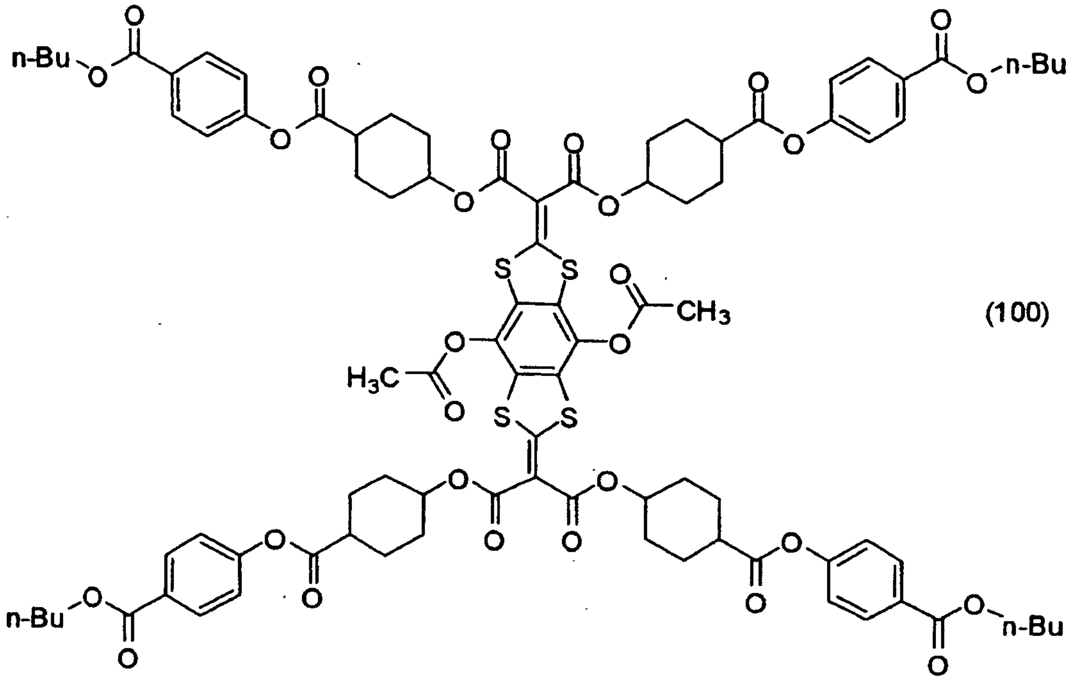

(100)

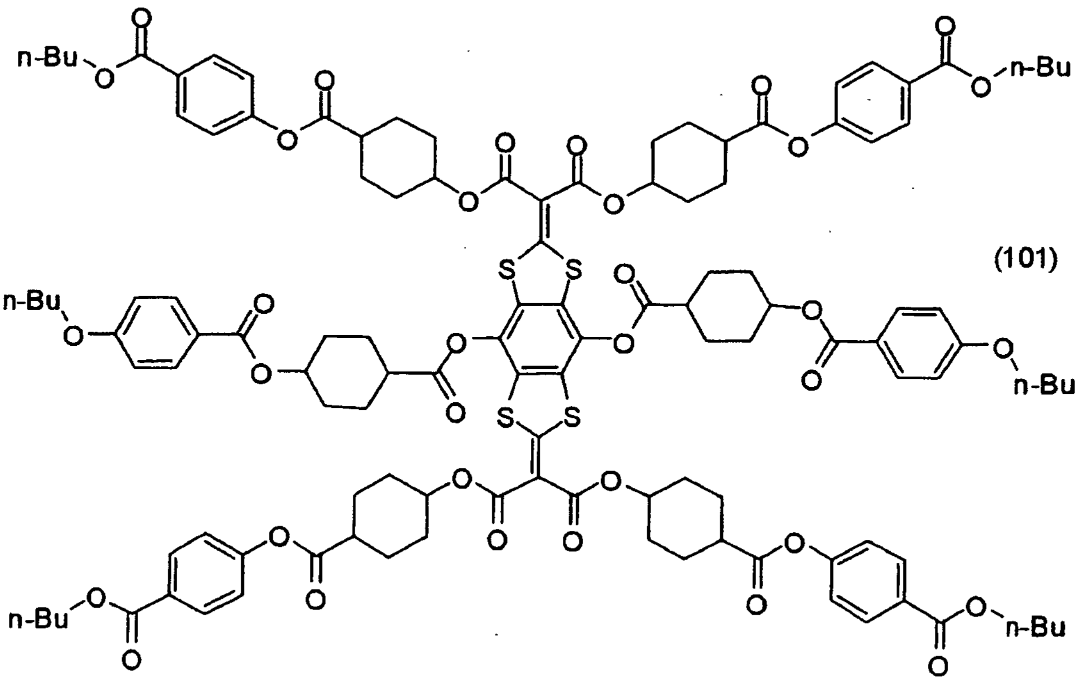

(101)

[Chemical formula 32]

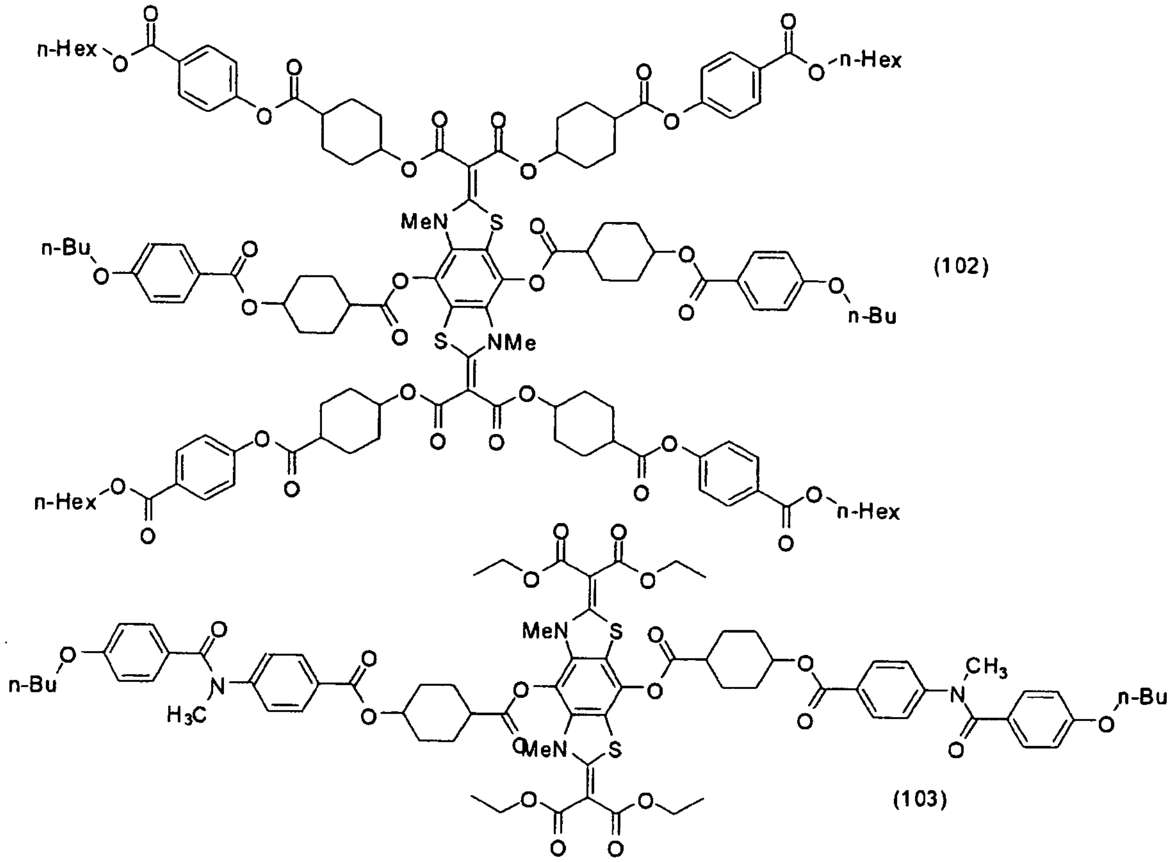

(102)

(103)

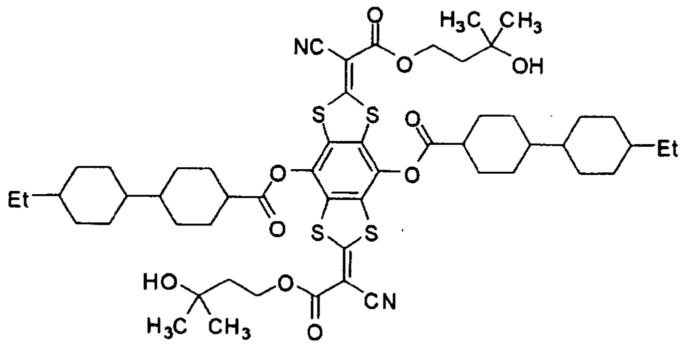

(104)

[Chemical formula 33]

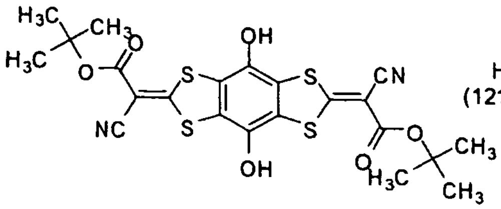
(121)

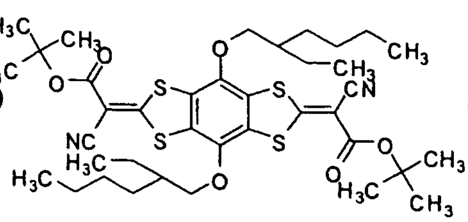
(122)

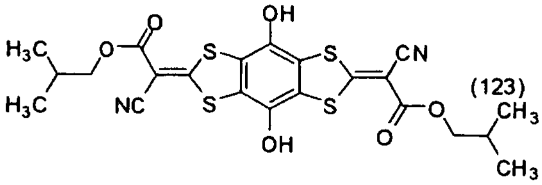
(123)

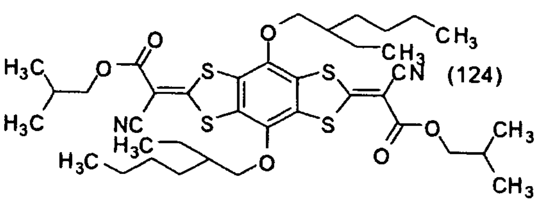
(124)

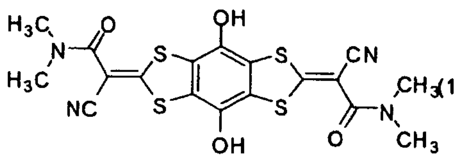
(125)

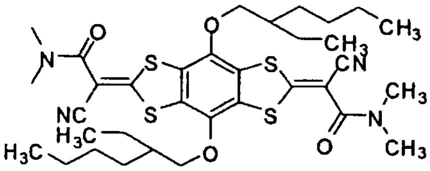
(126)

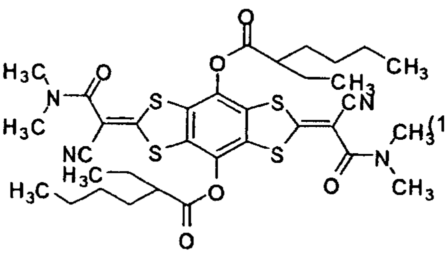
(127)

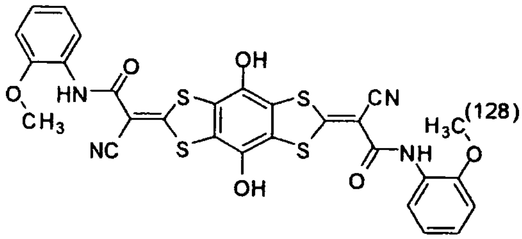
(128)

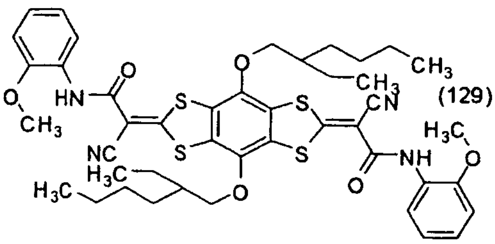
(129)

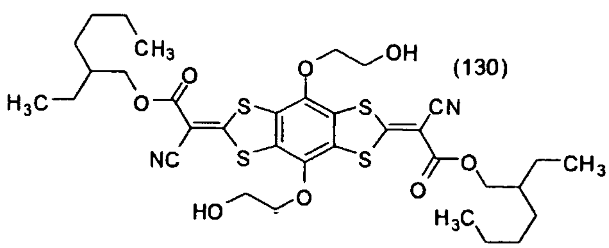
(130)

[Chemical formula 34]

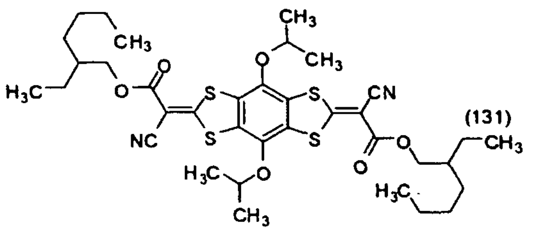
(131)

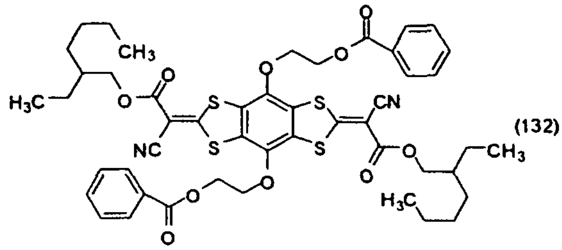
(132)

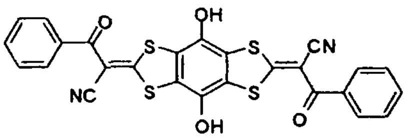
(133)

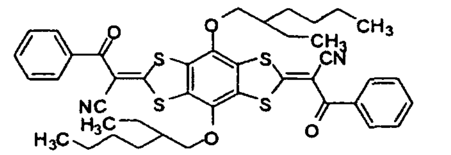
(134)

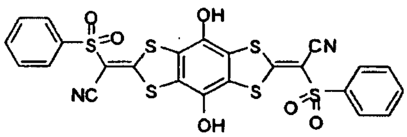
(135)

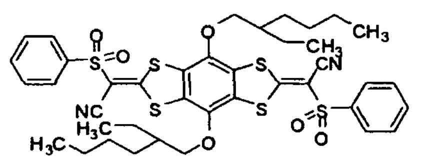
(136)

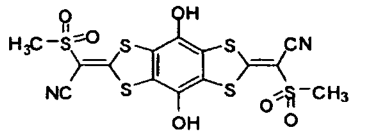
(137)

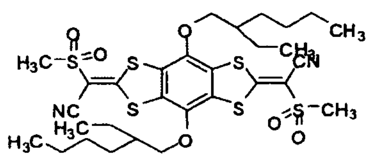
(138)

The ultraviolet absorbent represented by formula (B-I) or (B-Ia) above can be synthesized by any method. For example, such a compound can be synthesized by preparing, as a synthetic intermediate, a compound represented by formula (B-I) wherein $R^{B5}$ and $R^{B6}$ are a hydroxy group, and introducing desirable substituents by alkylation or acylation and the like.

For example, when $X^{B1}$, $X^{B2}$, $X^{B3}$ and $X^{B4}$ are all a sulfur atom, the synthetic intermediate represented by formula (B-I) wherein $R^{B5}$ and $R^{B6}$ are a hydroxy group can be synthesized according to the method in any one of known patents and literatures, for example, JP-A-63-225382, p. 3, right upper column, line 1 to left lower column, line 1, Reference Examples; and Liebigs Ann. Chem., 1969, vol. 726, p. 103-109, lines 5 to 12, p. 109.

In addition, the ultraviolet absorbent represented by formula (B-I) or (B-Ia) above can be synthesized according to the synthetic routes for preparation of compounds having similar structures described, for example, in Journal of Organic Chemistry, 1990, vol. 55, p. 5347-5350, experimental section on p. 5349, right column, line 27; ibid., 1994, vol. 59, p. 3077-3081, p. 3081, lines 11 to 16; Tetrahedron Letters, 1991, vol. 32, p. 4897-4900, p. 4897, line 9 to p. 4899, line 3; ibid., 1977, vol. 26, p. 2225, Table 1; Tetrahedron, 1993, vol. 49, p. 3035-3042, p. 3037, lines 11 to 20 and p. 3040, lines 22 to 38; Journal of the American Chemical Society, 1958, vol. 80, p. 1662-1664, p. 1664, right column, lines 6 to 15; ibid., 1995, vol. 117, p. 9995-10002, p. 9996, right column, line 12 to p. 9997, left column, line 46; JP-A-6-80672, p. 4, left column, line 43 to right column, line 45; Phosphorus, Sulfur, and Silicon, 1997, vol. 120 & 121, p. 121-143, p. 123, line 18 to p. 124, line 3; Chem. Commun., 2004, p. 1758-1759, p. 1758, left column, lines 44 to 54; German Patent No. 3728452, p. 4, line 46 to p. 5, line 16; JP-A-51-100097, p. 3, left upper column, line 3 to p. 4, left lower column, line 4; and JP-T-5-506428, p. 12, right lower column, line 1 to p. 35, right lower column, line 1.

For example, the exemplified compound (1) can be synthesized by allowing carbon disulfide and malononitrile to react with each other in the presence of sodium hydroxide to obtain a disodium salt, and allowing the disodium salt to react with chloranil, and then allowing the resultant product to react with 2-ethylhexanoyl chloride in the presence of base. The exemplified compound (2) can be synthesized by allowing carbon disulfide and malononitrile to react with each other in the presence of sodium hydroxide to obtain a disodium salt, and allowing the disodium salt to react with chloranil, and then allowing the resultant product to react with 2-ethylhexyl bromide in the presence of base.

The exemplified compound (11) can be synthesized by allowing carbon disulfide and ethyl cyanoacetate to react with each other in the presence of potassium hydroxide to obtain a dipotassium salt, and allowing the dipotassium

salt to react with chloranil to obtain the exemplified compound (72), and allowing the exemplified compound (72) to react with 2-ethylhaxanoyl chloride in the presence of base. The exemplified compound (12) can be synthesized by allowing the exemplified compound (72) to react with 2-ethylhexyl bromide in the presence of base.

The exemplified compound (59) can be synthesized by allowing carbon disulfide and ethyl cyanoacetate to react with each other in the presence of potassium hydroxide to obtain a dipotassium salt, and allowing the dipotassium salt to react with hexafluorobenzene.

The exemplified compound (51) can be synthesized by allowing the exemplified compound (59) to react with sodium dodecanethiolate.

When $R^{B1}$ and $R^{B2}$, $R^{B3}$ and $R^{B4}$, $X^{B1}$ and $X^{B2}$, $X^{B3}$ and $X^{B4}$, or $R^{B5}$ and $R^{B6}$ are different from each other, the ultraviolet absorbent represented by formula (B-I) may have a geometrical isomer wherein the respective groups are exchanged. Such a geometrical isomer is also included in the ultraviolet absorbent represented by formula (B-I) that can be used in the present invention, even when only one geometrical isomer is described in the present specification. In addition, even if a mixture of the geometrical isomers is formed in the preparative or purification process, only a typical isomeric structure is shown in the present specification. When the compound is a geometrical isomer mixture, the abundance ratio is arbitrary between 0:1 to 1:0.

The ultraviolet absorbent represented by any one of formulae (2), (3), (4), (5), (B-I) and (B-Ia) that can be used in the present invention may have a tautomer, depending on its structure and the environment to which the compound is exposed. In the present specification, only a typical tautomer is described, but other tautomers different from that described in the present specification are also included in the ultraviolet absorbent that can be used in the present invention compound.

The ultraviolet absorbent represented by any one of formulae (2), (3), (4), (5), (B-I) and (B-Ia) that can be used in the present invention may have an isotopic element (such as $^{2}H$, $^{3}H$, $^{13}C$, $^{15}N$, $^{17}O$, or $^{18}O$).

A polymer having the structure of the ultraviolet absorbent represented by any one of formulae (2), (3), (4), (5), (B-I) and (B-Ia) above in its recurring unit as the ultraviolet absorptive group can also be used favorably in the present invention. Hereinafter, examples of the recurring unit containing the structure of the ultraviolet absorbent represented by formula (2), (3), (4), (5), (B-I) or (B-Ia) above will be shown.

[Chemical formula 35]

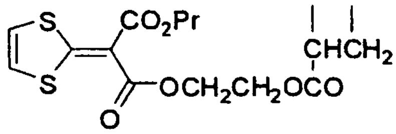

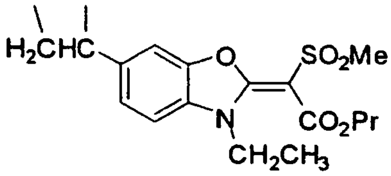

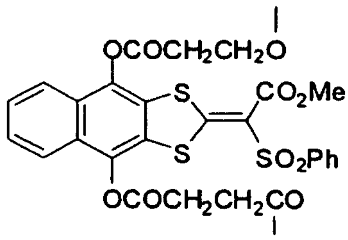

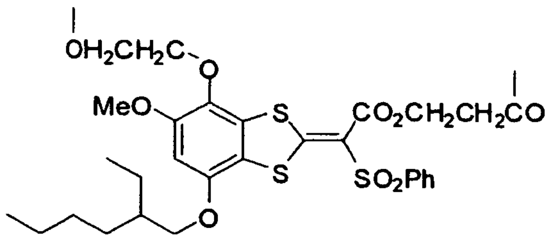

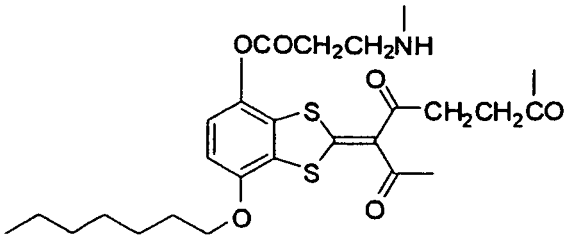

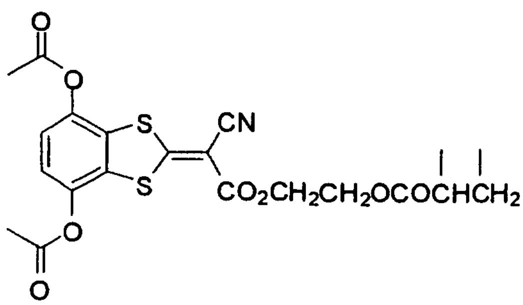

[Chemical formula 36]

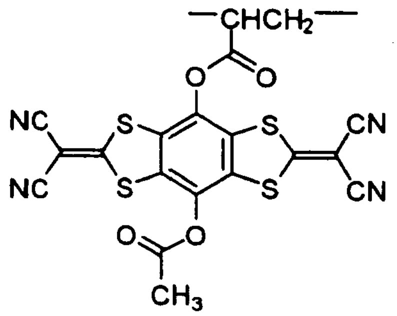

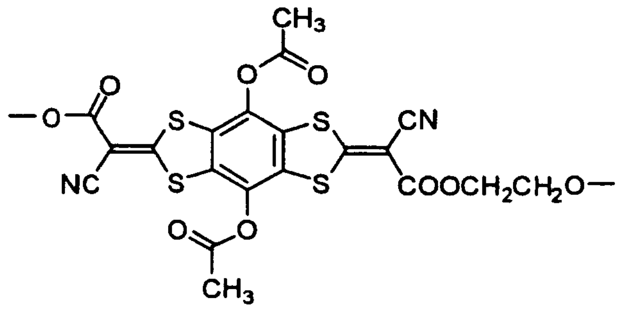

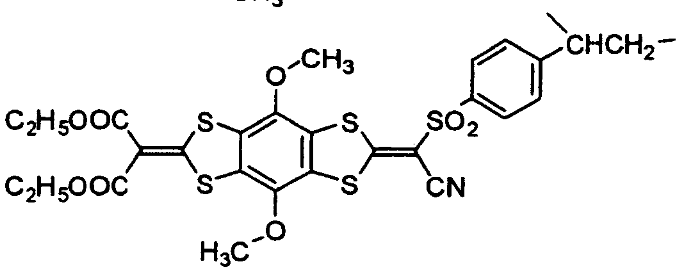

The polymer may be a homopolymer having one kind of recurring unit or a copolymer having two or more kinds of recurring units. It may be a copolymer having another recurring unit additionally. Hereinafter, examples of the other recurring unit are shown.

[Chemical formula 37]

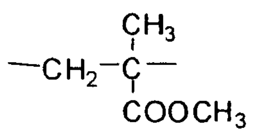

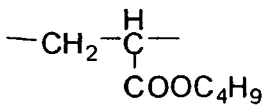

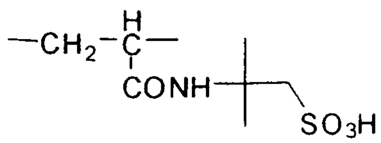

Examples of the polymer having the structure of the ultraviolet absorbent in the recurring unit are described, for example, in JP-B-1-53455, left column, line 39 to p. 12, right column, line 38; JP-A-61-189530, p. 3, right upper column, line 8 to p. 7, left lower column, line 15; JP-A-62-260152, right lower column, line 3 to p. 12, right upper column, line 10; JP-A-63-53544, left upper column, line 1 to p. 15, right lower column, line 19; JP-A-63-56651, p. 2, right upper column, line 10 to p. 14, left lower column, line 3; EP Patent No. 27242, p. 4, line 29 to p. 16, line 34; and WO 2006/009451 pamphlet, p. 3, line 28 to p. 26, line 1. The polymer can be prepared with reference to the methods described in these Patent Documents.

Next, the compound represented by formula (TS-I) or (TS-II) that can be used in the present invention will be described.

[Chemical formula 38]

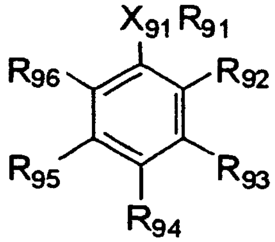

(TS-I)

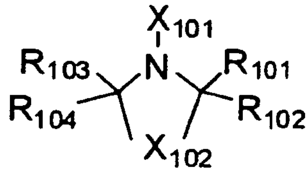

(TS-II)

In formula (TS-I), $R_{91}$ represents a hydrogen atom, a substituted or unsubstituted alkyl group (including a cyclic alkyl group such as a cycloalkyl group, a bicycloalkyl group and a tricycloalkyl group), a substituted or unsubstituted alkenyl group (including a cyclic alkenyl group such as a cycloalkenyl group, a bicycloalkenyl group and a tricycloalkenyl group), a substituted or unsubstituted aryl group, a substituted or unsubstituted heterocyclic group, a substituted or unsubstituted acyl group, a substituted or unsubstituted alkoxycarbonyl group, a substituted or unsubstituted aryloxycarbonyl group, a substituted or unsubstituted alkyl sulfonyl group (including a cyclic alkyl sulfonyl group such as a cycloalklyl sulfonyl group, a bicycloalklyl sulfonyl group and a tricycloalklyl sulfonyl group), a substituted or unsubstituted aryl sulfonyl group, or $-Si(R_{97})(R_{98})(R_{99})$. $R_{97}$, $R_{98}$, and $R_{99}$, which may be the same as or different from each other, each independently represent an alkyl group, an alkenyl group, an aryl group, an alkoxy group, an alkenyloxy group, or an aryloxy group. $-X_{91}-$ represents - O-, -S-, or $-N(-R_{100})-$, in which $R_{100}$ has the same meaning as $R_{91}$. $R_{92}$, $R_{93}$, $R_{94}$, $R_{95}$ and $R_{96}$, which may be the same as or different from each other, each independently represent a hydrogen atom, or a substituent. However, all of $R_{91}$, $R_{92}$, $R_{93}$, $R_{94}$, $R_{95}$, $R_{96}$ and $R_{100}$ cannot simultaneously represent a hydrogen atom, respectively, and the total number of carbon atoms is 10 or more.

When the group in the present specification contains an aliphatic moiety, the aliphatic moiety may be straight chain-like, branched chain-like, or cyclic, and saturated or unsaturated. Examples of the aliphatic moiety include alkyl, alkenyl, cycloalkyl, and cycloalkenyl moieties, each of which may be non-substituted, or substituted with a substituent. Further, when the group contains an aryl moiety, the aryl moiety may be a single ring or a fused ring, each of which may be non-substituted, or substituted with a substituent. Further, when the group contains a heterocyclic moiety, the heterocyclic moiety contains a hetero atom (for example, a nitrogen atom, a sulfur atom, an oxygen atom) in the ring, and may be a saturated ring, or an unsaturated ring, and may be a single ring or a fused ring, each of which may be non-substituted, or substituted with a substituent. The substituent may bind with a hetero atom, or a carbon atom in the ring.

The substituent used in the present invention is not particularly limited, as long as it is a replaceable group. Examples thereof include an aliphatic group, an aryl group, a heterocyclic group, an acyl group, an acyloxy group, an acyl amino group, an aliphatic oxy group, an aryloxy group, a heterocyclic oxy group, an aliphatic oxycarbonyl group, an aryloxycarbonyl group, a heterocyclic oxycarbonyl group, a carbamoyl group, an aliphatic sulfonyl group, an arylsulfonyl group, a heterocyclic sulfonyl group, an aliphatic sulfonyloxy group, an arylsulfonyloxy group, a heterocyclic sulfonyloxy group, a sulfamoyl group, an aliphatic sulfonamido group, an arylsulfonamido group, a heterocyclic sulfonamido group, an aliphatic amino group, an arylamino group, a heterocyclic amino group, an aliphatic oxycarbonylamino group, an aryloxycarbonylamino group, a heterocyclic oxycarbonylamino group, an aliphatic sulfinyl group, an arylsulfinyl group, an aliphatic thio group, an arylthio group, a hydroxy group, a cyano group, a sulfo group, a carboxyl group, an aliphatic oxyamino group, an aryloxyamino group, a carbamoylamino group, a sulfamoylamino group, a halogen atom, a sulfamoyl carbamoyl group, a carbamoyl sulfamoyl group, a phosphinyl group, and a phosphoryl group.

The compound represented by formula (TS-I) is described in detail below.

$R_{91}$ represents a hydrogen atom, an alkyl group (including a cyclic alkyl group such as a cycloalkyl group, a bicycloalkyl group and a tricycloalkyl group, e.g., a methyl group, an i-propyl group, a s-butyl group, a dodecyl group, a methoxyethoxy group and a benzyl group), an alkenyl group (including a cyclic alkenyl group such as a cycloalkenyl group, a bicycloalkenyl group, and a tricycloalkenyl group, e.g., an allyl group), an aryl group (e.g., a phenyl group, a p-methoxyphenyl group), a heterocyclic group (e.g., a 2-tetrahydrofuryl group, a pyranyl group), an acyl group (e.g., an acetyl group, a pivaloyl group, a benzoyl group, an acryloyl group), an alkyl- or alkenyloxycarbonyl group (e.g., a methoxycarbonyl group, a hexadecyloxycarbonyl group), an aryloxycarbonyl group (e.g., a phenoxycarbonyl group, a p-methoxyphenoxy carbonyl group), an alkyl sulfonyl group (e.g., a methanesulfonyl group, a butanesulfonyl group), an arylsulfonyl group (e.g., a benzene sulfonyl group, a p-toluenesulfonyl group) or - $Si(R_{97})(R_{98})(R_{99})$. $R_{97}$, $R_{98}$, and $R_{99}$ may be the same as or different from each other. $R_{97}$, $R_{98}$, and $R_{99}$ each represent an alkyl group (e.g., a methyl group, an ethyl group, a t-butyl group, a benzyl group), an alkenyl group (e.g., an allyl group), an aryl group (e.g., a phenyl group), an alkoxy group (e.g., a methoxy group, a butoxy group), an alkenyloxy group (e.g., an allyloxy group) or an aryloxy group (e.g., a phenoxy group). It is not preferable that the group is a phosphinotolyl group or a phosphinyl group because these groups are inferior in solubility in a solvent and compatibility with a polymer.

$-X_{91}-$ represents -O-, -S- or $-N(-R_{100})-$. $R_{100}$ has the same meaning as that of $R_{91}$, and preferable ranges thereof are also the same. $R_{92}$, $R_{93}$, $R_{94}$, $R_{95}$ and $R_{96}$, which may be the same as or different from each other, each independently represent a hydrogen atom or a substituent. Examples of the substituent include a hydrogen atom, an alkyl group (including a cyclic alkyl group such as a cycloalkyl group, a bicycloalkyl group and a tricycloalkyl group), an alkenyl group (including a cyclic alkenyl group such as a cycloalkenyl group, a bicycloalkenyl group and a tricycloalkenyl group), an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an acylamino group, an aminocarbonylamino group, an alkoxycarbonylamino group, an aryloxycarbonylamino group, a sulfamoylamino group, an alkyl- or aryl-sulfonylamino group, a mercapto group, an alkylthio group, an arylthio group, a heterocyclic thio group, a sulfamoyl group, a sulfo group, an alkyl- or arylsulfinyl group, an alkyl- or aryl-sulfonyl group, an acyl group, an aryloxycarbonyl group, an alkoxycarbonyl group, a carbamoyl group, an aryl- or heterocyclic-azo group, an imido group, a phosphino group, a phophinyl group, a phosphinyloxy group, a phosphinylamino group and a silyl group.

Among these, preferred examples of the substituent include an alkyl group (e.g., a methyl group, a t-butyl group, a t-hexyl group, a benzyl group), an alkenyl group (e.g., an allyl group), an aryl group (e.g., a phenyl group), an alkoxycarbonyl group (e.g., a methoxycarbonyl group, a dodecyloxycarbonyl group), an aryl oxycarbonyl group (e.g., a phenoxycarbonyl group), an alkyl- or alkenyl-sulfonyl group (e.g., a methanesulfonyl group, a butanesulfonyl group), an arylsulfonyl group (e.g., a benzene sulfonyl group, a p-hydroxybenzenesulfonyl group) or $-X_{91}-R_{91}$.

It is not preferable that $R_{91}$ and $R_{92}$, or $R_{100}$ and $R_{96}$, or $R_{91}$ and $R_{100}$ bind together with each other to form a 5- to 7-membered ring (for example, a chromane ring, a morpholine ring) because these rings are inferior in solubility in a solvent and compatibility with a polymer. Further, it is also not preferable from viewpoints of solubility and compatibility that $R_{92}$ and $R_{93}$, or $R_{93}$ and $R_{94}$ bind together with each other to form a 5- to 7-membered ring (for example, a chromane ring, an indane ring), a spiro ring or a bicycle ring. However, all of $R_{91}$, $R_{92}$, $R_{93}$, $R_{94}$, $R_{95}$, $R_{96}$ and $R_{100}$ are not a hydrogen atom at the same time. The total number of carbon atoms is 10 or more, and preferably 16 or more.

The compound represented by formula (TS-I) that can be used in the present invention includes those compounds represented by any of, for example, formula (IIIa) of JP-B-2-37575, formula of JP-B-2-50457, formula (I) or (II) of JP-A-2-66541, formula (III) of JP-A-2-139544, formula (III) of JP-A-3-200758, formula (II) of JP-A-3-48845, formula (B) of JP-A-3-266836, and formula (I) of JP-A-3-96944.

As the compound represented by the formula (TS-I), compounds represented by the following formulae (TS-IC) to (TS-IG) are exemplified. In the present invention, compounds having these structures are preferable.

[Chemical formula 39]

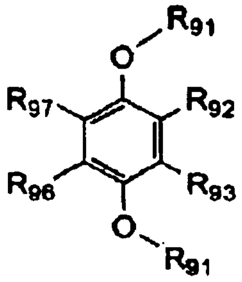

(TS-IC)

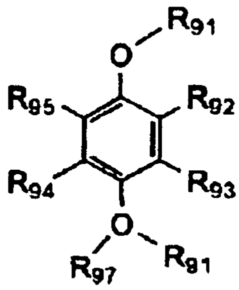

(TS-ID)

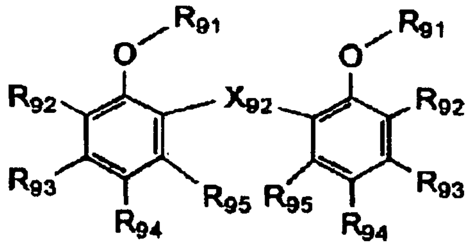

(TS-IE)

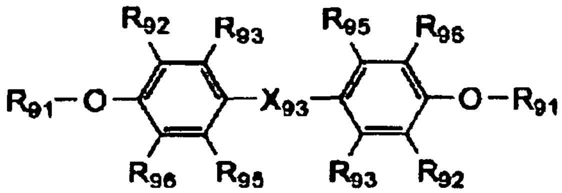

(TS-IF)

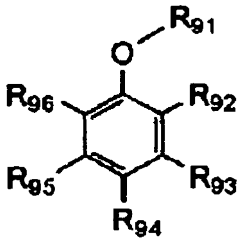

(TS-IG)

In formulae (TS-IC) to (TS-IG), $R_{91}$ to $R_{97}$ have the same meanings as those defined in formula (TS-I), and preferable ranges thereof are also the same. $R_{a1}$ to $R_{a4}$ each represent a hydrogen atom or an aliphatic group. $X_{92}$ and $X_{93}$ each represent a divalent linking group. Examples of the divalent linking group include an alkylene group, an oxy group and a sulfonyl group. In the formulae, the same symbols in the same molecule may be the same as or different from each other.

In formula (TS-II), $R_{101}$, $R_{102,}$ $R_{103}$, and $R_{104}$ each independently represent a hydrogen atom, an alkyl group (including a cyclic alkyl group such as a cycloalkyl group, a bicycloalkyl group and a tricycloalkyl group), or an alkenyl group (including a cyclic alkenyl group such as a cycloalkenyl group, a bicycloalkenyl group and a tricycloalkenyl group); each combination of $R_{101}$, and $R_{102}$, and/or $R_{103}$ and $R_{104}$ may bind to each other to form a 5- to 7-membered ring.

$X_{101}$ represents a hydrogen atom, a substituted or unsubstituted alkyl group (including a cyclic alkyl group such as a cycloalkyl group, a bicycloalkyl group and a tricycloalkyl group), a substituted or unsubstituted alkenyl group (including a cyclic alkenyl group such as a cycloalkenyl group, a bicycloalkenyl group and a tricycloalkenyl group), a substituted or unsubstituted alkoxy group, a substituted or unsubstituted alkenyloxy group, a substituted or unsubstituted alkyl- or alkenyloxycarbonyl group, a substituted or unsubstituted aryloxycarbonyl group, a substituted or unsubstituted acyl group, a substituted or unsubstituted acyloxy group, a substituted or unsubstituted alkyloxycarbonyloxy group, a substituted or unsubstituted alkenyloxycarbonyloxy group, a substituted or unsubstituted aryloxycarbonyloxy group, a substituted or unsubstituted alkyl- or alkenyl-sulfonyl group, a substituted or unsubstituted arylsulfonyl group, a substituted or unsubstituted alkyl- or alkenylsulfinyl group, a substituted or unsubstituted arylsulfinyl group, a substituted or unsubstituted sulfamoyl group, a substituted or unsubstituted carbamoyl group, a hydroxy group or an oxy radical group.

$X_{102}$ represents a group of hetero atoms necessary for forming a 5- to 7-membered ring.

The compound represented by formula (TS-II) is further described in detail below.

In formula (TS-II), $R_{101}$, $R_{102}$, $R_{103}$ and $R_{104}$ each are a hydrogen atom, an alkyl group (e.g., a methyl group,

an ethyl group) or an alkenyl group (e.g., an allyl group); preferably an alkyl group.

$X_{101}$ represents a hydrogen atom, an alkyl group (e.g., a methyl group, an ethyl group), an alkenyl group (e.g., an allyl group), an alkyloxy group (e.g., a methoxy group, an octyloxy group, a cyclohexyloxy group), an alkenyloxy group (e.g., an allyloxy group), an alkyloxycarbonyl group (e.g., a methoxycarbonyl group, a hexadecyloxycarbonyl group), an alkenyloxycarbonyl group (e.g., an allyloxycarbonyl group), an aryloxycarbonyl group (e.g., a phenoxycarbonyl group, a p-chlorophenoxycarbonyl group), an acyl group (e.g., an acetyl group, a pivaloyl group, a methacryloyl group), an acyloxy group (e.g., an acetoxy group, a benzoyloxy group), an alkyloxycarbonyloxy group (e.g., a methoxycarbonyloxy group, an octyloxycarbonyloxy group), an alkenyloxycarbonyloxy group (e.g., an allyloxycarbonyloxy group), an aryloxycarbonyloxy group (e.g., a phenoxycarbonyloxy group), an alkylsulfonyl group (e.g., a methanesulfonyl group, a butanesulfonyl group), an alkenylsulfonyl group (e.g., an allylsulfonyl group), an arylsulfonyl group (e.g., a benzene sulfonyl group, a p-toluenesulfonyl group), an alkylsulfinyl group (e.g., a methanesulfinyl group, an octanesulfinyl group), an alkenylsulfinyl group (e.g., an allylsulfinyl group), an arylsulfinyl group (e.g., a benzenesulfinyl group, a p-toluenesulfinyl group), a sulfamoyl group (e.g., a dimethylsulfamoyl group), a carbamoyl group (e.g., a dimethylcarbamoyl group, a diethylcarbamoyl group), a hydroxy group, or an oxy radical group.

$X_{102}$ represents a group of hetero atoms necessary for forming a 5- to 7-membered ring (e.g., a piperidine ring, a piperazine ring).

In formula (TS-II), it is further preferable that $R_{103}$, $R_{104}$, $R_{105}$ and $R_{106}$ each are an alkyl group having 1 to 3 carbon atoms; $X_{101}$ is an oxy radical group, an alkyl group having 1 to 12 carbon atoms, an alkenyl group having 3 to 12 carbon atoms, a cycloalkyl group having 5 to 12 carbon atoms, an acyl group having 2 to 14 carbon atoms, or an aryl group having 6 to 20 carbon atoms; and $X_{102}$ forms a cyclohexane ring.

The compound represented by formula (TS-II) is particularly preferably a compound represented by formula (TS-IIa).

[Chemical formula 40]

Formula (TS-IIa)

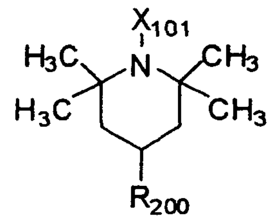

In formula (TS-IIa), $X_{101}$ has the same meaning as that of $X_{101}$ in formula (TS-II), and preferable ranges thereof are also the same. $R_{200}$ represents a monovalent substituent. Examples of the monovalent substituent include those described above as the monovalent substituent.

The compound represented by formula (TS-II) that can be used in the present invention include those compounds represented by, for example, formula (I) of JP-B-2-32298, formula (1) of JP-B-3-39296, formula of JP-B-3-40373, formula (I) of JP-A-2-49762, formula (II) of JP-A-2-208653, formula (III) of JP-A-2-217845, formula (B) of U.S. Patent No. 4,906,555, formula of European Patent Publication EP309,400A2, formula of European Patent Publication EP309,401A1, and formula of European Patent Publication EP309,402A1.

Among the compound represented by formula (TS-I) or (TS-II), the compound represented by formula (TS-II) is more preferable. Particularly preferred examples of the compound represented by formula (TS-II) include those having a 2,2,6,6-tetraalkylpiperidine skeleton.

Hereinafter, specific examples of the compound represented by formula (TS-I) or (TS-II) will be shown, but the present invention should not be considered to be limited thereto. In addition, T I-1 to T 1-57 are appended in sequence as a reference number to the compounds that fall within the above-described formula (TS-I), while T II-1 to T II-36 are appended to the compounds that fall within the above-described formula (TS-II).

[Chemical formula 41]

(TI-1)

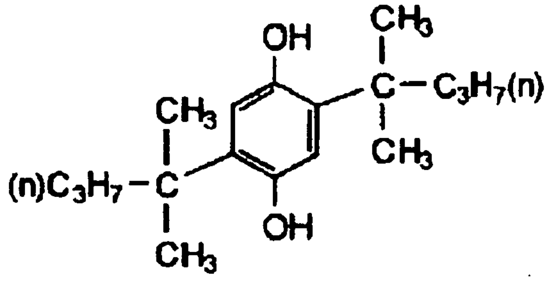

(TI-2)

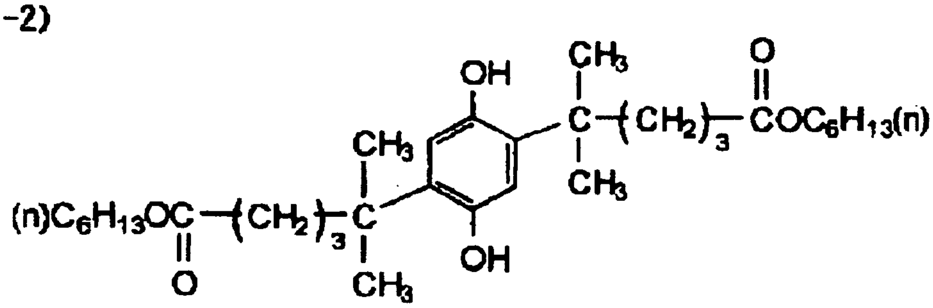

(TI-3)

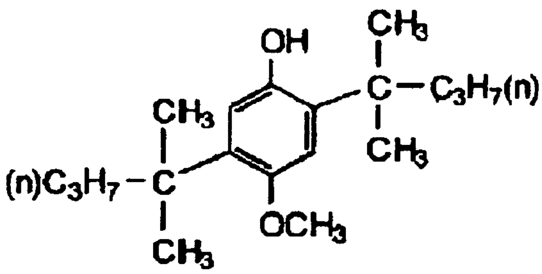

(TI-4)

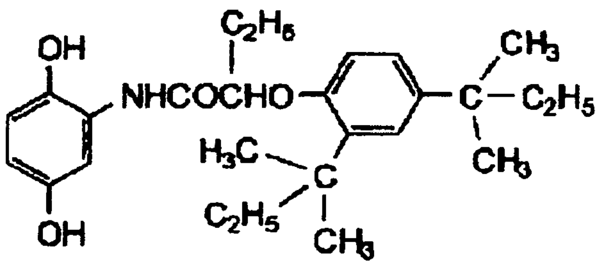

(TI-5)

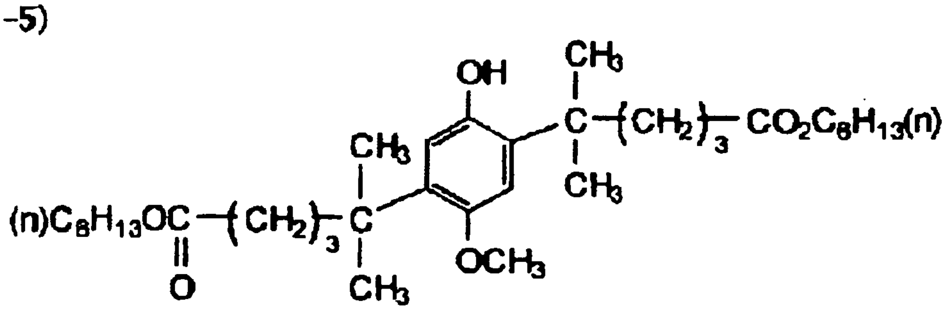

[Chemical formula 42]

(TI-6)

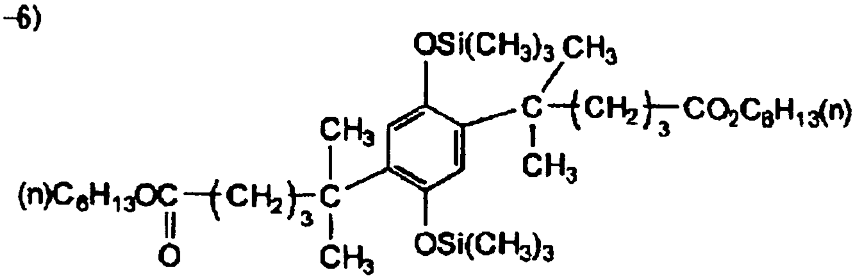

(TI-7)

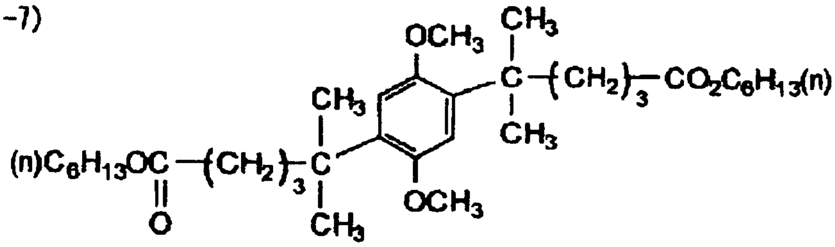

[Chemical formula 43]

(TI-15)

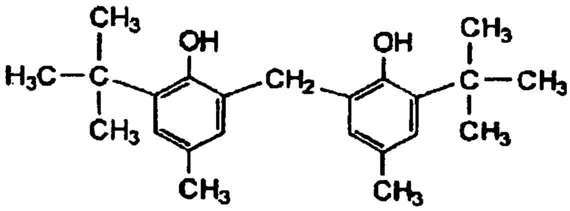

(TI-16)

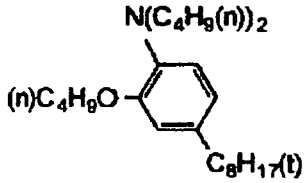

(TI-18)

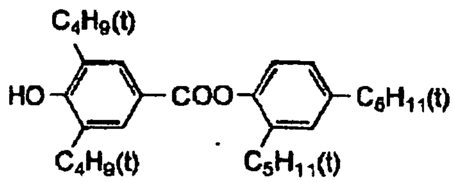

(TI-20)

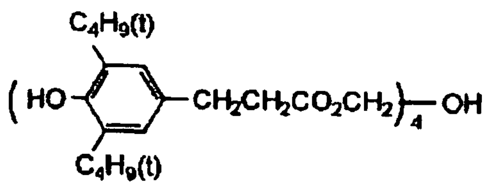

[Chemical formula 44]

(TI-22)

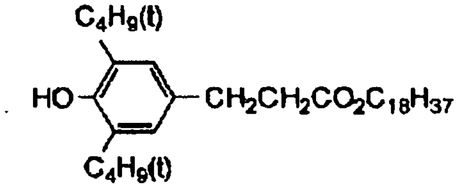

(TI-24)

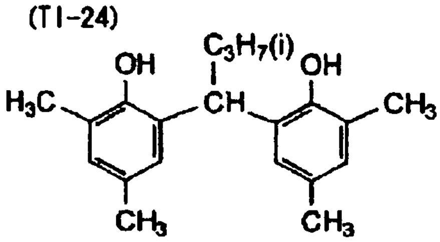

(TI-25)

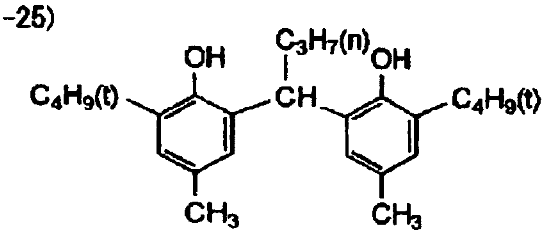

(TI-26)

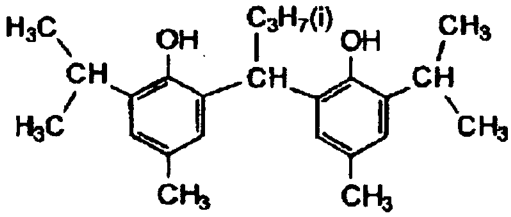

(TI-27)

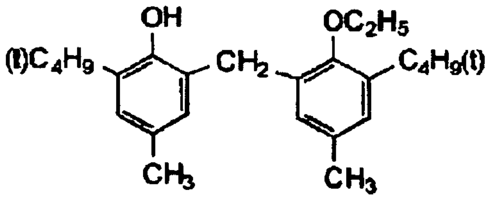

(TI-28)

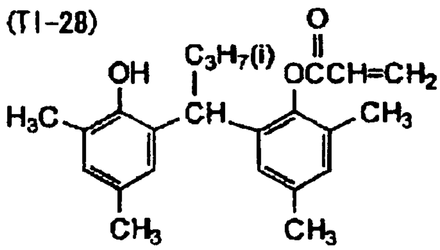

[Chemical formula 45]

(TI-29)

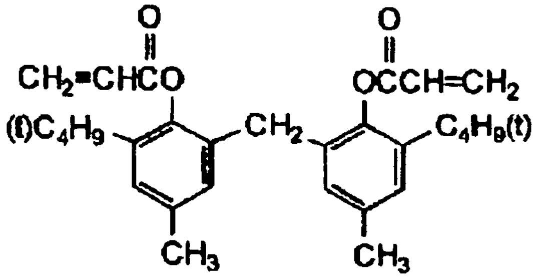

(TI-30)

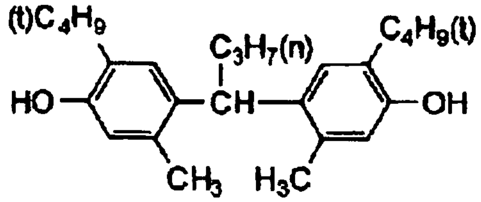

(TI-31)

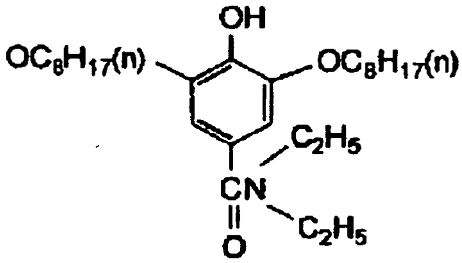

(TI-32)

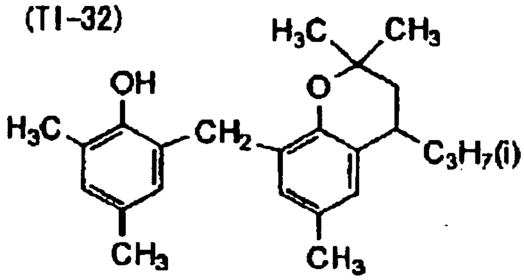

(TI-33)

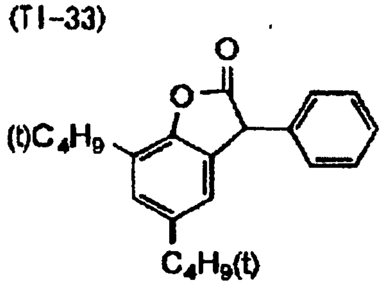

(TI-34)

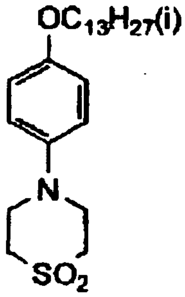

(TI-35)

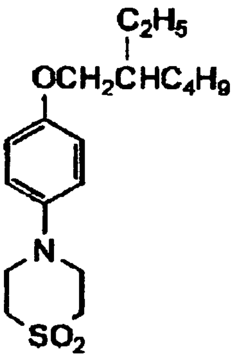

(TI-36)

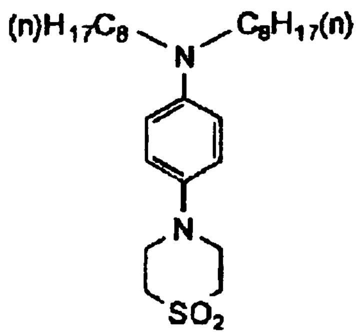

[Chemical formula 46]

(TI-37)

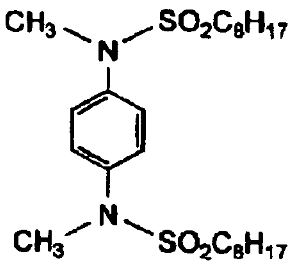

(TI-38)

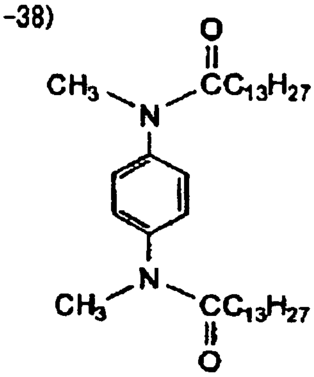

(TI-40)

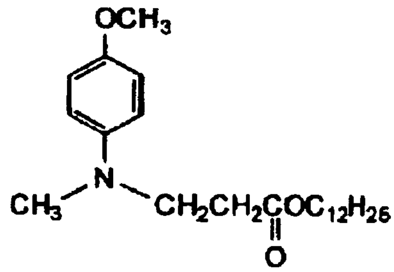

(TI-41)

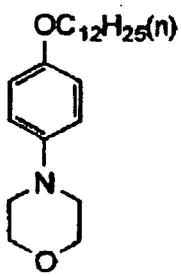

(TI-44)

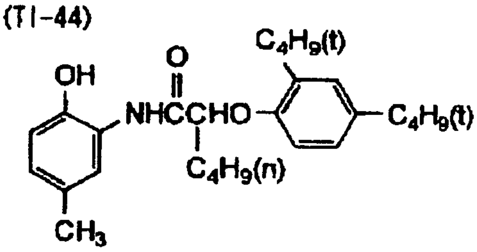

[Chemical formula 47]

(TI-47)

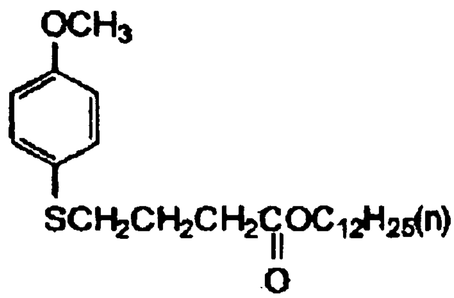

[Chemical formula 48]

(TI-48)

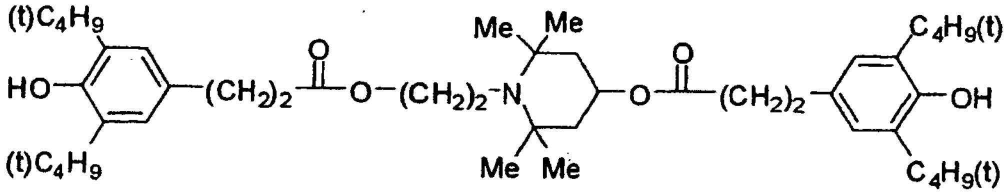

(TI-49)

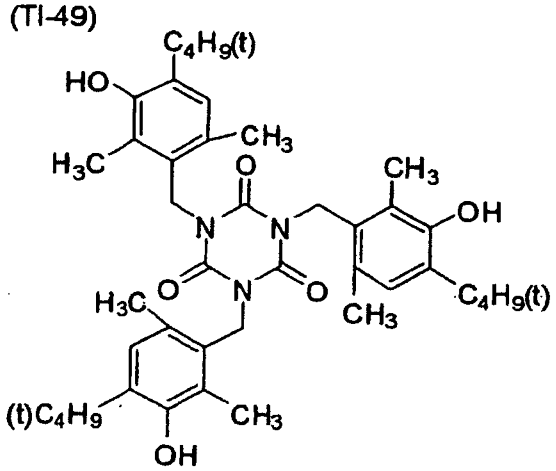

(TI-50)

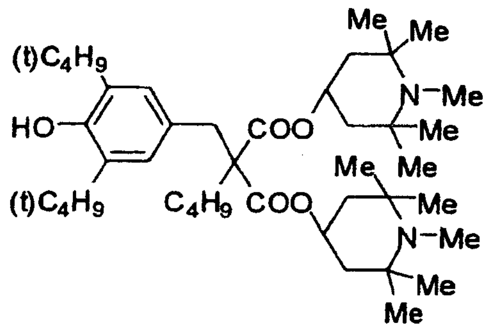

(TI-51)

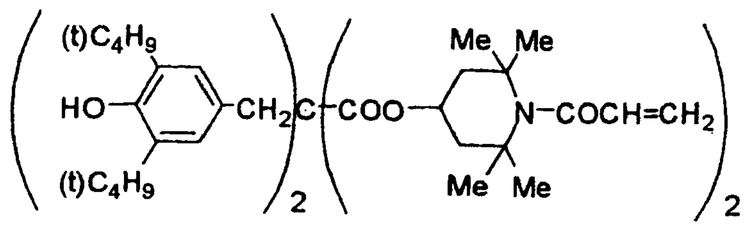

[Chemical formula 49]

(TI-52)

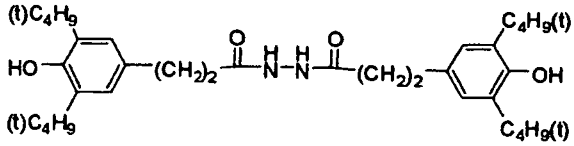

(TI-53)

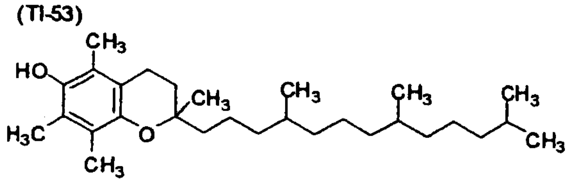

(TI-54)

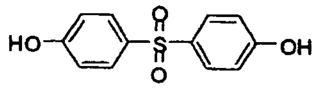

(TI-55)

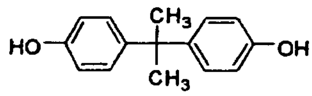

(TI-56)

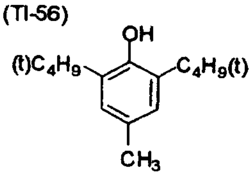

(TI-57)

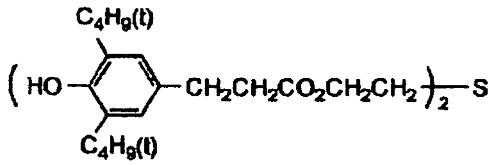

[Chemical formula 50]

(TII-1)

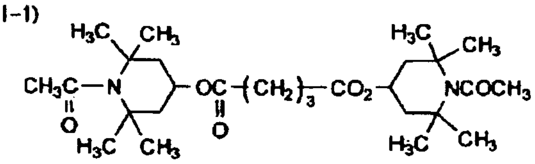

(TII-2)

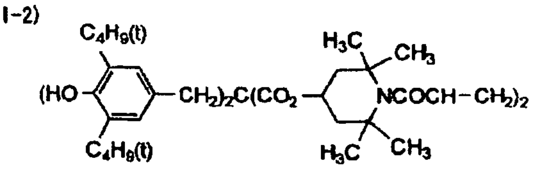

(TII-3)

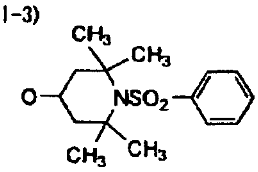

(TII-4)

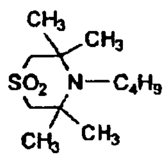

(TII-5)

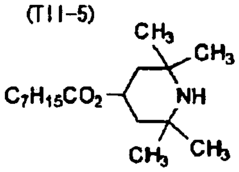

(TII-6)

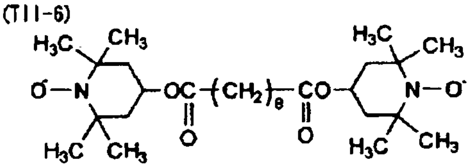

[Chemical formula 51]

(TII-7)

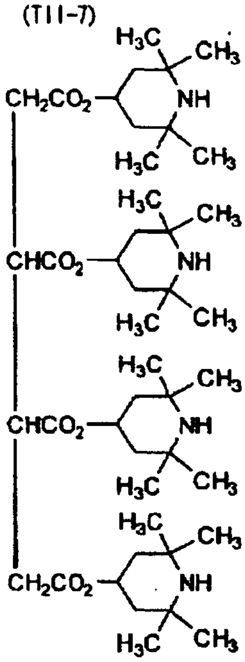

(TII-8)

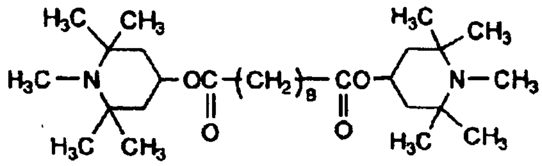

(TII-9)

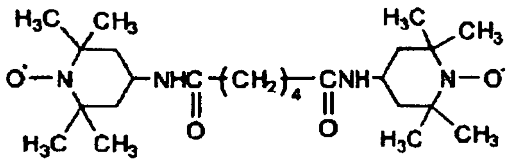

(TII-10)

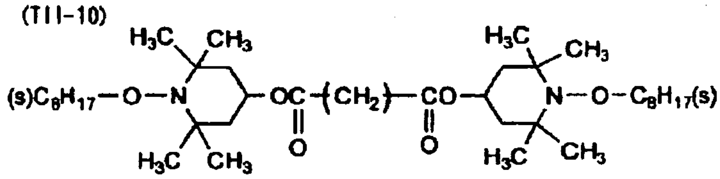

(TII-11)

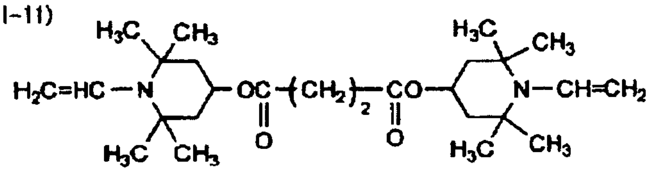

[Chemical formula 52]

(TII-12)

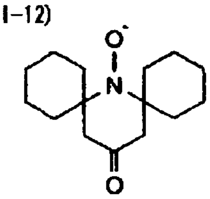

(TII-13)

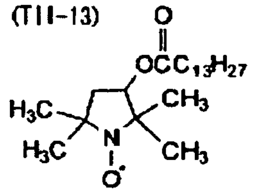

(TII-14)

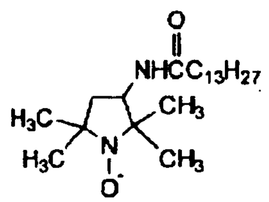

(TII-15)

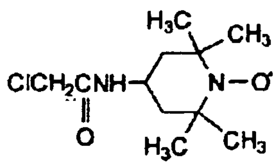

[Chemical formula 53]

(TII-16)

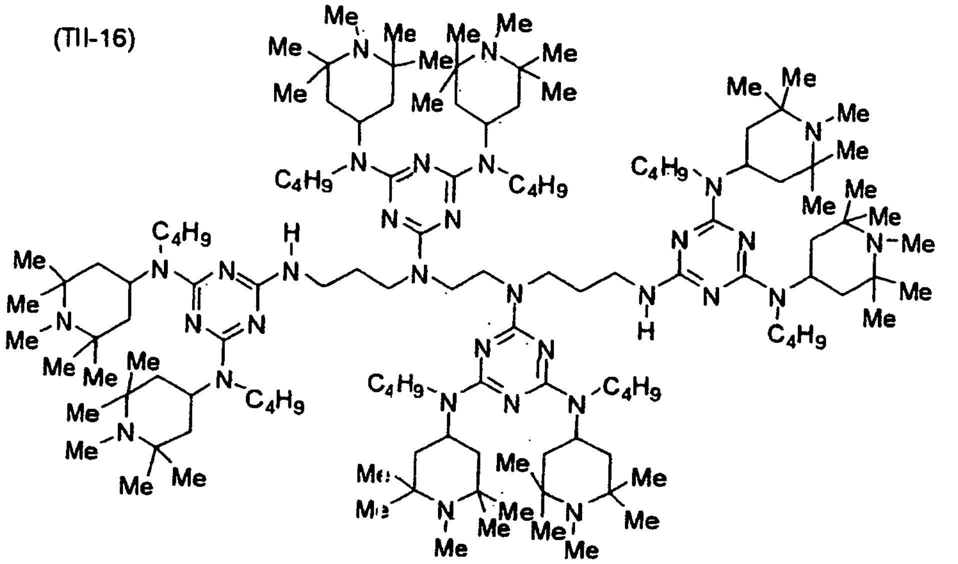

(TII-17)

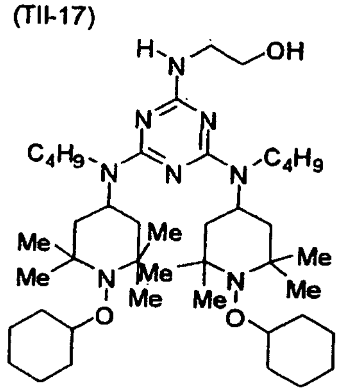

(TII-18)

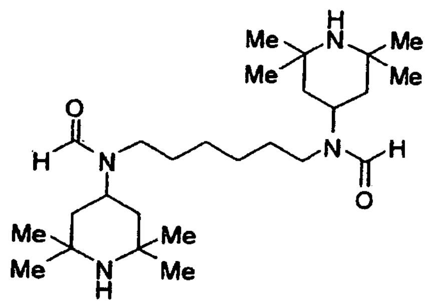

(TII-19)

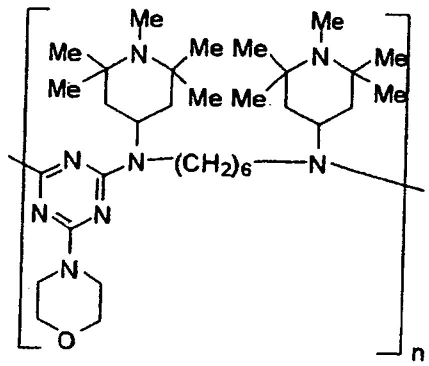

(TII-20)

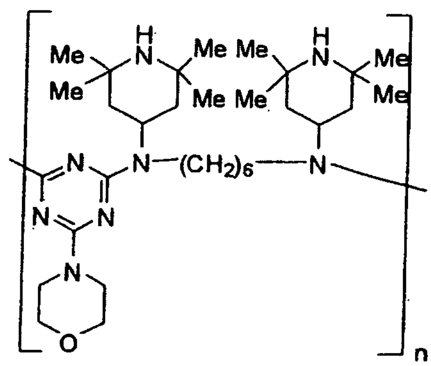

[Chemical formula 54]

(TII-21)

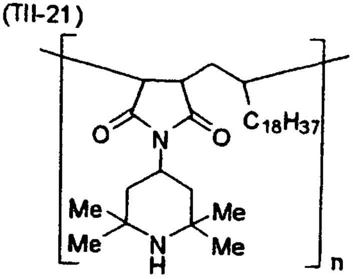

(TII-22)

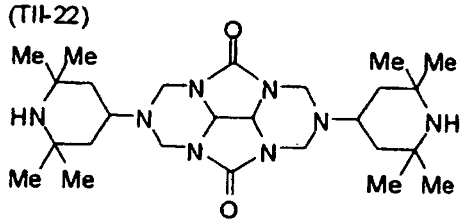

(TII-23)

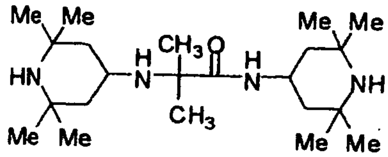

(TII-24)

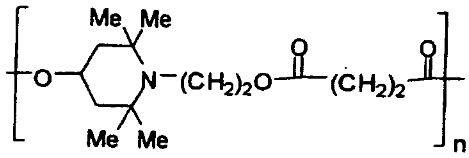

(TII-25)

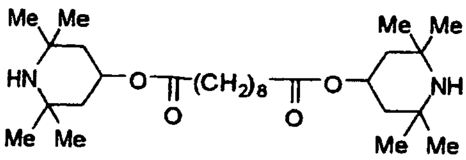

(TII-26)

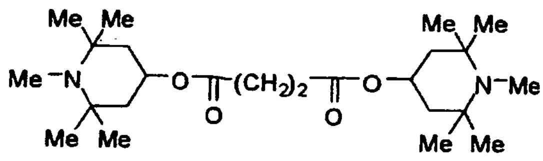

(TII-27)

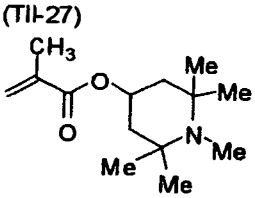

(TII-28)

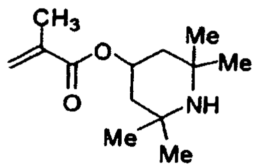

(TII-29)

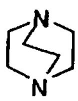

(TII-30)

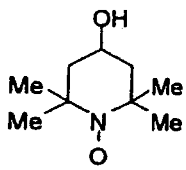

[Chemical formula 55]

(TII-31)

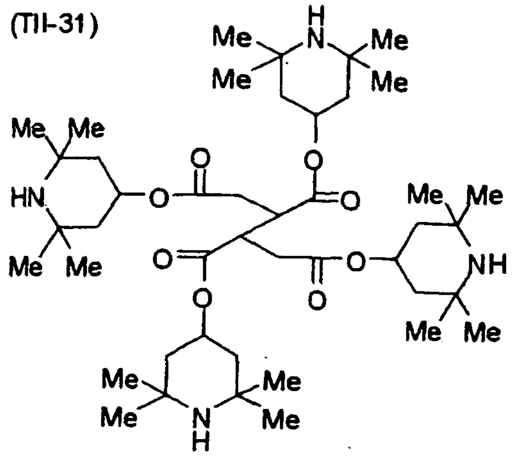

(TII-32)

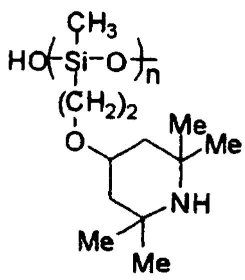

(TII-33)

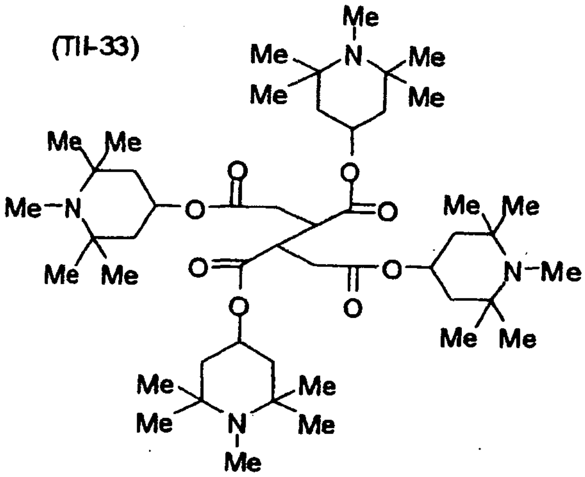

(TII-34)

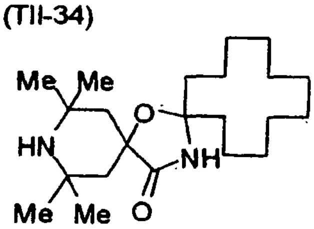

(TII-35)

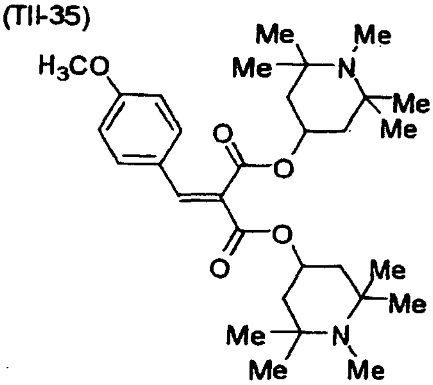

(TII-36)

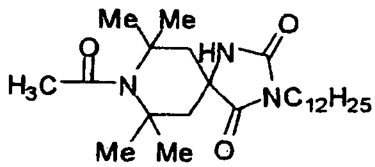

When the ultraviolet absorbent composition contains two or more compounds represented by the formula (TS-I) or (TS-II), the two or more compounds may be selected from the same family (for example, that is the case where the two compounds represented by the formula (TS-II) are used), or alternatively each of the two or more compounds may be selected from different families (for example, that is the case where one compound represented by the formula (TS-I) and another compound represented by the formula (TS-II) are used in combination). It is preferable that the two or more compounds, each of which is selected from different families, are used in combination.

In the present invention, two or more kinds of ultraviolet absorbents represented by formula (2) or (B-I) different in structure may be used in combination. Alternatively, the ultraviolet absorbent represented by formula (2) or (B-I) and one or more kinds of ultraviolet absorbents different in structure may be used in combination. Two kinds (preferably three kinds) of ultraviolet absorbents when used in combination absorb ultraviolet ray in a wider wavelength range. In addition, the use of two or more kinds of ultraviolet absorbents in combination has a function to stabilize the dispersion state. Any ultraviolet absorbent having a structure other than that of the ultraviolet absorbent represented by formula

(2) or (B-I) may be used. Examples thereof include those described, for example, in Yasuichi Okatsu Ed., "Development of Polymer Additives and Environmental Measures" (CMC Publishing, 2003), Chapter 2; and Toray Research Center Inc., Technical Survey Dept., Ed., "New Trend of Functional Polymer Additives" (Toray Research Center Inc., 1999), Chapter 2.3.1. Examples thereof include ultraviolet absorbing structures such as triazine-based, benzotriazole-based, benzophenone-based, merocyanine-based, cyanine-based, dibenzoylmethane-based, cinnamic acid-based, acrylate-based, benzoic ester-based, and oxalic diamide-based compounds. Specific examples thereof are described, for example, in Fine Chemicals, 2004, May, pp. 28 to 38; Toray Research Center Inc., Technical Survey Dept., Ed., "New Trend of Functional Polymer Additives" (Toray Research Center Inc., 1999), pp. 96 to 140; and Yasuichi Okatsu Ed., "Development of Polymer Additives and Environmental Measures" (CMC Publishing, 2003), pp. 54 to 64.

From the consideration of the latitude of the molar extinction coefficient, benzotriazole-based, benzophenone-based, salicylic acid-based, acrylate-based and triazine-based compounds are preferable. Among these compounds, benzotriazole-based, benzophenone-based and triazine-based compounds, each of which is excellent in light fastness, are more preferable. Particularly preferable are benzotriazole-based and triazine-based compounds.

The benzotriazole-based compound is preferably a compound having an effective absorption wavelength of approximately 270 to 380 nm that is represented by formula (IIa) or (IIb). The compound represented by formula (IIa) or (IIb) will be described in detail.

[Chemical formula 56]

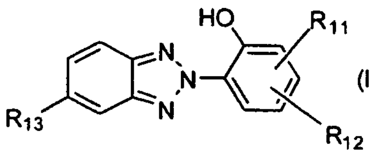
(IIa)

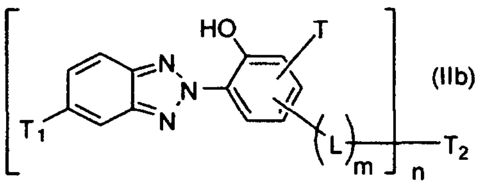
(IIb)

(In formula (IIa),

$R_{11}$ represents a hydrogen atom, a substituted or unsubstituted alkyl group, a substituted or unsubstituted cycloalkyl group, or a substituted or unsubstituted aryl group; $R_{12}$ represents a hydrogen atom, a halogen atom, a substituted or unsubstituted alkyl group, or a substituted or unsubstituted aryl group; and

$R_{13}$ represents a hydrogen atom, a halogen atom, a substituted or unsubstituted alkyl group, a substituted or unsubstituted alkoxy group, or -$COOR_{14}$ group (herein, $R_{14}$ represents a hydrogen atom, a substituted or unsubstituted alkyl group or a substituted or unsubstituted aryl group.))

(In formula (IIb),

T represents a hydrogen atom or a substituted or unsubstituted alkyl group;

$T_1$ represents a hydrogen atom, a halogen atom, a substituted or unsubstituted alkyl group, a substituted or unsubstituted aryl group, or a substituted or unsubstituted alkoxy group;

L represents a divalent linking group or a single bond;

m represents 0 or 1;

n represents an integer of 1 to 4; and

when n is 1, $T_2$ represents a halogen atom, a substituted or unsubstituted alkyl group or a substituted or unsubstituted aryl group; when n is 2, $T_2$ represents a divalent substituent; when n is 3, $T_2$ represents a trivalent substituent; and when n is 4, $T_2$ represents a tetravalent substituent.)

(Formula (IIa))

$R_{11}$ represents a hydrogen atom, a substituted or unsubstituted alkyl group, a substituted or unsubstituted cycloalkyl group or a substituted or unsubstituted aryl group.

$R_{11}$ is preferably a substituted or unsubstituted alkyl group having 1 to 18 carbon atoms, a substituted or unsubstituted cycloalkyl group having 5 to 18 carbon atoms, or a substituted or unsubstituted aryl group having 6 to 24 carbon atoms; and particularly preferably a substituted or unsubstituted alkyl group having 1 to 18 carbon atoms, or a substituted or unsubstituted alkyl group having 1 to 18 carbon atoms.

The substituted alkyl group, the substituted cycloalkyl group and the substituted aryl group each are referred to as an alkyl group, a cycloalkyl group and an aryl group, each of which has a monovalent substituent at an arbitrary position thereof, respectively. Examples of the monovalent substituent include a halogen atom (e.g., a fluorine atom, a chlorine atom, a bromine atom and an iodine atom), a straight-chain or branched alkyl group having 1 to 20 carbon atoms (preferably 1 to 10 carbon atoms) (e.g., methyl, ethyl), an aryl group having 6 to 20 carbon atoms (preferably 6 to 10 carbon atoms) (e.g., phenyl, naphthyl), a cyano group, a carboxyl group, an alkoxycarbonyl group having 1 to 20 carbon atoms (preferably 1 to 10 carbon atoms) (e.g., methoxycarbonyl), an aryloxycarbonyl group having 6 to 20 carbon

atoms (preferably 6 to 10 carbon atoms) (e.g., phenoxycarbonyl), a substituted or unsubstituted carbamoyl group having 0 to 20 carbon atoms (preferably 0 to 10 carbon atoms) (e.g., carbamoyl, N-phenylcarbamoyl, N,N-dimethylcarbamoyl), an alkylcarbonyl group having 1 to 20 carbon atoms (preferably 1 to 10 carbon atoms) (e.g., acetyl), an arylcarbonyl group having 6 to 20 carbon atoms (preferably 6 to 10 carbon atoms) (e.g., benzoyl), a nitro group, a substituted or unsubstituted amino group having 0 to 20 carbon atoms (preferably 0 to 10 carbon atoms) (e.g., amino, dimethylamino, anilino), an acylamino group having 1 to 20 carbon atoms (preferably 1 to 10 carbon atoms) (e.g., acetamido, ethoxycarbonylamino),

a sulfonamido group having 0 to 20 carbon atoms (preferably 0 to 10 carbon atoms) (e.g., methanesulfonamido), an imido group having 2 to 20 carbon atoms (preferably 2 to 10 carbon atoms) (e.g., succinimido, phthalimido), an imino group having 1 to 20 carbon atoms (preferably 1 to 10 carbon atoms) (e.g., benzylideneamino), a hydroxy group, an alkoxy group having 1 to 20 carbon atoms (preferably 1 to 10 carbon atoms) (e.g., methoxy), an aryloxy group having 6 to 20 carbon atoms (preferably 6 to 10 carbon atoms) (e.g., phenoxy), an acyloxy group having 1 to 20 carbon atoms (preferably 1 to 10 carbon atoms) (e.g., acetoxy), an alkylsulfonyloxy group having 1 to 20 carbon atoms (preferably 1 to 10 carbon atoms) (e.g., methanesulfonyloxy), an arylsulfonyloxy group having 6 to 20 carbon atoms (preferably 6 to 10 carbon atoms) (e.g., benzenesulfonyloxy), a sulfo group, a substituted or unsubstituted sulfamoyl group having 0 to 20 carbon atoms (preferably 0 to 10 carbon atoms) (e.g., sulfamoyl, N-phenylsulfamoyl), an alkylthio group having 1 to 20 carbon atoms (preferably 1 to 10 carbon atoms) (e.g., methylthio), an arylthio group having 6 to 20 carbon atoms (preferably 6 to 10 carbon atoms) (e.g., phenylthio), an alkylsulfonyl group having 1 to 20 carbon atoms (preferably 1 to 10 carbon atoms) (e.g., methansulfonyl), an arylsulfonyl group having 6 to 20 carbon atoms (preferably 6 to 10 carbon atoms) (e.g., benzenesulfonyl) and a four- to seven-membered (preferably five- to six-membered) heterocyclic group (e.g., pyridyl, morpholino).

$R_{12}$ represents a hydrogen atom, a halogen atom, a substituted or unsubstituted alkyl group or a substituted or unsubstituted aryl group. $R_{12}$ is preferably a hydrogen atom, a chlorine atom, a substituted or unsubstituted alkyl group having 1 to 18 carbon atoms, a substituted or unsubstituted cycloalkyl group having 5 to 18 carbon atoms, or a substituted or unsubstituted aryl group having 6 to 24 carbon atoms; and particularly preferably a hydrogen atom, a chlorine atom, a substituted or unsubstituted alkyl group having 1 to 18 carbon atoms, or a substituted or unsubstituted aryl group having 6 to 24 carbon atoms.

$R_{13}$ represents a hydrogen atom, a halogen atom, a substituted or unsubstituted alkyl group, a substituted or unsubstituted alkoxy group or -COOR$_{14}$ group (herein, $R_{14}$ represents a hydrogen atom, a substituted or unsubstituted alkyl group, or a substituted or unsubstituted aryl group). $R_{13}$ is preferably a hydrogen atom, a chlorine atom, a substituted or unsubstituted alkyl group having 1 to 18 carbon atoms, a substituted or unsubstituted alkoxy group having 1 to 18 carbon atoms, or -COOR$_{14}$ group (herein, $R_{14}$ represents a hydrogen atom, a substituted or unsubstituted alkyl group having 1 to 18 carbon atoms or a substituted, or unsubstituted aryl group having 6 to 24 carbon atoms).

$R_{11}$ and $R_{12}$ may be substituted at an arbitrary position of the benzene ring. The substitution at 2- or 4- position to the hydroxyl group is preferable.

(Formula (IIb))

T represents a hydrogen atom or a substituted or unsubstituted alkyl group. T is preferably a hydrogen atom or a substituted or unsubstituted alkyl group having 1 to 18 carbon atoms.

$T_1$ represents a hydrogen atom, a halogen atom, a substituted or unsubstituted alkyl group, a substituted or unsubstituted aryl group or a substituted or unsubstituted alkoxy group. $T_1$ is preferably a hydrogen atom, a chlorine atom, a substituted or unsubstituted alkyl group having 1 to 18 carbon atoms, an aryl group having 6 to 24 carbon atoms or substituted or an alkoxy group having 1 to 18 carbon atoms.

-L- represents a divalent linking group or a single bond, m represents 0 or 1.

The case where m is 0 (zero) means that $T_2$ directly bonds with the benzene ring without involving L, that is -L- represents a single bond.

The divalent linking group -L- is explained. -L- is a divalent substituent represented by formula (a).

Formula (a) $$-(L_1)_{m1}-(L_2)_{m2}-(L_3)_{m3}-(L_4)_{m4}-(L_5)_{m5}-$$

In formula (a), m1, m2, m3, m4 and m5 each represent an integer of 0 to 2.

$L_1$, $L_2$, $L_3$, $L_4$ and $L_5$ each independently represent -CO-, -O-, -SO$_2$- -SO-, -NR$_L$-, a substituted or unsubstituted divalent alkyl group, a substituted or unsubstituted divalent alkenyl group, or a substituted or unsubstituted divalent aryl group. $R_L$ represents a hydrogen atom, a substituted or unsubstituted alkyl group, or a substituted or unsubstituted aryl group.

Examples of $R_L$ include a hydrogen atom, a methyl group, an ethyl group, a propyl group, a hexyl group, an octyl group, a phenyl group, and a naphthyl group. The group may be substituted with one or more monovalent substituents at any position of the alkyl or aryl group. The monovalent substituent is, for example, the monovalent substituent described above. $R_L$ is preferably a substituted or unsubstituted alkyl group having 3 to 20 carbon atoms or a substituted or

unsubstituted aryl group having 6 to 14 carbon atoms; and more preferably a substituted or unsubstituted alkyl group having 6 to 12 carbon atoms or a substituted or unsubstituted aryl group having 6 to 10 carbon atoms.

Preferred examples of the divalent substituent -L- include $-O-CO-C_2H_4-CO-O-$, $-O-CO-C_3H_6-$, $-NH-CO-C_3H_6-CO-NH-$, $-NH-CO-C_4H_8-$, $-CH_2-$, $-C_2H_4-$, $-C_3H_6-$, $-C_4H_8-$, $-C_5H_{10}-$, $-C_8H_{16}-$, $-C_4H_8-CO-O-$, $-C_6H_4-C_6H_4-$ and $-NH-SO_2-C_3H_6-$.

In formula (IIb), n represents an integer of 1 to 4.

When n is 1, $T_2$ represents a halogen atom, a substituted or unsubstituted alkyl group or a substituted or unsubstituted aryl group. When n is 1, $T_2$ is preferably a chlorine atom, a substituted or unsubstituted alkyl group having 1 to 18 carbon atoms, or a substituted or unsubstituted aryl group having 6 to 24 carbon atoms.

When n is 2, $T_2$ represents a divalent substituent. When n is 2, examples of $T_2$ include the same examples as the above-described divalent substituent -L-. When n is 2, $T_2$ is preferably $-CH_2-$, $-O-CO-C_2H_4-CO-O-$, or $-NH-CO-C_3H_6-CO-NH-$.

When n is 3, $T_2$ represents a trivalent substituent. The trivalent substituent is explained. Specifically, the trivalent substituent is a trivalent alkyl group, a trivalent aryl group or a substituent represented by the following formula.

[Chemical formula 57]

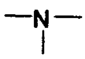

The trivalent substituent is preferably a trivalent alkyl group having 1 to 8 carbon atoms, a trivalent aryl group having 6 to 14 carbon atoms or a substituent represented by the following formula.

[Chemical formula 58]

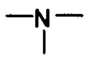

When n is 4, $T_2$ represents a tetravalent substituent. The tetravalent substituent is explained. Specifically, the tetravalent substituent is a tetravalent alkyl group or a tetravalent aryl group. Among the tetravalent substituents, a tetravalent alkyl group having 1 to 8 carbon atoms and a tetravalent aryl group having 6 to 14 carbon atoms are preferable.

In formula (IIb), it is especially preferable that n is 1 or 2.

Specifically, the components of the formula (IIb) are preferably combined as follows:

When n is 1, a preferable combination is that T is a hydrogen atom, or a substituted or unsubstituted alkyl group having 1 to 18 carbon atoms; $T_1$ is a hydrogen atom, a chlorine atom, a substituted or unsubstituted alkyl group having 1 to 18 carbon atoms, a substituted or unsubstituted aryl group having 6 to 24 carbon atoms, or an alkoxy group having 1 to 18 carbon atoms; L is $-O-CO-C_3H_6-$, $-CH_2-$, $-C_3H_6-$, $-C_5H_{10}-$, $-C_8H_{16}-$, $-NH-CO-C_4H_8-$ or a single bond; and $T_2$ is a chlorine atom, a substituted or unsubstituted alkyl group having 1 to 18 carbon atoms, or a substituted or unsubstituted aryl group having 6 to 24 carbon atoms.

When n is 2, a preferable combination is that T is a hydrogen atom, or a substituted or unsubstituted alkyl group having 1 to 18 carbon atoms; $T_1$ is a hydrogen atom, a chlorine atom, a substituted or unsubstituted alkyl group having 1 to 18 carbon atoms, an aryl group having 6 to 24 carbon atoms, or an alkoxy group having 1 to 18 carbon atoms; L is $-CH_2-$ or a single bond; and $T_2$ is $-CH_2-$, $-O-CO-C_2H_4-CO-O-$ or $NH-CO-C_3H_6-CO-NH-$.

Further, when n is 2, a preferable another combination is that m is 0; T is a hydrogen atom, or a substituted or unsubstituted alkyl group having 1 to 18 carbon atoms; $T_1$ is a hydrogen atom, a chlorine atom, a substituted or unsubstituted alkyl group having 1 to 18 carbon atoms, an aryl group having 6 to 24 carbon atoms, or an alkoxy group having 1 to 18 carbon atoms; and $T_2$ is $-CH_2-$, $-O-CO-C_2H_4-CO-O-$, or $-NH-CO-C_3H_6-CO-NH-$.

Typical examples of the compound represented by formula (IIa) or (IIb) include 2-(2'-hydroxy-5'-methylphenyl)benzotriazole, 2-(2'-hydroxy-5'-t-butylphenyl)benzotriazole, 2-(2'-hydroxy-3'-t-butyl-5'-methylphenyl)-5-chlorobenzotriazole, 2-(2'-hydroxy-3',5'-di-t-butylphenyl)-5-chlorobenzotriazole, 2-(2'-hydroxy-3'-dodecyl-5'-methylphenyl)-5-chlorobenzotriazole, 2-(2'-hydroxy-3',5'-di-t-amylphenyl)benzotriazole, 2-(2'-hydroxy-5'-(1,1,3,3-tetramethylbutyl)phenyl)benzotriazole, 2-(2'-hydroxy-4'-octyloxyphenyl)benzotriazole, 2-(2'-hydroxy-3'-(3,4,5,6-tetrahydrophthalimidylmethyl)-5'-methylbenzyl)phenyl)benzotriazole, 2-(3'-sec-butyl-5'-t-butyl-2'-hydroxyphenyl)benzotriazole, 2-(3',5'-bis-($\alpha$,$\alpha$-

dimethylbenzyl)-2'-hydroxyphenyl)benzotriazole, 2-(3'-t-butyl-2'-hydroxy-5'-(2-octyloxycarbonylethyl)phenyl)-5-chloro-benzotriazole, 2-(3'-t-butyl-5'-[2-(2-ethylhexyloxy)-carbonylethyl]-2'-hydroxyphenyl)-5-chloro-benzotriazole, 2-(3'-t-butyl-2'-hydroxy-5'-(2-methoxycarbonylethyl)phenyl)-5-chloro-benzotriazole, 2-(3'-t-butyl-2'-hydroxy-5'-(2-methoxycarbonylethyl)phenyl)benzotriazole, 2-(3'-t-butyl-2'-hydroxy-5'-(2-octyloxycarbonylethyl)phenyl)benzotriazole, 2-(3'-t-butyl-5'-[2-(2-ethylhexyloxy)carbonylethyl]-2'-hydroxyphenyl)benzotriazole, 2-(3'-dodecyl-2'-hydroxy-5'-methylphenyl)benzotriazole, 2-(3'-t-butyl-2'-hydroxy-5'-(2-isooctyloxycarbonylethyl)phenylbenzotriazole, 2,2'-methylene-bis[4-(1,1,3,3-tetramethylbutyl)-6-benzotriazole-2-ylphenol], ester exchange products of 2-[3'-t-butyl-5'-(2-methoxycarbonylethyl)-2'-hydroxyphenyl]-2H-benzotriazole and polyethylene glycol 300; and the compound represented by the following formula:

[Chemical formula 59]

$$\left[R-CH_2CH_2-COO-CH_2CH_2-\right]_2$$

(wherein, R represents 3'-tert-butyl-4'-hydroxy-5'-2H-benzotriazol-2-ylphenyl, 2-[2'-hydroxy-3'-($\alpha$,$\alpha$-dimethylbenzyl)-5'-(1,1,3,3-tetramethylbutyl)-phenyl]benzotriazole; 2-[2'-hydroxy-3'-(1,1,3,3-tetramethylbutyl)-5'-($\alpha$,$\alpha$-dimethylbenzyl)-phenyl]benzotriazole or the like).

The triazine-based compound is preferably a compound having an effective absorption wavelength of approximately 270 to 380 nm that is represented by formula (III).

[Chemical formula 60]

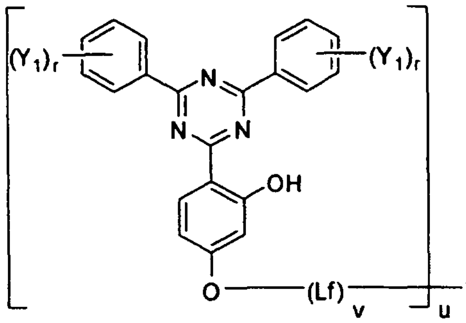

(III)

(In formula (III),

the substituent $Y_1$'s each independently represent a hydrogen atom, a hydroxyl group, a substituted or unsubstituted alkyl group, a substituted or unsubstituted aryl group, or a substituted or unsubstituted alkoxy group;

Lf represents a divalent linking group or a single bond;

u represents 1 or 2;

v represents 0 or 1;

r represents an integer of 1 to 3; and

when u is 1, $Y_2$ represents a hydrogen atom, a substituted or unsubstituted alkyl group, or a substituted or unsubstituted aryl group; and when u is 2, $Y_2$ represents a divalent substituent.

$Y_1$'s each independently represent a hydrogen atom, a hydroxyl group, a substituted or unsubstituted alkyl group, a substituted or unsubstituted aryl group, or a substituted or unsubstituted alkoxy group. $Y_1$ is preferably a hydrogen atom, a hydroxyl group, a substituted or unsubstituted alkyl group having 1 to 18 carbon atoms, a substituted or unsubstituted aryl group having 6 to 24 carbon atoms, or a substituted or unsubstituted alkoxy group having 1 to 18 carbon atoms.

Lf represents a divalent linking group or a single bond u represents 1 or 2. r represents an integer of 1 to 3. v represents 0 or 1. When v is 0, Lf represents a single bond.

The divalent linking group -Lf- is explained. The divalent linking group -Lf- is a divalent substituent represented by formula (b).

Formula (b) $-(Lf_1)_{mf1}-(Lf_2)_{mf2}-(Lf_3)_{mf3}-(Lf_4)_{mf4}-(Lf_5)_{mf5}-$

In formula (b), mf1 to mf5 each represent an integer of 0 to 2.

$Lf_1$, $Lf_2$, $Lf_3$, $Lf_4$ and $Lf_5$ each independently represent -CO-, -O-, $-SO_2-$ -SO-, $-NRf_L-$, a substituted or unsubstituted divalent alkyl group, a substituted or unsubstituted divalent alkenyl group, or a substituted or unsubstituted divalent aryl group. $Rf_L$ represents a hydrogen atom, a substituted or unsubstituted alkyl group, or a substituted or unsubstituted aryl group.

Examples of $Rf_L$ include a hydrogen atom, a methyl group, an ethyl group, a propyl group, a hexyl group, an octyl group, a phenyl group, and a naphthyl group. The group may be substituted with one or more monovalent substituents at any position of the alkyl or aryl groups. The monovalent substituent is, for example, the monovalent substituent described above. $Rf_L$ is preferably a substituted or unsubstituted alkyl group having 3 to 20 carbon atoms or a substituted or unsubstituted aryl group having 6 to 14 carbon atoms; and more preferably a substituted or unsubstituted alkyl group having 6 to 12 carbon atoms or a substituted or unsubstituted aryl group having 6 to 10 carbon atoms.

Preferred examples of the divalent substituent -Lf- include $-O-CO-C_2H_4-CO-O-$, $-O-CO-C_3H_6-$, $-NH-CO-C_3H_6-CO-NH-$, $-NH-CO-C_4H_8-$, $-CH_2-$, $-C_2H_4-$, $-C_3H_6-$, $-C_4H_8-$, $-C_5H_{10}-$, $-C_8H_{16}-$, $-C_4H_8-CO-O-$, $-C_6H_4-C_6H_4-$ and $-NH-SO_2-C_3H_6-$.

When u is 1, $Y_2$ represents a hydrogen atom, a substituted or unsubstituted alkyl group, or a substituted or unsubstituted aryl group. When u is 1, $Y_2$ is preferably a hydrogen atom, a substituted or unsubstituted alkyl group having 1 to 18 carbon atoms, or a substituted or unsubstituted aryl group having 6 to 24 carbon atoms.

When u is 2, $Y^2$ represents a divalent substituent. Examples of the divalent substituent include the same examples as the aforementioned divalent substituent -L-. $Y_2$ is preferably a substituted or unsubstituted divalent alkyl group, a substituted or unsubstituted divalent alkenyl group, a substituted or unsubstituted divalent aryl group, $-CH_2CH(OH)CH_2-O-Y_{11}-OCH_2CH(OH)CH_2$, $-CO-Y_{12}-CO-$, $-CO-NH-Y_{13}-NH-CO-$, or $-(CH_2)_t-CO_2-Y_{14}-OCO-(CH_2)_t$.

Herein, t is 1, 2 or 3;

$Y_{11}$ represents a substituted or unsubstituted alkylene group, phenylene group, or -phenylene-M-phenylene- (wherein, M represents -O-, -S-, $-SO_2-$, $-CH_2-$ or $-C(CH_3)_2-$);

$Y_{12}$ represents a substituted or unsubstituted divalent alkyl group, a substituted or unsubstituted divalent alkenyl group, or a substituted or unsubstituted divalent aryl group;

$Y_{13}$ represents a substituted or unsubstituted divalent alkyl group, or a substituted or unsubstituted divalent aryl group; and

$Y_{14}$ represents a substituted or unsubstituted divalent alkyl group, or a substituted or unsubstituted divalent aryl group.

That is, when u is 2, $Y_2$ is preferably a substituted or unsubstituted divalent alkyl group having 1 to 18 carbon atoms, a substituted or unsubstituted divalent aryl group having 6 to 24 carbon atoms, $-CH_2CH(OH)CH_2-O-CH_2-OCH_2CH(OH)CH_2-$, $-CH_2CH(OH)CH_2-O-C(CH_3)_2-OC_8H_{16}-$, or $-(CH_2)_2-CO_2-C_2H_4-OCO-(CH_2)_2-$.

Typical examples of the compound represented by formula (III) include 2-(4-butoxy-2-hydroxyphenyl)-4,6-di(4-butoxyphenyl)-1,3,5-triazine, 2-(4-butoxy-2-hydroxyphenyl)-4,6-di(2,4-dibutoxyphenyl)-1,3,5-triazine, 2,4-di(4-butoxy-2-hydroxyphenyl)-6-(4-butoxyphenyl)-1,3,5-triazine, 2,4-di(4-butoxy-2-hydroxyphenyl)-6-(2,4-dibutoxyphenyl)-1,3,5-triazine, 2,4,6-tris(2-hydroxy-4-octyloxyphenyl)-1,3,5-triazine, 2-(2-hydroxy-4-octyloxyphenyl)-4,6-bis(2,4-dimethylphenyl)-1,3,5-triazine, 2-(2,4-dihydroxyphenyl)-4,6-bis(2,4-dimethylphenyl)-1,3,5-triazine, 2,4-bis(2-hydroxy-4-propyloxyphenyl)-6-(2,4-dimethylphenyl)-1,3,5-triazine, 2-(2-hydroxy-4-octyloxyphenyl)-4,6-bis(4-methylphenyl)-1,3,5-triazine, 2-(2-hydroxy-4-dodecyloxyphenyl)-4,6-bis(2,4-dimethylphenyl)-1,3,5-triazine, 2-(2-hydroxy-4-tridecyloxyphenyl)-4,6-bis(2,4-dimethylphenyl)-1,3,5-triazine, 2-[2-hydroxy-4-(2-hydroxy-3-butyloxypropoxy)phenyl]-4,6-bis(2,4-dimethyl)-1,3,5-triazine, 2-[2-hydroxy-4-(2-hydroxy-3-octyloxypropyloxy)phenyl]-4,6-bis(2,4-dimethyl)-1,3,5-triazine, 2-[4-(dodecyloxy/tridecyloxy-2-hydroxypropoxy)-2-hydroxyphenyl]-4,6-bis(2,4-dimethylphenyl)-1,3,5-triazine, 2-[2-hydroxy-4-(2-hydroxy-3-dodecyloxypropoxy)phenyl]-4,6-bis(2,4-dimethylphenyl)-1,3,5-triazine, 2-(2-hydroxy-4-hexyloxy)phenyl-4,6-diphenyl-1,3,5-triazine, 2-(2-hydroxy-4-methoxyphenyl)-4,6-diphenyl-1,3,5-triazine, 2,4,6-tris(2-hydroxy-4-(3-butoxy-2-hydroxypropoxy)phenyl)-1,3,5-triazine, 2-(2-hydroxyphenyl)-4-(4-methoxyphenyl)-6-phenyl-1,3,5-triazine, 2-{2-hydroxy-4-[3-(2-ethylhexyl-1-oxy)-2-hydroxy-propyloxy]phenyl}-4,6-bis(2,4-dimethylphenyl)-1,3,5-triazine and 2-(2-hydroxy-4-(2-ethylhexyl)oxy)phenyl-4,6-di(4-phenyl)phenyl-1,3,5-triazine.

The benzophenone-based compound is preferably a compound having an effective absorption wavelength of approximately 270 to 380 nm that is represented by formula (IVa) or (IVb).

[Chemical formula 61]

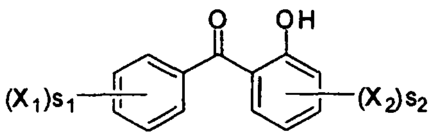

(IVa)

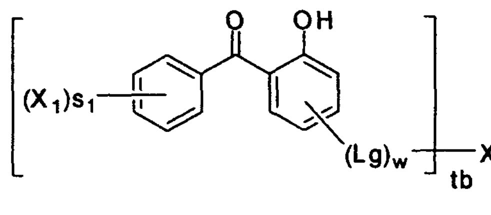

(IVb)

(In formula (IVa), $X_1$ and $X_2$ each independently represent a hydrogen atom, a halogen atom, a hydroxyl group, a substituted or unsubstituted alkyl group, a substituted or unsubstituted phenyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group or a substituted or unsubstituted amino group; and s1 and s2 each independently represent an integer of 1 to 3.)

(In formula (IVb), $X_1$ represents a hydrogen atom, a halogen atom, a hydroxyl group, a substituted or unsubstituted alkyl group, a substituted or unsubstituted phenyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group, or a substituted or unsubstituted amino group; s1 represents an integer of 1 to 3;

Lg represents a divalent substituent or a single bond; w represents 0 or 1;

tb represents 1 or 2; and when tb is 1, $X_3$ represents a hydrogen atom, a halogen atom, a hydroxyl group, a substituted or unsubstituted alkyl group, a substituted or unsubstituted phenyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group, or a substituted or unsubstituted amino group; and when tb is 2, $X_3$ represents a divalent substituent.

(Formula (IVa))

$X_1$ and $X_2$ each independently represent a hydrogen atom, a halogen atom, a hydroxyl group, a substituted or unsubstituted alkyl group, a substituted or unsubstituted phenyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group, or a substituted or unsubstituted amino group. $X_1$ and $X_2$ each are preferably a hydrogen atom, a chlorine atom, a hydroxyl group, a substituted or unsubstituted alkyl group having 1 to 18 carbon atoms, a substituted or unsubstituted aryl group having 6 to 24 carbon atoms, a substituted or unsubstituted alkoxy group having 1 to 18 carbon atoms, an alkyloxycarbonyl group having 2 to 18 carbon atoms, an aryloxycarbonyl group having 7 to 24 carbon atoms, a sulfonic acid group or a substituted or unsubstituted amino group having 1 to 16 carbon atoms; and particularly preferably a hydrogen atom, a hydroxyl group, a substituted or unsubstituted alkoxy group having 1 to 18 carbon atoms, a sulfonic acid group or a substituted or unsubstituted amino group having 1 to 16 carbon atoms.

(Formula (IVb))

tb is 1 or 2, w is 0 or 1, and s1 is an integer of 1 to 3.

The substituent $X_1$ represents a hydrogen atom, a halogen atom, a hydroxyl group, a substituted or unsubstituted alkyl group, a substituted or unsubstituted phenyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group, or a substituted or unsubstituted amino group.

$X_1$ is preferably a hydrogen atom, a chlorine atom, a hydroxyl group, a substituted or unsubstituted alkyl group having 1 to 18 carbon atoms, a substituted or unsubstituted aryl group having 6 to 24 carbon atoms, a substituted or unsubstituted alkoxy group having 1 to 18 carbon atoms, a substituted or unsubstituted alkyloxycarbonyl group having 2 to 18 carbon atoms, an aryloxycarbonyl group having 7 to 24 carbon atoms, a sulfonic acid group or a substituted or unsubstituted amino group having 1 to 16 carbon atoms; and particularly preferably a hydrogen atom, a hydroxyl group, a substituted or unsubstituted alkoxy group having 1 to 18 carbon atoms, a sulfonic acid group or a substituted, or unsubstituted amino group having 1 to 16 carbon atoms.

-Lg- represents a divalent linking group or a single bond. w represents an integer of 0 or 1. The case where w is 0 (zero) means that $X_3$ directly bonds with the benzene ring without involving Lg, that is, -Lg- represents a single bond.

The divalent linking group -Lg- is explained. The divalent linking group Lg is a divalent substituent represented by formula (c).

Formula (c) $-(Lg_1)_{mg1}-(Lg_2)_{mg2}-(Lg_3)_{mg3}-(Lg_4)_{mg4}-(Lg_5)_{mg5}-$

In formula (c), mg1, mg2, mg3, mg4 and mg5 each represent an integer of 0 to 2.

$Lg_1$, $Lg_2$, $Lg_3$, $Lg_4$ and $Lg_5$ each independently represent -CO-, -O-, $-SO_2-$, -SO-, $-NRg_L-$, a substituted or unsubstituted divalent alkyl group, a substituted or unsubstituted divalent alkenyl group, or a substituted or unsubstituted divalent aryl group. $Rg_L$ represents a hydrogen atom, a substituted or unsubstituted alkyl group or a substituted or unsubstituted aryl group.

Examples of $Rg_L$ include a hydrogen atom, a methyl group, an ethyl group, a propyl group, a hexyl group, an octyl group, a phenyl group and a naphthyl group. The group may be substituted with one or more monovalent substituents at any position of the alkyl or aryl groups. The monovalent substituent is, for example, the monovalent substituent described above. $Rg_L$ is preferably a substituted or unsubstituted alkyl group having 3 to 20 carbon atoms, or a substituted

or unsubstituted aryl group having 6 to 14 carbon atoms; and more preferably a substituted or unsubstituted alkyl group having 6 to 12 carbon atoms, or a substituted or unsubstituted aryl group having 6 to 10 carbon atoms.

That is, preferred examples of the divalent substituent -Lg- include -O-, $-O-CO-C_2H_4-CO-O-$, $-O-C_4H_8-O-$, $-O-CO-C_3H_6-$, $-NH-CO-C_3H_6-CO-NH-$, $-NH-CO-C_4H_8-$, $-CH_2-$, $-C_2H_4-$, $-C_3H_6-$, $-C_4H_8-$, $-C_5H_{10}-$, $-C_8H_{16}-$, $-C_4H_8-CO-O-$, $-C_6H_4-C_6H_4-$, and $-NH-SO_2-C_3H_6-$.

When tb is 1, $X_3$ represents a hydrogen atom, a halogen atom, a hydroxyl group, a substituted or unsubstituted phenyl group, a substituted or unsubstituted alkyl group, a substituted or unsubstituted alkoxy group, a substituted or unsubstituted alkylsulfonyl group, a substituted or unsubstituted arylsulfonyl group, a sulfonic acid group, a substituted or unsubstituted alkyloxycarbonyl group, a substituted or unsubstituted aryloxycarbonyl group or a substituted or unsubstituted amino group.

When tb is 1, $X_3$ is preferably a hydrogen atom, a hydroxyl group, a chlorine atom, a substituted or unsubstituted alkyl group having 1 to 18 carbon atoms, a substituted or unsubstituted aryl group having 6 to 24 carbon atoms, a substituted or unsubstituted alkoxy group having 1 to 18 carbon atoms, a substituted or unsubstituted alkyloxycarbonyl group having 2 to 18 carbon atoms, an aryloxycarbonyl group having 7 to 24 carbon atoms, a sulfonic acid group, or a substituted or unsubstituted amino group having 1 to 16 carbon atoms.

$X_3$ is particularly preferably a hydrogen atom, a hydroxyl group, a substituted or unsubstituted alkoxy group having 1 to 18 carbon atoms, a sulfonic acid group, or a substituted or unsubstituted amino group having 1 to 16 carbon atoms.

When tb is 2, $X_3$ represents a divalent substituent.

When tb is 2, examples of $X_3$ include the same examples as the above-described divalent substituent -L-. When tb is 2, $X_3$ is preferably $-CH_2-$, $-C_4H_8-$, $-O-C_4H_8-O-$, $-O-CO-C_2H_4-CO-O-$, or $-NH-CO-C_3H_6-CO-NH-$.

In formula (IVb), tb is particularly preferably 1.

That is, the component of formula (IVb) is preferable combined as follows.

Specifically, when tb is 1, a preferable combination is that $X_1$ is a hydrogen atom, a hydroxyl group, a substituted or unsubstituted alkoxy group having 1 to 18 carbon atoms, a sulfonic acid group, or a substituted or unsubstituted amino group having 1 to 16 carbon atoms;

Lg is -O-, $-O-CO-C_2H_4-CO-O-$, $-O-C_4H_8-O-$, $-O-CO-C_3H_6-$, $-NH-CO-C_3H_6-CO-NH-$, $-NH-CO-C_4H_8-$, $-CH_2-$, $-C_2H_4-$, $-C_3H_6-$, $-C_4H_8-$, $-C_5H_{10}-$, $-C_8H_{16}-$, $-C_4H_8-CO-O-$, $-C_6H_4-C_6H_4-$, $-NH-SO_2-C_3H_6-$, or a single bond; and

$X_3$ is a hydrogen atom, a hydroxyl group, a chlorine atom, a substituted or unsubstituted alkyl group having 1 to 18 carbon atoms, a substituted or unsubstituted aryl group having 6 to 24 carbon atoms, a substituted or unsubstituted alkoxy group having 1 to 18 carbon atoms, a substituted or unsubstituted alkyloxycarbonyl group having 2 to 18 carbon atoms, an aryloxycarbonyl group having 7 to 24 carbon atoms, a sulfonic acid group, or a substituted or unsubstituted amino group having 1 to 16 carbon atoms.

When tb is 2, a preferable combination is that

$X_1$ is a hydrogen atom, a hydroxyl group, a substituted or unsubstituted alkoxy group having 1 to 18 carbon atoms, a sulfonic acid group, or a substituted or unsubstituted amino group having 1 to 16 carbon atoms;

Lg is -O-, $-O-CO-C_2H_4-CO-O$ $-O-C_4H_8-O-$, $-O-CO-C_3H_6-$, $-NH-CO-C_3H_6-CO-NH-$, $-NH-CO-C_4H_8-$, $-CH_2-$, $-C_2H_4-$, $-C_3H_6-$, $-C_4H_8-$, $-C_5H_{10}-$, $-C_8H_{16}-$, $-C_4H_8-CO-O-$, $-C_6H_4-C_6H_4-$, $-NH-SO_2-C_3H_6-$, or a single bond; and

$X_3$ is $-CH_2-$, $-C_4H_8-$, $-O-C_4H_8-O-$, $-O-CO-C_2H_4-CO-O-$, or $-NH-CO-C_3H_6-CO-NH-$.

Typical examples of the benzophenone-based compound include 2,4-dihydroxybenzophenone, 2-hydroxy-4-methoxybenzophenone, 2-hydroxy-4-octyloxybenzophenone, 2-hydroxy-4-decyloxybenzophenone, 2-hydroxy-4-dodecyloxybenzophenone, 2-hydroxy-4-benzyloxybenzophenone, 2-hydroxy-4-(2-hydroxy-3-methacryloxypropoxy)benzophenone, 2-hydroxy-4-methoxy-5-sulfobenzophenone, 2-hydroxy-4-methoxy-5-sulfobenzophenone trihydrate, 2-hydroxy-4-methoxy-2'-carboxybenzophenone, 2-hydroxy-4-octadecyloxybenzophenone, 2-hydroxy-4-diethylamino-2'-hexyloxycarbonylbenzophenone, 2,2'-dihydroxy-4-methoxybenzophenone, 2,2',4,4'-tetrahydroxybenzophenone, 2,2'-dihydroxy-4,4'-dimethoxybenzophenone, and 1,4-bis(4-benzyloxy-3-hydroxyphenoxy)butane.

The salicylic acid-based compound above is preferably a compound having an effective absorption wavelength of approximately 290 to 330 nm, and typical examples thereof include phenyl salicylate, 4-t-butylphenyl salicylate, 4-octylphenyl salicylate, dibenzoylresorcinol, bis(4-t-butylbenzoyl)resorcinol, benzoylresorcinol, 2,4-di-t-butylphenyl 3,5-di-t-butyl-4-hydroxysalicylate, and hexadecyl 3,5-di-t-butyl-4-hydroxysalicylate.

The acrylate-based compound above is preferably a compound having an effective absorption wavelength of approximately 270 to 350 nm, and typical examples thereof include 2-ethylhexyl 2-cyano-3,3-diphenylacrylate, ethyl 2-cyano-3,3-diphenylacrylate, isooctyl 2-cyano-3,3-diphenylacrylate, hexadecyl 2-cyano-3-(4-methylphenyl)acrylate, methyl 2-cyano-3-methyl-3-(4-methoxyphenyl)cinnamate, butyl 2-cyano-3-methyl-3-(4-methoxyphenyl)cinnamate, methyl 2-carbomethoxy-3-(4-methoxyphenyl)cinnamate 2-cyano-3-(4-methylphenyl)acrylate salt, 1,3-bis(2'-cyano-3,3'-diphenylacryloyl)oxy)-2,2-bis(((2'-cyano-3,3'-diphenylacryloyl)oxy)methyl)propane, and N-(2-carbomethoxy-2-cyanovinyl)-2-methylindoline.

The oxalic diamide-based compound above is preferably a compound having an effective absorption wavelength

of approximately 250 to 350 nm, and typical examples thereof include 4,4'-dioctyloxyoxanilide, 2,2'-dioctyloxy-5,5'-di-t-butyloxanilide, 2,2'-didodecyloxy-5,5'-di-t-butyloxanilide, 2-ethoxy-2'-ethyloxanilide, N,N'-bis(3-dimethylaminopropyl)oxamide, 2-ethoxy-5-t-butyl-2'-ethyloxanilide, and 2-ethoxy-2'-ethyl-5,4'-di-t-butyloxanilide.

A mixing ratio of the ultraviolet absorbent represented by the above-described formula (2) or (B-1) and the compound represented by the above-described formula (TS-I) or (TS-II) used in the present invention is 1:4 to 4:1, more preferably 1:3 to 3:1, and furthermore preferably 1:2 to 2:1. These compounds may be arbitrarily mixed at the above-described mixing ratio. In the preferable embodiments described above, improvement of compatibility with a polymer has been observed.

The total content of the ultraviolet absorbent represented by the formula (2) or (B-I) is preferably more than 0% by mass and 80% by mass or less, more preferably 10% by mass or more and 60% by mass or less, and furthermore preferably 30% by mass or more and 50% by mass or less, of the ultraviolet absorbent composition in all respectively.

The total content of the compound represented by the formula (TS-I) or (TS-II) is preferably more than 0% by mass and 80% by mass or less, more preferably 30% by mass or more and 70% by mass or less, and furthermore preferably 40% by mass or more and 60% by mass or less, of the ultraviolet absorbent composition in all respectively.

The total content of the ultraviolet absorbent composition of the present invention to the polymer material is preferably more than 0% by mass and 50% by mass or less, more preferably 0% by mass or more and 40% by mass or less, and furthermore preferably 0% by mass or more and 30% by mass or less. The ultraviolet absorbent composition of the present invention has such an excellent property that bleed out is not observed in the case where the composition is used at a low concentration of more than 0% by mass and less than 10% by mass, as well as in the case where the composition is used at a high concentration of 10% by mass or more.

As a combination of the formula (2) or (B-1), and the formula (TS-I) or (TS-II), a combination of the formula (3) and the formula (TS-II), or a combination of the formula (B-1 a) and the formula (TS-II) is preferable. Especially, a combination of the formula (4) and the formula (TS-IIa), or a combination of the formula (B-1a) and the formula (TS-IIa) is preferable. In the preferable combinations described above, improvement of both compatibility with a polymer and solubility in a solvent has been observed.

The ultraviolet absorbent represented by the formula (2) or (B-1) and the compound represented by the formula (TS-I) or (TS-II) used in the present invention may be individually present, or may be connected to each other previously or by binding together with each other in a composition. Further, a polymerizable group may be bound with each of the ultraviolet absorbent represented by the formula (2) or (B-1) and the compound represented by the formula (TS-I) or (TS-II) to form a polymerizable monomer respectively, followed by polymerization of these monomers to form a copolymer including these monomers as a unit structure. Alternatively, these compounds may be used together with other monomers free of these compounds to form a copolymer. A preferable embodiment is that a composition is constructed by monomers, and a copolymer is formed by polymerization of the monomers at a desired time.

The ultraviolet absorbent composition according to the present invention may be in any form, for example, liquid dispersion, solution, polymer material, or the like. The ultraviolet absorbent composition according to the present invention may contain any other desirable components according to application, in addition to the ultraviolet absorbent represented by the formula (2) or (B-1) and the compound represented by the formula (TS-I) or (TS-II).

The ultraviolet absorbent composition according to the present invention is preferably in the dispersed state as dispersed in a dispersing medium. Hereinafter, the ultraviolet absorbent dispersion according to the present invention will be described.

The medium for dispersing the ultraviolet absorbent according to the present invention is arbitrary. Examples thereof include water, organic solvents, resins, resin solutions, and the like. These media may be used alone or in combination of two or more.

Examples of the organic solvents as the dispersing medium that can be used in the present invention include hydrocarbon-based solvents such as pentane, hexane and octane; aromatic solvents such as benzene, toluene and xylene; ether-based solvents such as diethylether and methyl-t-butylether; alcoholic solvents such as methanol, ethanol and isopropanol; ester-based solvents such as acetone, ethyl acetate and butyl acetate; ketone-based solvents such as methyl ethyl ketone; nitrile-based solvents such as acetonitrile and propionitrile; amide-based solvents such as N,N-dimethylformamide, N,N-dimethylacetamide and N-methylpyrrolidone; sulfoxide-based solvents such as dimethylsulfoxide; amine-based solvents such as triethylamine and tributylamine; carboxylic acid-based solvents such as acetic acid and propionic acid; halogen-based solvents such as methylene chloride and chloroform; and heterocycle-based solvents such as tetrahydrofuran and pyridine. These solvents may be used as a mixture at any rate.

Examples of the resins as the dispersing medium that can be used in the present invention include various known thermoplastic and thermosetting resins conventionally used for production of molded article, sheet, film and others. Examples of the thermoplastic resins include polyethylene series resins, polypropylene series resins, poly(meth)acrylic ester series resins, polystyrene series resins, styrene-acrylonitrile series resins, acrylonitrile-butadiene-styrene series resins, polyvinyl chloride series resins, polyvinylidene chloride series resins, polyvinyl acetate series resins, polyvinylbutyral series resins, ethylene-vinyl acetate series copolymers, ethylene-vinylalcohol series resins, polyethylene terephthalate resins (PET), polybutylene terephthalate resins (PBT), liquid crystal polyester resins (LCP), polyacetal resins (POM), polyamide resins (PA), polycarbonate resins, polyurethane resins, and polyphenylene sulfide resins (PPS), and these resins may be used alone or as polymer blend or alloy of two or more. The resin may be used as a thermoplastic molding material containing a natural resin and additionally a filler such as glass fiber, carbon fiber, semi-carbonized fiber, cellulosic fiber or glass bead, a flame retardant, and the like. As needed, resin additives conventionally used, such as polyolefin series resin fine powder, polyolefin series wax, ethylene bisamide wax, and metal soap, may be used alone or in combination.

Examples of the thermosetting resins include epoxy resins, melamine resins, and unsaturated polyester resins, and the resin may be used as a thermosetting molding material containing a natural resin and additionally a filler, such as glass fiber, carbon fiber, semi-carbonized fiber, cellulosic fiber or glass bead, and a flame retardant.

The ultraviolet absorbent dispersion according to the present invention may contain other additives such as dispersant, antifoam, preservative, antifreezing agent, surfactant and others. The dispersion may contain any other compounds additionally. Examples of the other additives include dye, pigment, infrared absorbent, flavoring agent, polymerizable compound, polymer, inorganic material and metal.

For example, a high-shearing force high-speed-agitation dispersing machine or a high-strength ultrasonic dispersing machine may be used as the apparatus for preparation of the ultraviolet absorbent dispersion according to the present invention. Specific examples thereof include colloid mill, homogenizer, capillary emulsifier, liquid siren, electromagnetic-distortion ultrasonic wave generator, emulsifier having a Pallmann whistle, and the like. The high-speed-agitation dispersing machine favorably used in the present invention is a dispersing machine in which a dispersing part is revolving in liquid at high speed (500 to 15,000 rpm, preferably 2,000 to 4,000 rpm) such as dissolver, polytron, homomixer, homoblender, keddy mill, or jet agitator. The high-speed-agitation dispersing machine that can be used in the present invention is also called a dissolver or a high-speed impeller dispersing machine, and, as described in JP-A-55-129136, a dispersing machine having impellers of saw-teeth shaped plate alternately bent in the vertical direction that are connected to the shaft revolving at high speed is also a favorable example.

Various methods may be used in preparation of an emulsified dispersion containing a hydrophobic compound. For example, in dissolving a hydrophobic compound in an organic solvent, the hydrophobic compound is dissolved in a solvent or a mixture of two or more arbitrarily selected from high-boiling point organic materials, water-immiscible low boiling point organic solvents and water-miscible organic solvents, and the solution is then dispersed in water or an aqueous hydrophilic colloid solution in the presence of a surfactant compound. The water-insoluble phase containing the hydrophobic compound and the aqueous phase may be mixed by the so-called normal mixing method of adding the water-insoluble phase into the agitated aqueous phase or by the reverse mixing method of adding the phases reversely.

The content of the ultraviolet absorbent composition in the ultraviolet absorbent dispersion according to the present invention may not be determined specifically, because it varies according to application and type of usage, and is the concentration is arbitrary according to application. The content is preferably 0.001 to 50 mass%, more preferably 0.01 to 20 mass%, with respect to the total amount of the ultraviolet absorbent dispersion.

The ultraviolet absorbent composition according to the present invention is favorably used in the state of a solution dissolved in a liquid medium. Hereinafter, the ultraviolet absorbent solution according to the present invention will be described.

The liquid dissolving the ultraviolet absorbent composition according to the present invention is arbitrary. It is, for example, water, an organic solvent, a resin, a resin solution, or the like. Examples of the organic solvent, the resin, and the resin solution include those described above as the dispersing medium. These may be used alone or in combination.

The solution of the ultraviolet absorbent composition according to the present invention may contain any other compounds additionally. Examples of the other additives include dye, pigment, infrared absorbent, flavoring agent, polymerizable compound, polymer, inorganic material, metal and the like. Components other than the ultraviolet absorbent composition according to the present invention may not necessarily be dissolved.

The content of the ultraviolet absorbent composition in the ultraviolet absorbent solution according to the present invention may not be determined specifically, because it varies according to application and type of usage, and thus the concentration is arbitrary according to application. The concentration in the entire solution is preferably 0.001 to 30 mass%, more preferably 0.01 to 10 mass%. A solution at higher concentration may be prepared in advance and diluted at a desired time before use. The dilution solvent is selected arbitrarily from the solvents described above.

The polymer composition is used in preparation of the polymer material according to the present invention. The polymer composition for use in the present invention contains a polymer substance described below and the ultraviolet absorbent composition according to the present invention.

The ultraviolet absorbent composition according to the present invention may be contained in the polymer substance in various methods. When the ultraviolet absorbent composition according to the present invention is compatible with the polymer substance, the ultraviolet absorbent composition according to the present invention may be added to the polymer substance directly. The ultraviolet absorbent composition according to the present invention may

be dissolved in a cosolvent compatible with the polymer substance, and then the obtained solution be added to the polymer substance. The ultraviolet absorbent composition according to the present invention may be dispersed in a high-boiling point organic solvent or a polymer, and the obtained dispersion be added to the polymer substance.

The boiling point of the high-boiling point organic solvent is preferably 180°C or higher, more preferably 200°C or higher. The melting point of the high-boiling point organic solvent is preferably 150°C or lower, more preferably 100°C or lower. Examples of the high-boiling point organic solvents include phosphoric esters, phosphonic esters, benzoic esters, phthalic esters, fatty acid esters, carbonate esters, amides, ethers, halogenated hydrocarbons, alcohols and paraffins. Phosphoric esters, phosphonic esters, phthalic ester, benzoic esters and fatty acid esters are preferable.

The method of adding the ultraviolet absorbent composition according to the present invention is determined, by reference to the description in JP-A-58-209735, JP-A-63-264748, JP-A-4-191851, JP-A-8-272058, and British Patent No. 2016017A.

The content of the ultraviolet absorbent composition in the ultraviolet absorbent solution according to the present invention is not determined specifically, because it varies according to application and type of usage, and the concentration is arbitrary according to application. It is preferably 0.001 to 10 mass%, more preferably 0.01 to 5 mass%, in the polymer material.

The ultraviolet absorbent composition according to the present invention is preferably used for a polymer material. Hereinafter, the polymer material according to the present invention will be described.

Although practically sufficient ultraviolet-shielding effect is obtained only with the ultraviolet absorbent composition according to the present invention in the present invention, a white pigment which has higher hiding power such as titanium oxide may be used for assurance. In addition, a trace (0.05 mass% or less) amount of colorant may be used additionally, if the appearance or the color tone is of a problem or as needed. Alternatively, a fluorescent brightener may be used additionally for applications demanding transparency or whiteness. Examples of the fluorescent brighteners include commercialized products, the compounds represented by Formula [1] and typical exemplary compounds 1 to 35 described in JP-A-2002-53824, and the like.

Hereinafter, the polymer substance that can be used in the polymer composition will be described. The polymer substance is a natural or synthetic polymer or copolymer. Examples thereof include the followings:

<1> Monoolefin and diolefinic polymers such as polypropylene, polyisobutylene, poly-but-1-ene, poly-4-methyl pent-1-ene, polyvinylcyclohexane, polyisoprene and polybutadiene; cycloolefin polymers such as of cyclopentene or norbornene; polyethylenes (crosslinked as needed) such as high-density polyethylene (HDPE), high-density and high-molecular weight polyethylene (HDPE-HMW), high-density and ultrahigh molecular weight polyethylene (HDPE-UHMW), medium-density polyethylene (MDPE), low-density polyethylene (LDPE), and linear low-density polyethylene (LLDPE), (VLDPE) and (ULDPE).

Polyolefins (that is, polymers of the monoolefins exemplified in the paragraph above), preferably polyethylene and polypropylene, may be prepared by various methods, particularly by the following methods:

a) Radical polymerization (normally under high pressure and elevated temperature), and
b) Catalytic polymerization normally by using one or more metals in the groups IVb, Vb, VIb or VIII of the Periodic Table.

The metal is normally bound to one or more ligands, typically $\pi$- or $\sigma$-coordinating groups such as oxide, halide, alcoholate, ester, ether, amine, alkyl, alkenyl and/or aryl. The metal complex is in the free state or immobilized on a base material such as activated magnesium chloride, titanium (III) chloride, alumina or silicon oxide. The catalyst may be soluble or insoluble in the polymerization medium. The catalyst may be used as it is in polymerization or in combination with another activation agent, such as metal alkyl, metal hydride, metal alkyl halide, metal alkyl oxide or metal alkyloxane, the metal being an element in the groups Ia, IIa and/or IIIa of the Periodic Table. The activation agent may be modified properly with an other ester, ether, amine or silylether group. Such a catalyst system is normally called Philips, Standard Oil-Indiana, Ziegler (Natta), TNZ (Du Pont), metallocene or single site catalyst (SSC).

<2> Mixture of the polymers described in <1> above such as polypropylene/polyisobutylene, polypropylene/polyethylene mixture (such as PP/HDPE and PP/LDPE), and mixture of different types of polyethylene (such as LDPE/HDPE).

<3> Copolymers of a monoolefin and a diolefin or a monoolefin or diolefin with another vinyl monomer such as ethylene/propylene copolymer, mixture of linear low-density polyethylene (LLDPE) and its low-density polyethylene (LDPE), propylene/but-1-ene copolymer, propylene/isobutylene copolymer, ethylene/but-1-ene copolymer, ethylene/hexene copolymer, ethylene/methylpentene copolymer, ethylene/heptene copolymer, ethylene/octene copolymer, ethylene/vinylcyclohexane copolymer, ethylene/cycloolefin copolymer (such as COC (Cyclo-Olefin Copolymer) of ethylene/norbornene), ethylene/1-olefin copolymer (1-olefin is produced in situ), propylene/butadiene copolymer, isobutylene/isoprene copolymer, ethylene/vinylcyclohexene copolymer, ethylene/alkyl acrylate copolymer, ethylene/alkyl methacrylate copolymer, ethylene/vinyl acetate copolymer or ethylene/acrylic acid copolymer and the salts thereof (ionomers); and terpolymers of ethylene, propylene and diene (such as hexadiene, dicyclopentadiene or ethylidene-norbomene); and mixtures of each other's copolymers and the mixtures of such copolymers with the polymer described in the above 1) such as polypropylene/ethylenepropylene copolymer, LDPE/ethylene-vinyl acetate copolymer (EVA), LDPE/ethylene-acrylic acid copolymer (EAA), and mixtures of LLDPE/EVA, LLDPE/EAA and alternating or random polyalkylene/carbon monooxide copolymer and the other polymer such as polyamide.

<4> Mixtures of hydrocarbon resins (for example, having 5 to 9 carbon atoms) containing hydrogenated derivatives (such as tackifier), polyalkylene and starch.

The homopolymers and copolymers described in <1> to <4> above may have any steric structure including syndiotactic, isotactic, hemiisotactic or atactic; and atactic polymers are preferable. Stereoblock polymers are also included.

<5> Polystyrene, poly(p-methylstyrene), and poly($\alpha$-methylstyrene).

<6> Aromatic homopolymers and copolymers derived from aromatic vinyl monomers including all isomers of styrene, $\alpha$-methylstyrene, and vinyltoluene, in particular all isomers of p-vinyltoluene, ethylstyrene, propylstyrene, vinyl biphenyl, vinylnaphthalene, and vinylanthracene, and the mixture thereof. The homopolymers and copolymers may have any steric structure including syndiotactic, isotactic, hemiisotactic or atactic; and atactic polymers are preferable. Stereoblock polymers are also included.

<6a> Copolymers of the aromatic vinyl monomers or comonomers selected from ethylene, propylene, dienes, nitriles, acids, maleic anhydride, maleimide, vinyl acetate and vinyl chloride or its acrylic derivative and the mixture thereof, such as styrene/butadiene, styrene/acrylonitrile, styrene/ethylene (copolymer), styrene/alkyl methacrylate, styrene/butadiene/alkyl acrylate, styrene/butadiene/alkyl methacrylate, styrene/maleic anhydride, and styrene/acrylonitrile/methyl acrylate; styrene copolymers and other polymers including high shock-resistant mixtures such as polyacrylate, diene polymer, and ethylene/propylene/diene terpolymer; and styrene block copolymers such as styrene/butadiene/styrene, styrene/isoprene/styrene, styrenelethylene/butylene/styrene and styrene/ethylene/propylene/styrene.

<6b> Hydrogenated aromatic polymers derived from the hydrogenated polymers described in <6>, in particular polycyclohexylethylene (PCHE), often called as polyvinylcyclohexane (PVCH), prepared by hydrogenation of atactic polystyrene.

<6c> Hydrogenated aromatic polymers derived by hydrogenation of the polymers described in <6a> above.

The homopolymers and copolymers may have any three-dimensional structure, syndiotactic, isotactic, hemiisotactic or atactic, and atactic polymers are preferable. Stereoblock polymers are also included.

<7> Graft copolymers of an aromatic vinyl monomer such as styrene or $\alpha$-methylstyrene, including graft copolymers of polybutadiene/styrene; polybutadiene-styrene or polybutadiene-acrylonitrile copolymer/styrene; polybutadiene/styrene and acrylonitrile (or methacrylonitrile); polybutadiene/styrene, acrylonitrile and methyl methacrylate; polybutadiene/styrene and maleic anhydride; polybutadiene/styrene, acrylonitrile and maleic anhydride or maleimide; polybutadiene/styrene and maleimide; polybutadiene/styrene and alkyl acrylate or methacrylate; ethylene/propylene/diene terpolymer/styrene and acrylonitrile; polyalkyl acrylate or polyalkyl methacrylate/styrene and acrylonitrile; acrylate/butadiene copolymer/styrene and acrylonitrile; and mixtures thereof with the copolymers described in <6> above such as known copolymer mixtures of ABS, SAN, MBS, ASA and AES polymer.

<8> Halogen-containing polymers such as polychloroprene, chlorinated rubber, chlorinated or brominated copolymers of isobutylene-isoprene (halobutyl rubbers), chlorinated or sulfochlorinated polyethylene, ethylene-chlorinated ethylene copolymer, and epichlorohydrin homopolymer and copolymers; in particular, polymers of a halogen-containing vinyl compound such as polyvinyl chloride, polyvinylidene chloride, polyvinyl fluoride, polyvinylidene fluoride, and copolymers thereof such as polyvinyl chloride/vinylidene chloride, polyvinyl chloride/vinyl acetate or vinylidene chloride/vinyl acetate copolymer.

<9> Polymers derived from $\alpha$,$\beta$-unsaturated acid, and the derivatives thereof such as polyacrylates and polymethacrylates; and high-impact polymethyl methacrylate modified with butyl acrylate, polyacrylamide and polyacrylonitrile.

<10> Copolymers of each other's monomers described in <9> above or copolymers thereof with another unsaturated monomer such as acrylonitrile/butadiene copolymer, acrylonitrile/alkyl acrylate copolymer, acrylonitrile/alkoxyalkyl acrylate or acrylonitrile/vinyl halide copolymer and acrylonitrile/alkyl methacrylate/butadiene terpolymer.

<11> Polymers derived from an unsaturated alcohol and an amine, and acyl derivatives or acetals thereof such as polyvinylalcohol, polyvinyl acetate, polyvinyl stearate, polyvinyl benzoate, polyvinyl maleate, polyvinylbutyral, polyallyl phthalate and polyallylmelamine; and copolymers thereof with the olefin described in <1> above.

<12> Homopolymers and copolymers of cyclic ether such as polyalkylene glycols, polyethyleneoxide, polypropyleneoxide or bisglycidylether, and the copolymers thereof.

<13> Polyacetals such as polyoxymethylene and polyoxymethylene containing ethyleneoxide as a comonomer; polyacetals modified with a thermoplastic polyurethane, acrylate or MBS.

<14> Mixtures of polyphenylene-oxide and sulfide, and those of polyphenyleneoxide and styrene polymer or

polyamide.

<15> Polyurethanes derived from a polyether, polyester or polybutadiene having a hydroxyl group terminal, and an aliphatic or aromatic polyisocyanate, and the precursors thereof.

<16> Polyamides and copolyamides derived from a diamine and a dicarboxylic acid and/or an aminocarboxylic acid or the corresponding lactam, such as polyamide 4, polyamide 6, polyamides 6/6, 6/10, 6/9, 6/12, 4/6 and 12/12, polyamide 11, polyamide 12, and an aromatic polyamide from m-xylenediamine and adipic acid; polyamides prepared from hexamethylenediamine and isophthalic and/or terephthalic acid, in the presence or absence of a modifying agent elastomer such as poly-2,4,4-trimethylhexamethylene terephthalamide and poly-m-phenylene isophthalamide; block copolymers of the polyamides above with polyolefin, olefin copolymer, ionomer or chemically bonded or grafted elastomer; block copolymers of the polyamides above with polyether such as polyethylene glycol, polypropylene glycol or polytetramethylene glycol; polyamides or copolyamides modified with EPDM or ABS; and polyamides condensed during processing (RIM polyamides).

<17> Polyurea, polyimide, polyamide-imide, polyether imide, polyester-imide, polyhydantoin and polybenzimidazole.

<18> Polyesters derived from a dicarboxylic acid and a diol and/or a hydroxycarboxylic acid or the corresponding lactone such as polyethylene terephthalate, polybutylene terephthalate, poly-1,4-dimethylolcyclohexane terephthalate, polyalkylene naphthalate (PAN) and polyhydroxybenzoate; block copolyether esters derived from hydroxyl terminal polyethers; and polyesters modified with polycarbonate or MBS; the polyesters and polyester copolymers specified in U.S. Patent No. 5,807,932 (2nd column, line 53) are also incorporated herein by reference.

<19> Polycarbonates and polyester carbonates.

<20> Polyketones.

<21> Polysulfones, polyether sulfones and polyether ketones.

<22> Crosslinked polymers derived from an aldehyde component and another component of phenol, urea or melamine, such as phenol/formaldehyde resin, urea/formaldehyde resin and melamine/formaldehyde resin.

<23> Dry and non-dry alkyd resins.

<24> Unsaturated polyester resins derived from saturated and unsaturated dicarboxylic acids, a polyvalent alcohol, and a vinyl compound as a crosslinking agent, and in addition, less flammable halogen-containing derivatives thereof.

<25> Substituted acrylates, for example, crosslinkable acrylic resins derived from epoxy acrylate, urethane acrylate or polyester acrylate.

<26> Crosslinked alkyd, polyester and acrylate resins crosslinked with a melamine resin, urea resin, isocyanate, isocyanurate, polyisocyanate or epoxy resin.

<27> Crosslinked epoxy resins derived from an aliphatic, alicyclic, heterocyclic or aromatic glycidyl compound, for example, glycidyl ether products of bisphenol A or bisphenol F crosslinked with a common curing agent such as anhydride or amine in the presence or absence of an accelerator.

<28> Natural polymers such as cellulose, rubber, gelatin and chemically modified derivative of their homologs, such as cellulose acetate, cellulose propionate and cellulose butyrate, or cellulose ethers (e.g., methylcellulose); and rosins and the derivatives thereof.

<29> Polymer blends (polyblends) of the polymers described above such as PP/EPDM, polyamide/EPDM or ABS, PVC/EVA, PVC/ABS, PVC/MBS, PC/ABS, PBTP/ABS, PC/ASA, PC/PBT, PVC/CPE, PVC/acrylate, POM/thermoplastic PUR, PC/thermoplastic PUR, POM/acrylate, POM/MBS, PPO/HIPS, PPO/PA6.6 and copolymer, PA/HDPE, PA/PP, PA/PPO, PBT/PC/ABS and PBT/PET/PC.

<30> Natural and synthetic organic materials of a pure monomeric compound or a mixture of the compounds such as mineral oils, animal and vegetable fats, oils and waxes, or synthetic ester (such as phthalate, adipate, phosphate or trimellitate)-based oils, fats and waxes, and mixtures thereof with a synthetic ester and mineral oil at any weight rate, mixtures typically used as a fiber-spinning composition, and the aqueous emulsions of the above materials.

<31> Aqueous emulsions of natural or synthetic rubber, for example, a natural latex or latexes of a carboxylated styrene/butadiene copolymer.

<32> Polysiloxanes, for example, the soft hydrophilic polysiloxane described in U.S. Patent No. 4,259,467 and the hard polyorganosiloxane described in U.S. Patent No. 4,355,147.

<33> Polyketimines in combination with an unsaturated acrylic polyacetoacetate resin and/or an unsaturated acrylic resin including urethane acrylate, polyester acrylate, vinyl or acrylic copolymers having a pendant unsaturated group, and acrylated melamines. The polyketimine is prepared from a polyamine and a ketone in the presence of an acid catalyst.

<34> Radiant ray-hardening compositions containing an ethylenically unsaturated monomer or oligomer and a polyunsaturated aliphatic oligomer.

<35> Epoxy-functionalized epoxy melamine resins such as photostabilized epoxy resins crosslinked with a coetherified high-solid content melamine resin, such as LSE-4103 (trade name, manufactured by Monsanto).

The polymer substance for use in the present invention is preferably a synthetic polymer, more preferably a polyolefin, acrylic polymer, polyester, polycarbonate, or cellulose ester. Among them, polyethylene, polypropylene, poly(4-methylpentene), polymethyl methacrylate, polycarbonate, polyethylene terephthalate, polyethylene naphthalate, polybutylene terephthalate, and triacetylcellulose are particularly preferable.

The polymer substance for use in the present invention is preferably a thermoplastic resin.

The polymer material according to the present invention may contain any additives such as antioxidant, photostabilizer, processing stabilizer, antidegradant, and compatibilizer, as needed, in addition to the polymer substance above and the ultraviolet absorbent.

The polymer material according to the present invention contains the polymer substance above. The polymer material according to the present invention may be made only of the above polymer substance, or may be formed by using the polymer substance dissolved in an arbitrary solvent.

The polymer material according to the present invention is applicable to any application where synthetic resin is used, and particularly favorably to applications where there is possibility of exposure to light such as sunlight or ultraviolet light. Specific examples thereof include glass alternatives and their surface-coating agent; coating agents for the window glass, lighting glass and light source-protecting glass such as of house, facility, and vehicle; interior and exterior materials such as of house, facility and vehicle, paints for the interior and exterior materials; materials for ultraviolet-emission sources such as fluorescent lamp and mercury lamp; materials for precision machines and electric and electronic devices; materials for shielding electromagnetic and other waves emitted from various displays; containers or packaging material for food, chemicals, medicine and others; discoloration inhibitors for agricultural and industrial sheet or film, print, colored products, dyes and pigments; cosmetics such as anti-sunburn cream, shampoo, rinse, and hair dressing; apparel fiber products such as sport wear, stockings and cap and the fibers; home interior products such as curtain, carpet and wall paper; medical devices such as plastic lens, contact lens and artificial eye; optical materials such as optical filter, prism, mirror, and photographic material; stationery products such as tape and ink; display plates and devices and the surface-coating agents thereof, and the like.

The shape of the polymer material according to the present invention may be flat film, powder, spherical particle, crushed particle, bulky continuous particle, fiber, solenoid, hollow fiber, granule, plate, porous particle, or the other.

The polymer material according to the present invention, which contains the ultraviolet absorbent composition according to the present invention, is superior in light resistance (ultraviolet fastness), causing no precipitation or bleed out of the ultraviolet absorbent during long-term use. In addition, the polymer material according to the present invention, which has superior long-wavelength ultraviolet absorption capability, can be used as an ultraviolet-absorbing filter or container, for protection, for example, of an ultraviolet-sensitive compound therein. It is possible to obtain a molded article (such as container) of the polymer material according to the present invention, for example, by molding the polymer substance by any molding method such as extrusion molding or injection molding. It is also possible to prepare a molded article coated with an ultraviolet-absorbing film made of the polymer material according to the present invention, by coating and drying a solution of the polymer substance on a separately prepared molded article.

When the polymer material according to the present invention is used as an ultraviolet-absorbing filter or film, the polymer substance is preferably transparent. Examples of the transparent polymer materials include cellulose esters (such as diacetylcellulose, triacetylcellulose (TAC), propionylcellulose, butyrylcellulose, acetyl propionyl cellulose, and nitrocellulose), polyamides, polycarbonates, polyesters (such as polyethylene terephthalate, polyethylene naphthalate, polybutylene terephthalate, poly-1,4-cyclohexane dimethylene terephthalate, polyethylene-1,2-diphenoxyethane-4,4'-dicarboxylate, and polybutylene terephthalate), polystyrenes (such as syndiotactic polystyrene), polyolefins (such as polyethylene, polypropylene, and polymethylpentene), polymethyl methacrylate, syndiotactic polystyrene, polysulfones, polyether sulfones, polyether ketones, polyether imides, polyoxyethylene, and the like. Preferable are cellulose esters, polycarbonates, polyesters, polyolefins, and acrylic resins. The polymer material according to the present invention may be used as a transparent support, and the transmittance of the transparent support in such a case is preferably 80% or more, more preferably 86% or more.

Hereinafter, the packaging material containing the ultraviolet absorbent composition according to the present invention will be described. The packaging material containing the ultraviolet absorbent composition according to the present invention may be a packaging material of any kind of polymer, as long as it contains the ultraviolet absorbent represented by the above-described formula (2) or (B-1), and the compound represented by the above-described formula (TS-I) or (TS-II). Examples thereof include the thermoplastic resins described in JP-A-8-208765; the polyvinylalcohols described in JP-A-8-151455; the polyvinyl chlorides described in JP-A-8-245849; the polyesters described in JP-A-10-168292 and JP-A-2004-285189; the heat-shrinkable polyesters described in JP-A-2001-323082; the styrene-based resins described in JP-A-10-298397; the polyolefins described in JP-A-11-315175, JP-A-2001-26081, and JP-A-2005-305745; the ROMP's described in JP-T-2003-524019; and the like. It may be, for example, the resin having a vapor-deposition thin film layer of an inorganic compound described in JP-A-2004-50460 or JP-A-2004-243674. It may be, for example, the paper coated with a resin containing the ultraviolet absorbent described in JP-A-2006-240734.

The packaging material containing the ultraviolet absorbent composition according to the present invention

may be that for packaging anything such as food, beverage, medicine, cosmetics, or individual health care product. Examples thereof include the food packaging materials described in JP-A-11-34261 and JP-A-2003-237825; the colored liquid packaging materials described in JP-A-8-80928; the liquid preparation-packaging materials described in JP-A-2004-51174; the medicine container packaging materials described in JP-A-8-301363 and JP-A-11-276550; the medical sterilization packaging materials described in JP-A-2006-271781; the photographic photosensitive material packaging materials described in JP-A-7-287353; the photograph film packaging materials described in JP-A-2000-56433; the UV-hardening ink packaging materials described in JP-A-2005-178832; the shrink labels described in JP-A-2003-200966 and JP-A-2006-323339; and the like.

The packaging material containing the ultraviolet absorbent composition according to the present invention may be the transparent packaging material described, for example, in JP-A-2004-51174 or the light-shielding packaging material described, for example, in JP-A-2006-224317.

The packaging material containing the ultraviolet absorbent composition according to the present invention may have ultraviolet light-shielding property as well as other properties, as described, for example, in JP-A-2001-26081 and JP-A-2005-305745. Examples thereof include the packaging materials having gas-barrier property described, for example, in JP-A-2002-160321; those containing an oxygen indicator as described, for example, in JP-A-2005-156220; those containing both an ultraviolet absorbent and a fluorescent brightener described, for example, in JP-A-2005-146278; and the like.

The packaging material containing the ultraviolet absorbent composition according to the present invention may be prepared by any method. Examples of the method include the method of forming an ink layer described, for example, in JP-A-2006-130807; the method of melt-extruding and laminating a resin containing an ultraviolet absorbent described, for example, in JP-A-2001-323082 and JP-A-2005-305745; the method of coating on a base film described, for example, in JP-A-9-142539; the method of dispersing an ultraviolet absorbent in an adhesive described, for example, in JP-A-9-157626; and the like.

Hereinafter, the container containing the ultraviolet absorbent composition according to the present invention will be described. The container containing the ultraviolet absorbent composition according to the present invention may be a container of any kind of polymer, as long as it contains the ultraviolet absorbent represented by the above-described formula (2) or (B-1), and the compound represented by the above-described formula (TS-I) or (TS-II). Examples thereof include the thermoplastic resin containers described in JP-A-8-324572; the polyester containers described in JP-A-2001-48153, JP-A-2005-105004, and JP-A-2006-1568; the polyethylene naphthalate containers described in JP-A-2000-238857; the polyethylene containers described in JP-A-2001-88815; the cyclic olefin-based resin composition containers described in JP-A-7-216152; the plastic containers described in JP-A-2001-270531; the transparent polyamide containers described in JP-A-2004-83858; and the like. It may be the paper container containing a resin described, for example, in JP-A-2001-114262 or JP-A-2001-213427. It may be, alternatively, the glass container having an ultraviolet-absorbing layer described, for example, in JP-A-7-242444, JP-A-8-133787, or JP-A-2005-320408.

The container containing the ultraviolet absorbent composition according to the present invention is used as containers in various applications including food, beverage, medicine, cosmetics, individual health care product, shampoo and the like. Examples thereof include the liquid fuel-storing containers described in JP-A-5-139434; the golf ball containers described in JP-A-7-289665; the food containers described in JP-A-9-295664 and JP-A-2003-237825; the liquor containers described in JP-A-9-58687; the medicine-filling containers described in JP-A-8-155007; the beverage containers described in JP-A-8-324572 and JP-A-2006-298456; the oily food containers described in JP-A-9-86570; the analytical reagent solution containers described in JP-A-9-113494; the instant noodle containers described in JP-A-9-239910; the light-resistant cosmetic preparation containers described in JP-A-11-180474, JP-A-2002-68322, and JP-A-2005-278678; the medicine containers described in JP-A-11-276550; the high-purity chemical solution containers described in JP-A-11-290420; the liquid agent containers described in JP-A-2001-106218; the UV-hardening ink containers described in JP-A-2005-178832; the plastic ampoules described in WO 04/93775 pamphlet; and the like.

The container containing the ultraviolet absorbent composition according to the present invention may have ultraviolet-shielding property as well as other properties, as described, for example, in JP-A-5-305975 and JP-A-7-40954. Examples of such containers include the antimicrobial containers described in JP-A-10-23 7312; the flexible containers described in JP-A-2000-152974; the dispenser containers described in JP-A-2002-264979; the biodegradable containers described in, for example, JP-A-2005-255736; and the like.

The container containing the ultraviolet absorbent composition according to the present invention may be prepared by any method. Examples of the method include the two-layer stretching blow-molding method described in JP-A-2002-370723; the multilayer coextrusion blow-molding method described in JP-A-2001-88815; the method of forming an ultraviolet-absorbing layer on the external surface of an container described in JP-A-9-241407; the methods of using a shrinkable film described in JP-A-8-91385, JP-A-9-48935, JP-T-11-514387, JP-A-2000-66603, JP-A-2001-323082, JP-A-2005-105032, and WO 99/29490 pamphlet; the method of using a supercritical fluid described in JP-A-11-255925; and the like.

Hereinafter, the paint and the coated film containing the ultraviolet absorbent composition according to the

present invention will be described. The paint containing the ultraviolet absorbent composition according to the present invention may be a paint of any composition, as long as it contains the ultraviolet absorbent represented by the above-described formula (2) or (B-1), and the compound represented by the above-described formula (TS-I) or (TS-II). Examples thereof include those of acrylic resin-base, urethane resin-base, aminoalkyd resin-base, epoxy resin-base, silicone resin-base, and fluororesin-base. To these resins, a base compound, curing agent, diluent, leveling agent, cissing inhibitor or the like may be arbitrarily added.

For example, when an acrylic urethane resin or a silicon acrylic resin is selected as the transparent resin component, the curing agent is preferably a polyisocyanate; and the diluent is preferably a hydrocarbon-based solvent such as toluene and xylene, an ester-based solvent such as isobutyl acetate, butyl acetate and amyl acetate, or an alcohol-based solvent such as isopropyl alcohol and butyl alcohol. The acrylic urethane resin is an acrylic urethane resin obtained by reaction of a copolymer of methacrylate (typically, methyl methacrylate) and hydroxyethyl methacrylate, and a polyisocyanate. In such a case, the polyisocyanate is, for example, tolylene diisocyanate, diphenylmethane diisocyanate, polymethylene polyphenylene polyisocyanate, tolidine diisocyanate, naphthalene diisocyanate, hexamethylene diisocyanate, isophorone diisocyanate, xylylene diisocyanate, dicyclohexylmethane diisocyanate, hexamethylene diisocyanate or the like. Examples of other transparent resin components include polymethyl methacrylate, polymethyl methacrylate/styrene copolymer, polyvinyl chloride, polyvinyl acetate, and the like. In addition to these components, a leveling agent such as an acrylic or silicone resin, a silicone-based or acrylic cissing inhibitor, and others may be arbitrarily added as needed.

The paint containing the ultraviolet absorbent composition according to the present invention may be used in any application. Examples thereof include the ultraviolet-shielding paints described in JP-A-7-26177, JP-A-9-169950, JP-A-9-221631, and JP-A-2002-80788; the ultraviolet- and near-infrared-shielding paints described in JP-A-10-88039; the electromagnetic wave-shielding paints described in JP-A-2001-55541; the clear paints described in JP-A-8-81643; the metallic paint compositions described in JP-A-2000-186234; the cationic electrodeposition paints described in JP-A-7-166112; the antimicrobial and lead-free cationic electrodeposition paints described in JP-A-2002-294165; the powder paints described in JP-A-2000-273362, JP-A-2001-279189, and JP-A-2002-271227; the aqueous intermediate-layer paints, aqueous metallic paints, and aqueous clear paints described in JP-A-2001-9357; the topcoat paints for automobile, construction, and civil work described in JP-A-2001-316630; the hardening paints described in JP-A-2002-356655; the coat-film forming compositions for use on plastic materials such as automobile bumper described in JP-A-2004-937; the paints for a metal plate described in JP-A-2004-2700; the hardening gradient coat films described in JP-A-2004-169182; the coating materials for an electric wire described in JP-A-2004-107700; the paints for automobile repair described in JP-A-6-49368; the anionic electrodeposition paints described in JP-A-2002-38084 and JP-A-2005-307161; the paints for an automobile described in JP-A-5-78606, JP-A-5-185031, JP-A-10-140089, JP-T-2000-509082, JP-T-2004-520284, and WO 2006/097201 pamphlet; the paints for a coated steel plate described in JP-A-6-1945; the paints for a stainless steel described in JP-A-6-313148; the lamp moth-repellent paints described in JP-A-7-3189; the UV-hardening paints described in JP-A-7-82454; the antimicrobial paints described in JP-A-7-118576; the eyestrain protection paints described in JP-A-2004-217727; the anti-fog paints described in JP-A-2005-314495; the ultra-weather-resistance paints described in JP-A-10-298493; the gradient paints described in JP-A-9-241534; the photocatalyst paints described in JP-A-2002-235028; the strippable paints described in JP-A-2000-345109; the concrete separation paints described in JP-A-6-346022; the anticorrosion paints described in JP-A-2002-167545; the protective paints described in JP-A-8-324576; the water-repellent protective paints described in JP-A-9-12924; the anti-plate glass scattering paints described in JP-A-9-157581; the alkali-soluble protective paints described in JP-A-9-59539; the aqueous temporary protective paint compositions described in JP-A-2001-181558; the flooring paints described in JP-A-10-183057; the emulsion paints described in JP-A-2001-115080; the two-pack type aqueous paints described in JP-A-2001-262056; the one-pack type paints described in JP-A-9-263729; the UV-hardening paints described in JP-A-2001-288410; the electron beam-hardening paint compositions described in JP-A-2002-69331; the thermosetting paint compositions described in JP-A-2002-80781; the aqueous paints for baking lacquer described in JP-T-2003-525325; the powder paints and the slurry paints described in JP-A-2004-162021; the repair paints described in JP-A-2006-233010; the powder-paint aqueous dispersions described in JP-T-11-514689; the paints for a plastic article described in JP-A-2001-59068 and JP-A-2006-160847; the electron beam-hardening paints described in JP-A-2002-69331; and the like.

The paint containing the ultraviolet absorbent composition according to the present invention generally contains a paint (containing a transparent resin component as the principal component) and an ultraviolet absorbent. The paint contains the ultraviolet absorbent preferably in an amount of 0 to 20 mass% with respect to the resin. The thickness of the film coated is preferably 2 to 1,000 μm, more preferably 5 to 200μ m. The method of coating the paint is arbitrary, and examples of the method include a spray method, a dipping method, a roller coating method, a flow coater method, a curtain-flow coating method, and the like. The drying after coating is preferably carried out at a temperature of approximately room temperature to 120°C for 10 to 90 minutes, although the condition may vary according to the paint composition.

The coated film containing the ultraviolet absorbent composition according to the present invention is a coated

film formed by using the paint containing the ultraviolet absorbent according to the present invention that contains the ultraviolet absorbent represented by the above-described formula (2) or (B-1), and the compound represented by the above-described formula (TS-I) or (TS-II).

Hereinafter, the ink containing the ultraviolet absorbent composition according to the present invention will be described. The ink containing the ultraviolet absorbent composition according to the present invention may be any ink in any form, as long as it contains the ultraviolet absorbent represented by the above-described formula (2) or (B-1), and the compound represented by the above-described formula (TS-I) or (TS-II). For example, it may be a dye ink, a pigment ink, an aqueous ink, a solvent ink, or the like. It may be used in any application. Examples of the applications include the screen printing ink described in JP-A-8-3502; the flexographic printing ink described in JP-T-2006-521941; the gravure printing ink described in JP-T-2005-533915; the lithographic offset printing ink described in JP-T-11-504954; the letterpress printing ink described in JP-T-2005-533915; the UV ink described in JP-A-5-254277; the EB ink described in JP-A-2006-30596; and the like. Other examples thereof include the inkjet inks described in JP-A-11-199808, WO 99/67337 pamphlet, JP-A-2005-325150, JP-A-2005-350559, JP-A-2006-8811, and JP-T-2006-514130; the photochromic ink described in JP-A-2006-257165; the thermal transfer ink described in JP-A-8-108650; the masking ink described in JP-A-2005-23111; the fluorescence ink described in JP-A-2004-75888; the security ink described in JP-A-7-164729; the DNA ink described in JP-A-2006-22300; and the like.

Any shape obtained by using the ink containing the ultraviolet absorbent composition according to the present invention is also included in the present invention. Examples thereof include the print described in JP-A-2006-70190, and laminated films obtained by laminating the print, and the packaging materials and containers prepared by using the laminated film; the ink-receiving layer described in JP-A-2002-127596; and the like.

Hereinafter, the fiber containing the ultraviolet absorbent composition according to the present invention will be described. The fiber containing the ultraviolet absorbent composition according to the present invention may be a fiber of any kind of polymer, as long as it contains the ultraviolet absorbent represented by the above-described formula (2) or (B-1), and the compound represented by the above-described formula (TS-I) or (TS-II). Examples thereof include the polyester fibers described in JP-A-5-117508, JP-A-7-119036, JP-A-7-196631, JP-A-8-188921, JP-A-10-237760, JP-A-2000-54287, JP-A-2006-299428, and JP-A-2006-299438; the polyphenylene sulfide fibers described in JP-A-2002-322360 and JP-A-2006-265770; the polyamide fibers described in JP-A-7-76580, JP-A-2001-348785, JP-A-2003-41434, and JP-A-2003-239136; the epoxy fibers described in WO 03/2661 pamphlet; the aramide fibers described in JP-A-10-251981; the polyurethane fibers described in JP-A-6-228816; the cellulosic fibers described in JP-T-2005-517822; and the like.

The fiber containing the ultraviolet absorbent composition according to the present invention may be prepared by any method. Examples of the method include the method, as described in JP-A-6-228818, of processing a polymer previously containing the ultraviolet absorbent represented by the above-described formula (2) or (B-1), and the compound represented by the above-described formula (TS-I) or (TS-II) into fiber, and the methods, as described, for example, in JP-A-5-9870, JP-A-8-188921, and JP-A-10-1587, of processing a material processed in a fiber form with a solution containing the ultraviolet absorbent represented by the above-described formula (2) or (B-1). As described in JP-A-2002-212884 and JP-A-2006-16710, the fiber may be processed by using a supercritical fluid.

The fiber containing the ultraviolet absorbent composition according to the present invention can be used in various applications. Examples thereof include the clothing described in JP-A-5-148703; the backing cloth described in JP-A-2004-285516; the underwear described in JP-A-2004-285517; the blanket described in JP-A-2003-339503; the hosiery described in JP-A-2004-11062; the synthetic leather described in JP-A-11-302982; the moth-repellent mesh sheet described in JP-A-7-289097; the mesh sheet for construction described in JP-A-10-1868; the carpet described in JP-A-5-256464; the moisture-permeable water-repellent sheet described in JP-A-5-193037; the nonwoven fabric described in JP-A-6-114991; the ultrafine fiber described in JP-A-11-247028; the fibrous sheet described in JP-A-2000-144583; the refreshing clothing described in JP-A-5-148703; the moisture-permeable water-repellent sheet described in JP-A-5-193037; the flame-resistant synthetic suede cloth structure described in JP-A-7-18584; the resin tarpaulin described in JP-A-8-41785; the filming agent, external wall material, and agricultural greenhouse described in JP-A-8-193136; the net and mesh for construction described in JP-A-8-269850; the filter substrate described in JP-A-8-284063; the stainproof filming agent described in JP-A-9-57889; the mesh fabric and land net described in JP-A-9-137335; the underwater net described in JP-A-10-165045; the ultrafine fibers described in JP-A-11-247027 and 11-247028; the textile fiber described in JP-A-7-310283 and JP-T-2003-528974; the air-bag base cloth described in JP-A-2001-30861; the ultraviolet-absorbing fiber products described in JP-A-7-324283, JP-A-8-20579, and JP-A-2003-147617; and the like.

Hereinafter, the construction material containing the ultraviolet absorbent composition according to the present invention will be described. The construction material containing the ultraviolet absorbent composition according to the present invention may be a construction material of any kind of polymer, as long as it contains the ultraviolet absorbent represented by the above-described formula (2) or (B-1), and the compound represented by the above-described formula (TS-I) or (TS-II). Examples thereof include the vinyl chloride-based material described in JP-A-10-6451; the olefinic-based material described in JP-A-10-16152; the polyester-based material described in JP-A-2002-161158; the polyphenylene ether-based material described in JP-A-2003-49065; the polycarbonate-based material described in JP-A-2003-160724; and the like.

The construction material containing the ultraviolet absorbent composition according to the present invention may be prepared by any method. Examples of the method include the method, as described in JP-A-8-269850, of forming a material containing the ultraviolet absorbent represented by the above-described formula (2) or (B-1), and the compound represented by the above-described formula (TS-I) or (TS-II) into a desired shape; the methods, as described, for example, in JP-A-10-205056, of forming a laminate of a material containing the ultraviolet absorbent represented by the above-described formula (2) or (B-1), and the compound represented by the above-described formula (TS-I) or (TS-II); the methods, as described, for example, in JP-A-8-151457, of forming a coated layer containing the ultraviolet absorbent represented by the above-described formula (2) or (B-1), and the compound represented by the above-described formula (TS-I) or (TS-II); and the methods, as described, for example, in JP-A-2001-172531, of forming it by coating a paint containing the ultraviolet absorbent represented by the above-described formula (2) or (B-1), and the compound represented by the above-described formula (TS-I) or (TS-II).

The construction material containing the ultraviolet absorbent composition according to the present invention can be used in various applications. Examples thereof include the external construction materials described in JP-A-7-3955, JP-A-8-151457, and JP-A-2006-266042; the wood structure for construction described in JP-A-8-197511; the roofing material for construction described in JP-A-9-183159; the antimicrobial construction material described in JP-A-11-236734; the base construction material described in JP-A-10-205056; the antifouling construction material described in JP-A-11-300880; the flame-resistant material described in JP-A-2001-9811; the ceramic construction material described in JP-A-2001-172531; the decorative construction material described in JP-A-2003-328523; the painted matter for construction described in JP-A-2002-226764; the facing materials described in JP-A-10-6451, JP-A-10-16152, and JP-A-2006-306020; the net for construction materail described in JP-A-8-269850; the moisture-permeable water-repellent sheet for construction described in JP-A-9-277414; the mesh sheet for construction material described in JP-A-10-1868; the film for construction material described in JP-A-7-269016; the decorative film described in JP-A-2003-211538; the coating materials for construction described in JP-A-9-239921, JP-A-9-254345, and JP-A-10-44352; the adhesive composition for construction described in JP-A-8-73825; the civil work construction structure described in JP-A-8-207218; the pathway coating material described in JP-A-2003-82608; the sheet-shaped photocuring resin described in JP-A-2001-139700; the wood-protecting paint described in JP-A-5-253559; the push-switch cover described in JP-A-2005-2941780; the bond-sheeting agent described in JP-A-9-183159; the base construction material described in JP-A-10-44352; the wall paper described in JP-A-2000-226778; the decorative polyester film described in JP-A-2003-211538; the decorative polyester film for molding material described in JP-A-2003-211606; the flooring material described in JP-A-2004-3191; and the like.

Hereinafter, the recording medium containing the ultraviolet absorbent composition according to the present invention will be described. The recording medium containing the ultraviolet absorbent composition according to the present invention may be any medium, as long as it contains the ultraviolet absorbent represented by the above-described formula (2) or (B-1), and the compound represented of the above-described formula (TS-I) or (TS-II). Examples thereof include the inkjet recording media described in JP-A-9-309260, JP-A-2002-178625, JP-A-2002-212237, JP-A-2003-266926, JP-A-2003-266927, and JP-A-2004-181813; the image-receiving medium for thermal transfer ink described in JP-A-8-108650; the image-receiving sheet for sublimation transfer described in JP-A-10-203033; the image-recording medium described in JP-A-2001-249430; the heat-sensitive recording medium described in JP-A-8-258415; the reversible heat-sensitive recording media described in JP-A-9-95055, JP-A-2003-145949, and JP-A-2006-167996; the information-photorecording medium described in JP-A-2002-367227; and the like.

Hereinafter, the image display device containing the ultraviolet absorbent composition according to the present invention will be described. The image display device containing the ultraviolet absorbent composition according to the present invention may be any device, as long as it contains the ultraviolet absorbent represented by the above-described formula (2) or (B-1), and the compound represented by the above-described formula (TS-I) or (TS-II). Examples thereof include the image display device employing an electrochromic element described in JP-A-2006-301268; the image display device of so-called electronic paper described in JP-A-2006-293155; the plasma display described in JP-A-9-306344; the image display device employing an organic EL element described in JP-A-2000-223271; and the like. The ultraviolet absorbent composition according to the present invention may be contained, for example, in the ultraviolet-absorbing layer formed in the laminated structure described in JP-A-2000-223271, or in a necessary part such as the circularly polarizing plate described, for example, in JP-A-2005-189645.

Hereinafter, the solar cell cover containing the ultraviolet absorbent composition according to the present invention will be described. The solar cell according to the present invention may be made of any type of element. Examples thereof include a crystalline silicon solar cell, an amorphous silicon solar cell, and a dye-sensitized solar cell. As described in JP-A-2000-174296, a cover material has been used as a part for providing a crystalline silicon solar cell or an amorphous silicon solar cell with antifouling property, impact resistance, and durability. As described in JP-A-2006-282970, dye-sensitized solar batteries, which employ a metal oxide-based semiconductor that is activated by excitation of light (in particular, ultraviolet light) as its electrode material, have a problem of the photosensitizer colorant adsorbed being decomposed and thus the photovoltaic efficiency gradually declining, and for that reason, installation of an additional ultraviolet-absorbing layer was proposed.

The solar cell cover containing the ultraviolet absorbent composition according to the present invention may be a cover of any kind of polymer. Examples of the polymer include the polyester described in JP-A-2006-310461; the thermosetting transparent resin described in JP-A-2006-257144; the $\alpha$-olefin polymer described in JP-A-2006-210906; the polypropylene described in JP-A-2003-168814; the polyether sulfone described in JP-A-2005-129713; the acrylic resin described in JP-A-2004-227843; the transparent fluorine resin described in JP-A-2004-168057; and the like.

The solar cell cover containing the ultraviolet absorbent composition according to the present invention may be prepared by any method. For example, the ultraviolet-absorbing layer described in JP-A-11-40833 may be formed; the layers respectively containing the ultraviolet absorbent may be laminated, as described in JP-A-2005-129926; it may be contained in the filler layer resin, as described in JP-A-2000-91611; or a film may be formed, together with the ultraviolet absorbent-containing polymer described in JP-A-2005-346999.

The solar cell cover containing the ultraviolet absorbent composition according to the present invention may be in any form. Examples thereof include the film and sheet described in JP-A-2000-91610 and JP-A-11-261085; the laminate film described, for example, in JP-A-11-40833; the cover glass structure described in JP-A-11-214736; and the like. The ultraviolet absorbent may be contained in the sealer described in JP-A-2001-261904.

Other examples of applications include the illumination light source covers described in JP-A-8-102296, JP-A-2000-67629, and JP-A-2005-353554; the synthetic leathers described in JP-A-5-272076 and JP-A-2003-239181; the sport goggle described in JP-A-2006-63162; the deflection lens described in JP-A-2007-93649; the hard-coat for various plastic products described in JP-A-2001-214121, JP-A-2001-214122, JP-A-2001-315263, JP-A-2003-206422, JP-A-2003-25478, JP-A-2004-137457, and JP-A-2005-132999; the hard-coat for bonding on external window described in JP-A-2002-36441; the window film described in JP-A-10-250004; the high-definition antiglare hard-coat film described in JP-A-2002-36452; the antistatic hard-coat film described in JP-A-2003-39607; the permeable hard-coat film described in JP-A-2004-114355; the antiforgery ledger sheet described in JP-A-2002-113937; the turf purpura-preventing agent described in JP-A-2002-293706; the resin film/sheet-bonding sealant described in JP-A-2006-274179; the light guiding body described in JP-A-2005-326761; the coating agent for rubber described in JP-A-2006-335855; the agricultural covering materials described in JP-A-10-34841 and JP-A-2002-114879; the color candles described in JP-T-2004-532306 and JP-T-2004-530024; the cloth-rinsing agent composition described in JP-T-2004-525273; the laminated glass described in JP-A-10-194796; the prism sheet described in JP-A-10-287804; the protective layer transfer sheet described in JP-A-2000-71626; the photocuring resin product described in JP-A-2001-139700; the flooring sheet described in JP-A-2001-159228; the water droplet-repellent and heat wave-shielding glass plate described in JP-A-2002-127310; the light-blocking printing label described in JP-A-2002-189415; the fuel cup described in JP-A-2002-130591; the articles with hard-coat film described in JP-A-2002-307619; the intermediate transfer recording medium described in JP-A-2002-307845; the synthetic hair described in JP-A-2006-316395; the low-temperature heat-shrinkable films for label described in WO 99/29490 pamphlet and JP-A-2004-352847; the fishing goods described in JP-A-2000-224942; the micro beads described in JP-A-8-208976; the precoated metal plate described in JP-A-8-318592; the thin film described in JP-A-2005-504735; the heat-shrinkable film described in JP-A-2005-105032; the in-mold molding label described in JP-A-2005-37642; the projection screen described in JP-A-2005-55615; the decorative sheets described in JP-A-9-300537, JP-A-2000-25180, JP-A-2003-19776, and JP-A-2005-74735; the hot-melt adhesive described in JP-A-2001-207144; the adhesives described in JP-T-2002-543265, JP-T-2002-543266 and U.S. Patent No. 6,225,384; the electrodeposition coat and the basecoat described in JP-A-2004-352783; the wood surface-protecting agent described in JP-A-7-268253; the light-controlling materials, light-controlling films, and light-controlling glasses described in JP-A-2003-253265, JP-A-2005-105131, JP-A-2005-300962, and Japanese Patent No. 3915339; the moth-repellent lamp described in JP-A-2005-304340; the touch panel described in JP-A-2005-44154; the sealant for bonding resin film sheet described in JP-A-2006-274197; the polycarbonate film coating material described in JP-A-2006-89697; the optical fiber tape described in JP-A-2000-231044; the solid wax described in JP-T-2002-527559; and the like.

Hereinafter, the method of evaluating the light stability of the polymer material will be described. Preferable methods of evaluating the light stability of the polymer material are described, for example, in "Methods for Improving the Photostability of Polymers" (CMC Publishing, 2000), pp. 85 to 107; "Basis and Physical Properties of High Functional Coatings" (CMC Publishing, 2003), pp. 314 to 359; "Durability of Polymer Materials and Composite Material Products" (CMC Publishing, 2005); "Elongation of Lifetime of Polymer Materials and Environmental Measures" (CMC Publishing, 2000); H. Zweifel Ed., "Plastics Additives Handbook, 5th Edition" (Hanser Publishers), pp. 238 to 244; and Tadahiko Kutsura, "Basic Seminar 2. Science of Plastic Packaging Container" (Society of packaging Science & Technology, Japan, 2003), Chapter 8.

In addition, the light stability in each application can be attained by the following known evaluation methods.

The photodegradation of polymer materials can be evaluated by the method described in JIS-K7105:1981, JIS-K7101:1981, JIS-K7102:1981, JIS-K7219:1998, JIS-K7350-1:1995, JIS-K7350-2:1995, JIS-K7350-3:1996, JIS-K7350-4:1996 or a method referring to those.

The light stability in the packaging or container application can be evaluated by the method of JIS-K7105 and a method referring to that. Typical examples thereof include the light transmittance and transparency evaluation of the bottle body and the functional test evaluation of the bottle content after ultraviolet irradiation by using a xenon light source described in JP-A-2006-298456; the haze value evaluation after xenon lamp irradiation described in JP-A-2000-238857; the haze value evaluation by using a halogen lamp as the light source described in JP-A-2006-224317; the yellowing evaluation after mercury lamp irradiation by using a blue wool scale described in JP-A-2006-240734; the haze value evaluation and the visual observation of color development by using Sunshine Weather Meter described in JP-A-2005-105004 and JP-A-2006-1568; the ultraviolet light transmittance evaluation described in JP-A-7-40954, JP-A-8-151455, JP-A-10-168292, JP-A-2001-323082, and JP-A-2005-146278; the ultraviolet-blocking rate evaluation described in JP-A-9-48935 and 9-142539; the light transmittance evaluation described in JP-A-9-241407, JP-A-2004-243674, JP-A-2005-320408, JP-A-2005-305745, and JP-A-2005-156220; the evaluation of the viscosity of the ink in ink container described in JP-A-2005-178832; the light transmittance evaluation, the visual observation of the container sample and the color difference ΔE evaluation after sunlight irradiation described in JP-A-2005-278678; the ultraviolet light transmittance evaluation, the light transmittance evaluation, and the color difference evaluation after white fluorescent lamp irradiation described in JP-A-2004-51174; the light transmittance evaluation, the haze value evaluation, and the color tone evaluation described in JP-A-2004-285189; the yellowness index evaluation described in JP-A-2003-237825; the light-blocking evaluation and the brightness evaluation by using the color difference Formula of the L*a*b* color system described in JP-A-2003-20966; the yellowing evaluation by using the color difference ΔEa*b* of a sample after irradiation of xenon lights of different in wavelength described in JP-A-2002-68322; the ultraviolet absorbance evaluation after ultraviolet light irradiation described in JP-A-2001-26081; the film tensile elongation test after photoirradiation by using Sunshine Weather Meter described in JP-A-10-298397; the antimicrobial evaluation after photoirradiation in a xenon weather meter described in JP-A-10-237312; the evaluation of discoloration of a package content after fluorescent lamp irradiation described in JP-A-9-239910; the evaluation of oil peroxide value and color tone of a salad oil-filled bottle after fluorescent lamp irradiation described in JP-A-9-86570; the evaluation of the difference in absorbance after chemical lamp irradiation described in JP-A-8-301363; the evaluation of surface glossiness retention rate and appearance after photoirradiation by using Sunshine Weather Meter described in JP-A-8-208765; the evaluation of color difference and bending strength after photoirradiation by using Sunshine Weather-O-meter described in JP-A-7-216152; the light-blocking rate evaluation and the evaluation of the peroxide generated in kerosene described in JP-A-5-139434; and the like.

The long-term durability, in the case where the polymer material is used in the coating material and coated film applications, can be evaluated according to the method of JIS-K5400, JIS-K5600-7-5:1999, JIS-K5600-7-6:2002, JIS-K5600-7-7:1999, JIS-K5600-7-8:1999, or JIS-K8741 or a method referring to those. Typical examples thereof include the evaluation using the color density, the color difference ΔEa*b* in the CIE L*a*b* color coordinates, and the residual brilliance after photoirradiation in an xenon light-endurance test machine and an UVCON apparatus described in JP-T-2000-509082; the absorbance evaluation after photoirradiation on a film placed on a quartz slide in an xenon arc light-endurance test machine, and the evaluation of the color density and the color difference ΔEa*b* in the CIE L*a*b* color coordinates after fluorescent or UV lamp irradiation on wax described in JP-T-2004-520284; the color tone evaluation after photoirradiation in a Metalweather weather-resistance test machine described in JP-A-2006-160847; the evaluation of brilliance retention rate and the evaluation by using color difference ΔEa*b* after photoirradiation test by using a metal halide lamp, and the evaluation of glossiness after photoirradiation by a sunshine carbon arc light source described in JP-A-2005-307161; the evaluation by using color difference ΔEa*b*, the brilliance retention rate evaluation and the appearance evaluation after photoirradiation in a Metalweather weather-resistance test machine described in JP-A-2002-69331; the brilliance retention rate evaluation after photoirradiation by using Sunshine Weather-O-Meter described in JP-A-2002-38084; the evaluation by using the color difference ΔEa*b* and the brilliance retention rate evaluation after photoirradiation in a QUV weather-resistance test machine described in JP-A-2001-59068; the brilliance retention rate evaluation after photoirradiation by using Sunshine Weather-O-Meter described in JP-A-2001-115080, JP-A-6-49368, and JP-A-2001-262056; the evaluation of post-irradiation appearance after photoirradiation on a coated plate by using Sunshine Weather-O-Meter described in JP-A-8-324576, JP-A-9-12924, JP-A-9-169950, JP-A-9-241534, and JP-A-2001-181558; the evaluation of the brilliance retention rate and the fluctuation in brightness after photoirradiation by using Sunshine Weather-O-Meter described in JP-A-2000-186234; the evaluation of the appearance of the deteriorated coated film after dew cycle WOM photoirradiation on coated film described in JP-A-10-298493; the evaluation of the ultraviolet light transmittance of coated film described in JP-A-7-26177; the evaluation of the ultraviolet-blocking rate of coated film described in JP-A-7-3189 and JP-A-9-263729; the comparative evaluation of the period until the brilliance retention rate of the coated film declines to 80% by using Sunshine Weather-O-Meter as described in JP-A-6-1945; the evaluation of rusting after photoirradiation by using a Dewpanel Light Control Weather Meter described in JP-A-6-313148; the evaluation of the strength of a concrete to the coated formwork after external exposure described in JP-A-6-346022;

the evaluation by using the color difference ΔEa*b*, the lattice adhesion test and the surface appearance evaluation after external photoirradiation described in JP-A-5-185031; the brilliance retention rate evaluation after external photoirradiation described in JP-A-5-78606; the evaluation of post-irradiation yellowing (ΔYI) by using a carbon arc light source described in JP-A-2006-63162; and the like.

The light stability, in the case where the polymer material is used in the ink application, is determined by the method of JIS-K5701-1:2000, JIS-K7360-2, or ISO105-B02 or a method referring to those. Specific examples thereof include the evaluation of the color density and the measurement by the CIE L*a*b* color coordinates after photoirradiation by using an office fluorescent lamp or a discoloration tester described in JP-T-2006-514130; the electrophoretic evaluation after ultraviolet light irradiation by using a xenon arc light source described in JP-A-2006-22300; the print concentration evaluation with a xenon fade meter described in JP-A-2006-8811; the ink blurring evaluation by using a 100W chemical lamp described in JP-A-2005-23111; the evaluation of the dye residual ratio in the image-forming range by using a weather meter described in JP-A-2005-325150; the evaluation of print chalking and discoloration by using an Eye Super UV Tester described in JP-A-2002-127596; the evaluation of print by using the color difference ΔEa*b* in the CIE L*a*b* color coordinates after photoirradiation by a xenon fade meter described in JP-A-11-199808 and JP-A-8-108650; the reflectance evaluation after photoirradiation by using a carbon arc light source described in JP-A-7-164729; and the like.

The light stability of the solar cell module can be evaluated according to the method of JIS-C8917:1998 or JIS-C8938:1995 or a method referring to those. Specific examples thereof include the I-V-measuring photovoltaic efficiency evaluation after photoirradiation by a xenon lamp light source having a sunlight-simulating compensation filter described in JP-A-2006-282970; and the evaluation of discoloration gray scale degree, color, and apparent adhesiveness after photoirradiation by using Sunshine Weather Meter or a fade mater described in JP-A-11-261085 and JP-A-2000-144583.

The light stability of fibers and fiber products can be evaluated according to the method of JIS-L1096:1999, JIS-A5905:2003, JIS-L0842, JIS-K6730, JIS-K7107, DIN75.202, SAEJ1885, SN-ISO-105-B02, or AS/NZS4399 or a method referring to those. Examples thereof include the ultraviolet light transmittance evaluation described in JP-A-10-1587, JP-A-2006-299428, and JP-A-2006-299438; the blue scale discoloration evaluation after photoirradiation by using a xenon light source or a carbon arc light source described in JP-A-6-228816, JP-A-7-76580, JP-A-8-188921, JP-A-11-247028, JP-A-11-247027, JP-A-2000-144583, JP-A-2002-322360, JP-A-2003-339503, and JP-A-2004-11062; the UV-blocking rate evaluation described in JP-A-2003-147617; the ultraviolet-blocking property evaluation described in JP-A-2003-41434; the blue scale discoloration evaluation after dry cleaning and after irradiation by using a carbon arc light source described in JP-A-11-302982; the evaluation of lightness index and color difference ΔE* according to chromaticness index after irradiation by using a Fade-O-meter described in JP-A-7-119036 and JP-A-10-251981; the tensile strength evaluation after photoirradiation by using a UV tester or Sunshine Weather Meter described in JP-A-9-57889, JP-A-9-137335, JP-A-10-1868, and JP-A-10-237760; the total transmission and strength retention evaluation described in JP-A-8-41785 and JP-A-8-193136; the ultraviolet protection factor (UPF) evaluation described in JP-T-2003-528974, JP-T-2005-517822, and JP-A-8-20579; the discoloration gray scale evaluation after irradiation by using a high-temperature fade meter described in JP-A- 6-228818, JP-A-7-324283, JP-A-7-196631, and JP-A-7-18584; the appearance evaluation after external photoirradiation described in JP-A-7-289097; the evaluation of yellowness index (YI) and yellowing degree (ΔYI) after ultraviolet irradiation described in JP-A-7-289665; the reflection evaluation described in JP-T-2003-528974; and the like.

The light stability of the construction material can be evaluated according to the method of JIS-A1415:1999 or a method referring to that. Specific examples thereof include the surface color tone evaluation after photoirradiation by using Sunshine Weather-O-Meter described in JP-A-2006-266402; the appearance evaluation after irradiation by using a carbon arc light source, the post-irradiation appearance evaluation by using an Eye Super UV Tester, the post-irradiation absorbance evaluation, the post-irradiation chromaticity and color difference evaluation, and the evaluation by using the color difference ΔEa*b* of CIE L*a*b* color coordinates and brilliance retention rate after photoirradiation by using a metal halide lamp light source described in JP-A-2004-3191 and JP-A-2006-306020; the evaluation of the change in haze value after photoirradiation by using Sunshine Weather Meter, and the elongation retention rate after photoirradiation by using a tensile test machine described in JP-A-10-44352, JP-A-2003-211538, JP-A-9-239921, JP-A-9-254345, and JP-A-2003-211606; the evaluation of ultraviolet transmittance after solvent dipping and the visual evaluation of post-irradiation appearance by using an Eye Super UV Tester described in JP-A-2002-161158; the evaluation of brilliance change after a QUV test described in JP-A-2002-226764; the brilliance retention rate evaluation after irradiation by using Sunshine Weather-O-Meter described in JP-A-2001-172531; the evaluation by using the color difference ΔEa*b* after ultraviolet irradiation by using a black light blue fluorescent lamp described in JP-A-11-300880; the evaluation of post-irradiation adhesion retention rate and ultraviolet-blocking property by using a UVCON acceleration test machine described in JP-A-10-205056; the appearance evaluation, the total light transmittance evaluation, the haze change evaluation, and tensile shear adhesive strength evaluation after external exposure (JIS-A1410) described in JP-A-8-207218 and JP-A-9-183159; the evaluation of total light transmittance of the light in the entire wavelength range, the haze evaluation, and the yellowing degree evaluation after irradiation by using a xenon weather meter described in JP-A-8-151457; the evaluation of yellowing degree (ΔYI) and ultraviolet absorbent residual ratio after irradiation by using

Sunshine Weather-O-Meter described in JP-A-7-3955; and the like.

The light stability when the polymer material is used in the recording medium application can be evaluated according to the method of JIS-K7350 or a method referring to that. Specific examples thereof include the evaluation of the difference in base color in the printing unit after fluorescent lamp irradiation described in JP-A-2006-167996; the evaluation of image density residual rate after irradiation by using a xenon weather meter described in JP-A-10-203033 and JP-A-2004-181813; the evaluation of the change in optical reflection density after irradiation by using a xenon weather meter described in JP-A-2002-207845; the yellowing degree evaluation based on the L*a*b* evaluation system after irradiation by using a Suntest CPS photodiscoloration tester described in JP-A-2003-266926; the post-irradiation discoloration evaluation by using a fade meter described in JP-A-2003-145949; the visual evaluation of post-irradiation discoloration by using a xenon fade meter described in JP-A-2002-212237; the color density retention rate evaluation after indoor sunlight irradiation and the post-irradiation color density retention rate evaluation by using a xenon weather meter described in JP-A-2002-178625; the evaluation of post-exposure C/N by using a fade meter described in JP-A-2002-367227; the fog density evaluation after fluorescent lamp irradiation described in JP-A-2001-249430; the optical reflection density evaluation and the erasability evaluation after irradiation by using a fluorescent lamp described in JP-A-9-95055; the evaluation of post-irradiation color difference $\Delta E^*$ by using an Atlas fade meter described in JP-A-9-309260; the visual evaluation of post-irradiation discoloration by using a carbon arc fade meter described in JP-A-8-258415; the evaluation of the retention rate of organic EL element color-changing property described in JP-A-2000-223271; the measurement and evaluation of organic EL display brightness after photoirradiation by a xenon discoloration tester described in JP-A-2005-189645; and the like.

Other evaluation methods include those of JIS-K7103 and ISO/DIS9050 or a method referring to those. Specific examples thereof include the appearance evaluation of a polycarbonate coating film after irradiation by a UV tester described in JP-A-2006-89697; the blue scale evaluation of a synthetic hair after irradiation with ultraviolet light described in JP-A-2006-316395; the evaluation of water contact angle on a test cloth after irradiation by using an accelerated weather-resistance test machine described in JP-A-2006-335855; the evaluation of a visual image projected on a projection screen after irradiation by using a weather-resistance test machine described in JP-A-2005-55615; the evaluation of the deterioration of sample surface and visual evaluation of ornamental change after irradiation by using a Sunshine Weather Meter or a metal weather meter described in JP-A-2005-74735; the visual evaluation of appearance after photoirradiation by using a metal lamp reflector described in JP-A-2005-326761; the evaluation of the light transmittance of bottle label described in JP-A-2002-189415 and JP-A-2004-352847; the evaluation of polypropylene deterioration after irradiation by using a xenon weather meter under humid condition described in JP-A-2003-19776; the evaluation of the deterioration of a hard-coat film, the deterioration evaluation, the hydrophilicity evaluation and the abrasion resistance evaluation of the base material by using Sunshine Weather-O-Meter described in JP-A-2002-36441 and JP-A-2003-25478; the evaluation of the gray scale color difference of synthetic leather after irradiation by using a xenon lamp light described in JP-A-2003-239181; the evaluation of liquid crystal device characteristics after irradiation by using a mercury lamp described in JP-A-2003-253265; the post-irradiation adhesiveness evaluation by using Sunshine Weather-O-Meter described in JP-A-2002-307619; the evaluation of the degree of turf purpura described in JP-A-2002-293706; the evaluation of ultraviolet light transmittance and tensile strength after irradiation by using a xenon arc light source described in JP-A-2002-114879; the concrete adhesion velocity evaluation described in JP-A-2001-139700; the appearance evaluation and the coated-film adhesiveness evaluation after irradiation by using Sunshine Weather-O-Meter described in JP-A-2001-315263; the evaluation of post-irradiation yellowing degree and adhesiveness by using a carbon arc light source described in JP-A-2001-214121 and JP-A-2001-214122; the adhesiveness evaluation by using an ultraviolet fade meter described in JP-A-2001-207144; the evaluation of insect-repellency when illumination is turned on described in JP-A-2000-67629; the evaluation of the laminated glass yellowing degree ($\Delta YI$) by using an Eye Super UV Tester described in JP-A-10-194796; the evaluation of the surface appearance and brilliance retention rate after QUV irradiation and humidity-resistance tests described in JP-A-8-318592; the evaluation of color difference with time by using a dew panel light control weather meter described in JP-A-8-208976; the evaluation of the glossiness (DI) and the yellowness index (YI) in the wood base-coated state after irradiation by using a xenon Weather-O-meter described in JP-A-7-268253; the ultraviolet absorbance evaluation after repeated processing of UV irradiation and storage in dark described in JP-T-2002-5443265 and JP-T-2002-543266; the evaluation of dye discoloration color difference $\Delta E$ after ultraviolet irradiation described in JP-T-2004-532306; and the like.

According to the present invention, it is possible to provide an ultraviolet absorbent composition that has improved solubility of both ultraviolet absorbent and stabilizer to their media, thereby causing no bleed out owing to a long-term use, and that is excellent in a long-wavelength ultraviolet absorption capability as well as storage stability for a long period of time.

The ultraviolet absorbent composition of the present invention has excellent advantages that there is no occurrence of both deposition of the ultraviolet absorbent and bleed out owing to a long-term use, and ultraviolet absorption capability is excellent over a long period of time, and in addition there is no absorption in a visible range.

EXAMPLES

The present invention will be described in more detail based on the following examples, but the invention is not intended to be limited thereby.

Example 1

(Preparation of Ultraviolet Absorbent Composition-containing Polymer Film)

Exemplified compound (S-01) was added to 50 g of polyethylene terephthalate so that transmittance at 400 nm is 1% at the time of 50 μm film production. Further, to the polyethylene terephthalate mixture, exemplified compound (TI-56) was added at a mass ratio of 1:1. After melt-kneading at 275°C, followed by cooling and centrifuging, UV agent-containing film (sample 1) was prepared. Similarly, sample films were prepared in accordance with combinations of the ultraviolet absorbents and exemplified compounds and mass ratio shown in Table 4 set forth below. Further, in the same way, sample films were prepared by using comparative compound (TX-1), (TX-2), or (TX-3), and in accordance with the compositions constructed of combinations shown in the following Table 4.
[Table 4]

Table 4

| Sample No. | Ultraviolet absorbent | Compound | Mass ratio | Remarks | Residual amount (%) |
|---|---|---|---|---|---|
| 1 | S-01 | TI-56 | 1:1 | This invention | 94 |
| 2 | S-01 | TI-56 | 1:3 | This invention | 94 |
| 3 | S-01 | TI-56 | 4:1 | This invention | 89 |
| 4 | S-17 | TII-30 | 1:1 | This invention | 93 |
| 5 | S-06 | TI-57 | 1:1 | This invention | 92 |
| 6 | S-01 | TII-25 | 1:1 | This invention | 94 |
| 7 | S-17 | TII-30 | 1:1 | This invention | 93 |
| 8 | 73 | TI-56 | 1:1 | This invention | 91 |
| 9 | 82 | TI-57 | 1:1 | This invention | 92 |
| 10 | 73 | TII-25 | 1:1 | This invention | 91 |
| 11 | 82 | TII-30 | 1:1 | This invention | 89 |
| 12 | S-01 | - | - | Comparative example | 78 |
| 13 | - | TII-25 | - | Comparative example | - |
| 14 | S-01 | TX-1 | 1:1 | Comparative example | 92 |
| 15 | S-01 | TX-2 | 1:1 | Comparative example | 94 |
| 16 | S-01 | TX-3 | 1:1 | Comparative example | 93 |
| 17 | 82 | - | - | Comparative example | 76 |
| 18 | - | TII-25 | - | Comparative example | - |
| 19 | 82 | TX-1 | 1:1 | Comparative example | 92 |
| 20 | 82 | TX-2 | 1:1 | Comparative example | 91 |
| 21 | 82 | TX-3 | 1:1 | Comparative example | 89 |

[Chemical formula 62]

(TX-1) 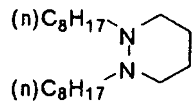 (TX-2) 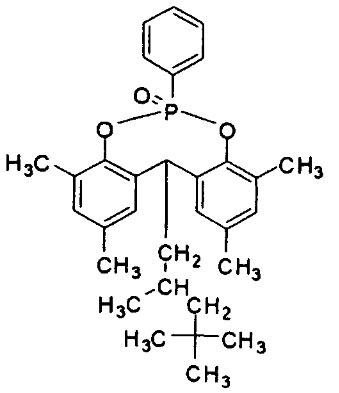 (TX-3) 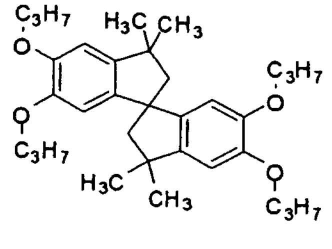

Each of these sample films was photoirradiated by a xenon lamp at an illuminance of 170,000 lux for 40 hours, and the residual amount of the ultraviolet absorbent after irradiation was determined. The residual amount was calculated according to the following Formula:

$$\text{Residual amount (\%)} = 100 \times (100 - \text{Transmittance after irradiation})/(100 - \text{Transmittance before irradiation})$$

Herein, the transmittance in the light toughness test is a value measured at 425 nm. The results are shown in Table 4. The residual amount of each of samples 13 and 18 in Table 4 was not measured because these samples contain no ultraviolet absorbent.

As is apparent from the results in Table 4, it is understood that light toughness of each of samples 12 and 17 each free of the compound represented by the formula (TS-I) or (TS-II) is less than 80% in terms of residual ratio of the ultraviolet absorbent, whereas in each of the samples 1 to 11 of the present invention, the residual ratio of the ultraviolet absorbent in the ultraviolet absorbent composition is high.

In addition, it is found that even in the samples 14 to 16 and 19 to 21 each containing the comparative compound that does not fall within the formula (TS-I) or (TS-II), the residual ratio of the ultraviolet absorbent is also high. However, these samples caused coloring as shown in the below-described Examples 2 and 4. Further, these samples were inferior in compatibility as shown in the below-described Example 5.

Example 2

(Preparation of molded plates 1011 to 120)

One (1) kg of a polymethyl methacrylate resin (PMMA) and 0.1 g of the composition sample 1 were agitated in a stainless steel tumbler for 1 hour. The resultant mixture was melted and blended by a vent extruder at 230°C and extruded into pellets for molding by an ordinary method. The pellets were dried at 80°C for 3 hours, and then, molded into molded plate 101 having a thickness of 3 mm by an injection molding machine.

Molded plates 102 to 111 were prepared in a similar manner to the molded plate 101, except that the composition sample 1 was replaced with each of the composition samples 2 to 11 in preparation of the molded plate 101.

Alternatively, molded plates 112, 114, 115, 117, 119 and 120 were prepared in a similar manner to the molded plate 101, except that the composition sample 1 was replaced with each of the composition samples 12, 14, 15, 17, 19 and 20 respectively in preparation of the molded plate 101.

(Evaluation)

The photo-irradiated molded plates were visually observed, and evaluated according to the following criterion:

○: No coloration is observed
Δ: A little coloration is observed
×: Coloration is apparently observed

The thus-obtained results are shown in Table 5.
[Table 5]

Table 5

| Molded plate No. | Sample No. | Visual observation | Remarks |
|---|---|---|---|
| 101 | 1 | ○ | This invention |
| 102 | 2 | ○ | This invention |
| 103 | 3 | ○ | This invention |
| 104 | 4 | ○ | This invention |
| 105 | 5 | ○ | This invention |
| 106 | 6 | ○ | This invention |
| 107 | 7 | ○ | This invention |
| 108 | 8 | ○ | This invention |
| 109 | 9 | ○ | This invention |
| 110 | 10 | ○ | This invention |
| 111 | 11 | ○ | This invention |
| 112 | 12 | ○ | Comparative example |
| 114 | 14 | Δ~× | Comparative example |
| 115 | 15 | × | Comparative example |
| 117 | 17 | ○ | Comparative example |
| 119 | 19 | Δ~× | Comparative example |
| 120 | 20 | × | Comparative example |

As is apparent from the results of Table 5, it is understood that when the comparative compounds that do not fall within the formula (TS-I) or (TS-II) are used, coloration occurs.

Example 3

(Preparation of PET films 201 to 211)

A transparent coating consisting of 100 g of DIANAL LR-1065 (trade name, manufactured by Mitsubishi Rayon Co., 40% methylethylketone (MEK) solution of an acrylic resin) and 0.5 g of the composition sample 1 was applied on a 100 μm polyethylene terephthalate (PET) film to be a dry film thickness of approximately 30 μm with a bar coater, and dried to give PET film 201 having an ultraviolet-absorbing layer.
PET films 202 to 208 were prepared in a similar manner to the PET film 201, except that the composition sample 1 was replaced with each of the composition samples 2 to 8 respectively in preparation of the PET film 201.
Alternatively, PET films 213 and 218 were prepared in a similar manner to the PET film 201, except that the composition sample 1 was replaced with the composition sample 13 or 18 in preparation of the PET film 201.

(Evaluation)

A solid image in magenta color was printed on an inkjet-recording paper and dried sufficiently by using an inkjet printer (PIXUS iP1500, trade name, manufactured by Canon), and the PET film prepared above was superposed and fixed thereon so that the ultraviolet-absorbing layer is the outermost layer. The film was adhered to a southward window glass with its PET film facing the light and left as it was for 12 weeks for a light-resistance test.
Significant discoloration was confirmed in the comparative PET films 213 and 218 by visual observation. In contrast, each of the PET films 201 to 208 having the ultraviolet-absorbing layer containing each of the ultraviolet absorbent composition samples 1 to 8 according to the present invention retained a color tone almost similar to that immediately after printing. It is understood that the polymer material according to the present invention containing the

ultraviolet absorbent composition according to the present invention is also excellent as an ultraviolet-absorbing film for protection of a light-labile compound for an extended period of time.

Example 4

(Preparation of PET Film (Samples 301 to 304))

Samples in which 1 g of each of the composition samples 5, 9, 14, and 19 was added to 150 g of polyethylene terephthalate were kneaded respectively at 270°C by means of MiniLab melt-kneading machine manufactured by Haake. After that, these samples were pressed at 270°C by means of a hot press machine to give PET film samples 301 to 304. The thus-prepared PET films were visually observed, and evaluated according to the following criterion:

○: No coloration is observed
Δ to ×: Coloration is observed

The thus-obtained results are shown in Table 6.
[Table 6]

Table 6

| Sample No. | External appearance (coloring) | Remarks |
|---|---|---|
| 301 | ○ | This invention |
| 302 | ○ | This invention |
| 303 | × | Comparative example |
| 304 | × | Comparative example |

As is apparent from the results in Table 6, it is understood that coloration caused by heat can be inhibited in samples 301 and 302 of the present invention, whereas coloration caused by heat cannot be inhibited, which results in occurrence of coloration, in comparative samples 303 and 304.

Example 5

(Evaluation of Compatibility with Acrylic Resin)

Transparent coating samples in which 25 g of each of the composition samples 1 to 21 was added to 200 g of DIANAL LR-1065 (trade name, manufactured by Mitsubishi Rayon Co., 40% methylethylketone (MEK) solution of an acrylic resin) were coated on an 80 μm-polyethylene terephthalate (PET) film to be a dry film thickness of approximately 30 μm with a bar coater, and dried to give PET films (samples 401 to 421) each having an ultraviolet absorbing layer. The thus-prepared PET films were visually observed to evaluate compatibility.
In the below-described Table 7, "○" denotes a clear film, "Δ"denotes a film in which granular powder is slightly observed on the surface, and "×" denotes a film in which granular powder is apparently observed on the surface.
[Table 7]

Table 7

| Sample No. | External appearance (Compatibility) | Remarks |
|---|---|---|
| 401 | ◎ | This invention |
| 402 | ○ | This invention |
| 403 | ○ | This invention |
| 404 | ○ | This invention |
| 405 | ○ | This invention |
| 406 | ◎ | This invention |
| 407 | ◎ | This invention |

(continued)

| Sample No. | External appearance (Compatibility) | Remarks |
|---|---|---|
| 408 | ○ | This invention |
| 409 | ○ | This invention |
| 410 | ◎ | This invention |
| 411 | ◎ | This invention |
| 412 | Δ~○ | Comparative example |
| 413 | ×~Δ | Comparative example |
| 414 | Δ | Comparative example |
| 415 | ×~Δ | Comparative example |
| 416 | × | Comparative example |
| 417 | Δ~○ | Comparative example |
| 418 | ×~Δ | Comparative example |
| 419 | ×~Δ | Comparative example |
| 420 | ×~Δ | Comparative example |
| 421 | × | Comparative example |

As is apparent from the results in Table 7, it is understood that samples 401 to 411 of the present invention are superior in compatibility with a resin to comparative samples 412 and 417 in each of which a single ultraviolet absorbent is used; comparative samples 413 and 418 in each of which a single compound is used, but the ultraviolet absorbent is not contained; and comparative samples 414 to 416 and 419 to 421 in each of which the comparative compound is contained. Especially, it is understood that when the mixing ratio of the ultraviolet absorbent represented by the formula (2) or (B-1), and the compound represented by the formula (TS-I) or (TS-II) is 1:1, the resin has more uniform surface on which no particles are observed (evaluation ◎). Further, it is understood that when a combination of the ultraviolet absorbent and the compound represented by the formula (TS-II), that is a more preferable embodiment of the present invention, is used, the resin has also more uniform surface on which no particles are observed (evaluation ◎).

Example 6

(Evaluation of Compatibility with Acrylic Resin)

Transparent coating samples in which 5 g or 25 g of the composition sample 1 was added to 100 g of DIANAL LR-1065 (trade name, manufactured by Mitsubishi Rayon Co., 40% methylethylketone (MEK) solution of an acrylic resin) were coated on an 80 μm-polyethylene terephthalate (PET) film to be a dry film thickness of approximately 30 μm with a bar coater, and dried to give PET films (samples 501 and 502) each having an ultraviolet absorbing layer. PET films each having an ultraviolet absorbing layer (samples 503 and 504) were prepared in the same manner, except that the composition sample 1 was replaced by the composition sample 16. The thus-prepared PET films were visually observed to evaluate compatibility.

In the below-described Table 8, "○" denotes a clear film, "Δ"denotes a film in which granular powder is slightly observed on the surface, and "×" denotes a film in which granular powder is apparently observed on the surface.

[Table 8]

Table 8

| Sample No. | External appearance (Compatibility) | Composition ratio to polymer | Remarks |
|---|---|---|---|
| 501 | ◎ | 5% | This invention |
| 502 | ◎ | 25% | This invention |
| 503 | × | 5% | Comparative example |

(continued)

| Sample No. | External appearance (Compatibility) | Composition ratio to polymer | Remarks |
|---|---|---|---|
| 504 | × to ×× | 25% | Comparative example |

As is apparent from the results in Table 8, it is understood that the ultraviolet absorbent composition of the present invention, when the proportion of which is 5 % in the polymer, gives the PET film (sample 501) in which no granular powder is observed on the surface (evaluation ◎). Further, it is understood that the sample 502 having an increased proportion of the ultraviolet absorbent composition (the proportion of the ultraviolet absorbent composition in the polymer is 25%), thereby enhancing ultraviolet-shielding capacity, also forms a film in which no bleed out is observed. In contrast, when the composition using the comparative compound not belonging to the present invention was mixed in a polymer, granular powder was observed on the polymer surface in spite of a low concentration (sample 503, evaluation x). Further, the high concentration of the ultraviolet absorbent composition gave a more powder-deposited film (sample 504, evaluation ××).

INDUSTRIAL APPLICABILITY

The ultraviolet absorbent compositions of the present invention are applicable for all uses in which a synthetic resin is used. Especially, they are suitable for the use in which there is a possibility that they are exposed to light including sun light or ultraviolet. Specifically, it can be preferably used for packaging materials, containers, coatings, coated films, ink, fiber, construction materials, recording mediums, image display devices and solar cell cover.

This application claims priority on Patent Application No. 2007-93061 filed in Japan on March 30, 2007, and Patent Application No. 2007-213951 filed in Japan on August 20, 2007.

## Claims

1. An ultraviolet absorbent composition, comprising at least one of ultraviolet absorbent represented by formula (2) or (B-I), and at least one of compound represented by formula (TS-I) or (TS-II):

[Chemical formula 1]

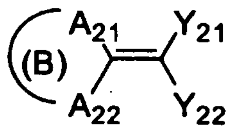

Formula (2)

wherein $A_{21}$ and $A_{22}$ each represent a hetero atom; $Y_{21}$ and $Y_{22}$ each independently represent a hydrogen atom or a monovalent substituent; at least one of $Y_{21}$ and $Y_{22}$ represents a substituent having a Hammett substituent constant σp of 0.2 or more; $Y_{21}$ and $Y_{22}$ may bind to each other to form a ring; and (B) represents a group of atoms necessary for forming a five- or six-membered ring with $A_{21}$, $A_{22}$ and the carbon atom;

[Chemical formula 2]

Formula (B－I)

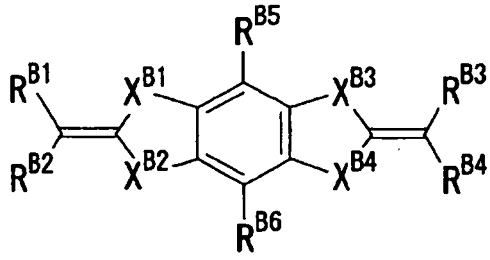

wherein $R^{B1}$, $R^{B2}$, $R^{B3}$ and $R^{B4}$ each independently represent a hydrogen atom or a monovalent substituent; $R^{B5}$ and $R^{B6}$ each independently represent a hydrogen atom or a monovalent substituent; and $X^{B1}$, $X^{B2}$, $X^{B3}$ and $X^{B4}$ each independently represent a hetero atom;

[Chemical formula 3]

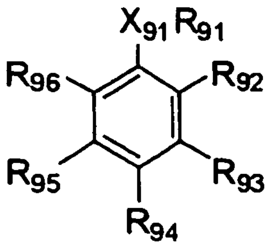

(TS-I)

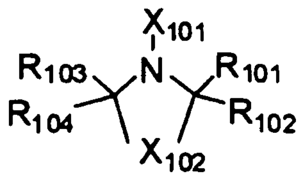

(TS-II)

wherein, in formula (TS-I), $R_{91}$ represents a hydrogen atom, a substituted or unsubstituted alkyl group, a substituted or unsubstituted alkenyl group, a substituted or unsubstituted aryl group, a substituted or unsubstituted heterocyclic group, a substituted or unsubstituted acyl group, a substituted or unsubstituted alkyl- or alkenyl-oxycarbonyl group, a substituted or unsubstituted aryloxycarbonyl group, a substituted or unsubstituted alkyl sulfonyl group, a substituted or unsubstituted arylsulfonyl group, or $-Si(R_{97})(R_{98})(R_{99})$, in which $R_{97}$, $R_{98}$, and $R_{99}$, which may be the same as or different from each other, each independently represent an alkyl group, an alkenyl group, an aryl group, an alkoxy group, an alkenyloxy group, or an aryloxy group; $-X_{91}-$ represents -O-, -S-, or $-N(-R_{100})-$, in which $R_{100}$ has the same meaning as $R_{91}$; $R_{92}$, $R_{93}$, $R_{94}$, $R_{95}$ and $R_{96}$, which may be the same as or different from each other, each independently represent a hydrogen atom or a substituent; and all of $R_{91}$, $R_{92}$, $R_{93}$, $R_{94}$, $R_{95}$, $R_{96}$ and $R_{100}$ cannot simultaneously represent a hydrogen atom, respectively, and the total number of carbon atoms is 10 or more; and wherein, in formula (TS-II), $R_{101}$, $R_{102}$, $R_{103}$, and $R_{104}$ each independently represent a hydrogen atom, a substituted or unsubstituted alkyl group, or a substituted or unsubstituted alkenyl group; each combination of $R_{101}$ and $R_{102}$, and/or $R_{103}$ and $R_{104}$ may bind to each other to form a 5- to 7-membered ring; $X_{101}$, represents a hydrogen atom, a substituted or unsubstituted alkyl group, a substituted or unsubstituted alkenyl group, a substituted or unsubstituted alkoxy group, a substituted or unsubstituted alkenyloxy group, a substituted or unsubstituted alkyl- or alkenyl-oxycarbonyl group, a substituted or unsubstituted aryloxycarbonyl group, a substituted or unsubstituted acyl group, a substituted or unsubstituted acyloxy group, a substituted or unsubstituted alkyloxycarbonyloxy group, a substituted or unsubstituted alkenyloxycarbonyloxy group, a substituted or unsubstituted aryloxycarbonyloxy group, a substituted or unsubstituted alkyl- or alkenyl-sulfonyl group, a substituted or unsubstituted arylsulfonyl group, a substituted or unsubstituted alkyl- or alkenyl-sulfinyl group, a substituted or unsubstituted arylsulfinyl group, a substituted or unsubstituted sulfamoyl group, a substituted or unsubstituted carbamoyl group, a hydroxy group or an oxy radical group; and $X_{102}$ represents a group of hetero atoms necessary for forming a 5- to 7-membered ring;
wherein the total content of the ultraviolet absorbent represented by formula (2) or (B-1) is more than 0% by mass and 80% by mass or less of the composition in all.

2. The ultraviolet absorbent composition according to claim 1, wherein the ultraviolet absorbent represented by formula (2) is an ultraviolet absorbent represented by formula (3):

[Chemical formula 4]

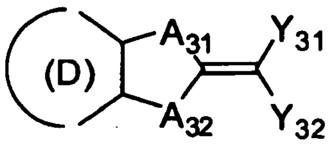

Formula (3)

wherein $A_{31}$ and $A_{32}$ each independently represent a hetero atom selected from the group consisting of an oxygen atom, a nitrogen atom and a sulfur atom; $Y_{31}$ and $Y_{32}$ each independently represent a hydrogen atom or a monovalent substituent; at least one of $Y_{31}$ and $Y_{32}$ represents a substituent having a Hammett substituent constant $\sigma p$ of 0.2 or more; $Y_{31}$ and $Y_{32}$ may bind to each other to form a ring; and (D) represents a group of atoms necessary for forming a five- or six-membered ring with the carbon atoms.

3. The ultraviolet absorbent composition according to claim 2, wherein the ultraviolet absorbent represented by formula (3) is an ultraviolet absorbent represented by formula (4):

[Chemical formula 5]

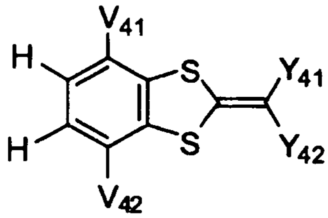

Formula (4)

wherein $Y_{41}$ and $Y_{42}$ each independently represent a monovalent substituent; at least one of $Y_{41}$ and $Y_{42}$ represents a cyano group, and the other represents a substituted or unsubstituted alkylcarbonyl group, a substituted or unsubstituted arylcarbonyl group, a substituted or unsubstituted heterocyclic carbonyl group, a substituted or unsubstituted alkylsulfonyl group, or a substituted or unsubstituted arylsulfonyl group; and $V_{41}$ and $V_{42}$ each independently represent a hydrogen atom or a monovalent substituent.

4. The ultraviolet absorbent composition according to claim 1, wherein the ultraviolet absorbent represented by formula (B-I) is an ultraviolet absorbent represented by formula (B-Ia):

[Chemical formula 6]

Formula (B-Ia)

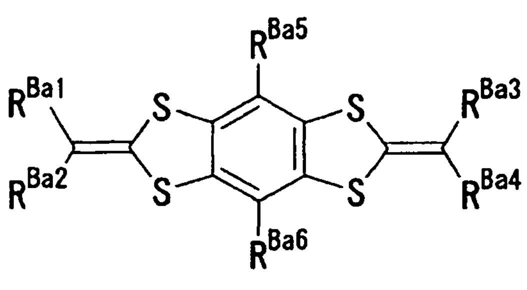

wherein $R^{Ba1}$, $R^{Ba2}$, $R^{Ba3}$ and $R^{Ba4}$ each independently represent a monovalent substituent; at least one of $R^{Ba1}$,

$R^{Ba2}$, $R^{Ba3}$ and $R^{Ba4}$ represents a cyano group, a substituted or unsubstituted alkoxycarbonyl group, a substituted or unsubstituted aryloxycarbonyl group, a substituted or unsubstituted carbamoyl group, a substituted or unsubstituted alkylcarbonyl group, a substituted or unsubstituted arylcarbonyl group, a substituted or unsubstituted alkylsulfonyl group, or a substituted or unsubstituted arylsulfonyl group, and the others are a cyano group, a substituted or unsubstituted carbamoyl group, a substituted or unsubstituted sulfamoyl group, a nitro group, a substituted or unsubstituted acyl group, a substituted or unsubstituted alkylsulfonyl group, a substituted or unsubstituted arylsulfonyl group, a substituted or unsubstituted alkylsulfinyl group, a substituted or unsubstituted arylsulfinyl group, a substituted or unsubstituted alkoxycarbonyl group, a substituted or unsubstituted aryloxycarbonyl group, a substituted or unsubstituted alkyl group, a substituted or unsubstituted aryl group, or a substituted or unsubstituted heterocyclic group; and $R^{Ba5}$ and $R^{Ba6}$ each independently represent a substituted or unsubstituted alkoxy group, a substituted or unsubstituted aryloxy group, a substituted or unsubstituted acyloxy group, a substituted or unsubstituted alkoxycarbonyloxy group, a substituted or unsubstituted aryloxycarbonyloxy group, a substituted or unsubstituted carbamoyloxy group, a substituted or unsubstituted amino group, a substituted or unsubstituted acylamino group, or a substituted or unsubstituted carbamoylamino group.

5. The ultraviolet absorbent composition according to any one of claims 1 to 4, wherein the total content of the compound represented by formula (TS-I) or (TS-II) is more than 0% by mass and 80% by mass or less of the composition in all.

6. The ultraviolet absorbent composition according to any one of claims 1 to 5, wherein a mixing ratio of the ultraviolet absorbent represented by formula (2) or (B-1) and the compound represented by formula (TS-I) or (TS-II) is 1:5 to 5:1.

7. The ultraviolet absorbent composition according to any one of claims 1 to 6, comprising the compound represented by formula (TS-II).

8. The ultraviolet absorbent composition according to any one of claims 1 to 7, wherein the compound represented by formula (TS-II) is a compound represented by formula (TS-IIa):

[Chemical formula 7]

Formula (TS-IIa)

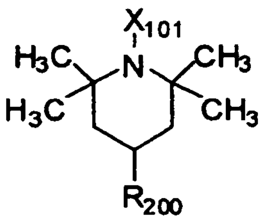

wherein $X_{101}$ represents a hydrogen atom, a substituted or unsubstituted alkyl group, a substituted or unsubstituted alkenyl group, a substituted or unsubstituted alkoxy group, a substituted or unsubstituted alkenyloxy group, a substituted or unsubstituted alkyl- or alkenyl-oxycarbonyl group, a substituted or unsubstituted aryloxycarbonyl group, a substituted or unsubstituted acyl group, a substituted or unsubstituted acyloxy group, a substituted or unsubstituted alkyloxycarbonyloxy group, a substituted or unsubstituted alkenyloxycarbonyloxy group, a substituted or unsubstituted aryloxycarbonyloxy group, a substituted or unsubstituted alkyl- or alkenyl-sulfonyl group, a substituted or unsubstituted arylsulfonyl group, a substituted or unsubstituted alkyl- or alkenyl-sulfinyl group, a substituted or unsubstituted arylsulfinyl group, a substituted or unsubstituted sulfamoyl group, a substituted or unsubstituted carbamoyl group, a hydroxy group or an oxy radical group; and $R_{200}$ represents a monovalent substituent.

9. An ultraviolet absorbent dispersion, comprising the ultraviolet absorbent composition according to any one of claims 1 to 8.

10. An ultraviolet absorbent solution, comprising the ultraviolet absorbent composition according to any one of claims 1 to 8.

11. A polymer material, comprising the ultraviolet absorbent composition according to any one of claims 1 to 8.

## Patentansprüche

1. Ultraviolettabsorptionsmittelzusammensetzung, umfassend mindestens eines der Ultraviolettabsorptionsmittel, die durch Formel (2) oder (B-1) wiedergegeben sind, und mindestens eine der Verbindungen, die durch Formel (TS-1) oder (TS-II) wiedergegeben sind:

[Chemische Formel 1]

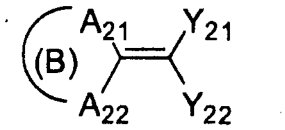

Formel (2)

wobei $A_{21}$ und $A_{22}$ jeweils ein Heteroatom bedeuten; $Y_{21}$ und $Y_{22}$ jeweils unabhängig voneinander ein Wasserstoffatom oder einen einwertigen Substituenten bedeuten; mindestens eines von $Y_{21}$ und $Y_{22}$ einen Substituenten mit einer Hammett-Substituentenkonstante $\sigma$ von 0,2 oder mehr bedeutet; $Y_{21}$ und $Y_{22}$ unter Bildung eines Rings aneinander gebunden sein können; und (B) eine Gruppe von Atomen bedeutet, die zum Bilden eines fünf- oder sechs-gliedrigen Rings mit $A_{21}$, $A_{22}$ und dem Kohlenstoffatom erforderlich ist;

[Chemische Formel 2]

Formel (B-I)

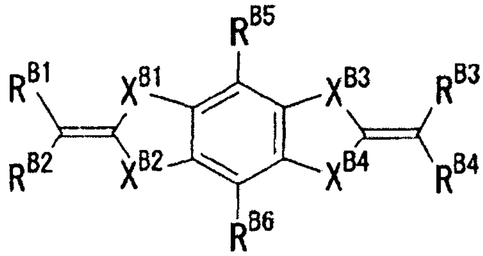

wobei $R^{B1}$, $R^{B2}$, $R^{B3}$ und $R^{B4}$ jeweils unabhängig voneinander ein Wasserstoffatom oder einen einwertigen Substituenten bedeuten; $R^{B5}$ und $R^{B6}$ jeweils unabhängig voneinander ein Wasserstoffatom oder einen einwertigen Substituenten bedeuten; und $X^{B1}$, $X^{B2}$, $X^{B3}$ und $X^{B4}$ jeweils unabhängig voneinander ein Heteroatom bedeuten;

[Chemische Formel 3]

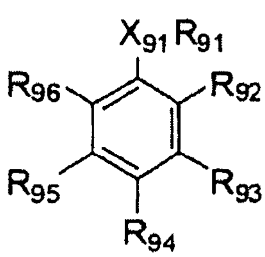

(TS-I)

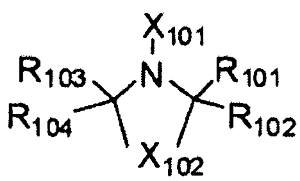

(TS-II)

wobei, in Formel (TS-I), $R_{91}$ ein Wasserstoffatom, eine substituierte oder unsubstituierte Alkylgruppe, eine substituierte oder unsubstituierte Alkenylgruppe, eine substituierte oder unsubstituierte Arylgruppe, eine substituierte oder unsubstituierte heterocyclische Gruppe, eine substituierte oder unsubstituierte Acylgruppe, eine substituierte oder unsubstituierte Alkyl- oder Alkenyl-oxycarbonylgruppe, eine substituierte oder unsubstituierte Aryloxycarbonylgruppe, eine substituierte oder unsubstituierte Alkylsulfonylgruppe, eine substituierte oder unsubstituierte Arylsulfonyl-

gruppe oder -Si($R_{97}$)($R_{9e}$)($R_{99}$) bedeutet, in welcher $R_{97}$, $R_{98}$ und $R_{99}$, welche gleich oder voneinander verschieden sein können, jeweils unabhängig voneinander eine Alkylgruppe, eine Alkenylgruppe, eine Arylgruppe, eine Alkoxygruppe, eine Alkenyloxygruppe oder eine Aryloxygruppe bedeuten; -$X_{91}$- -O-, -S- oder -N(-$R_{100}$)- bedeutet, in welchem $R_{100}$ die gleiche Bedeutung wie $R_{91}$ hat; $R_{92}$, $R_{93}$, $R_{94}$, $R_{95}$ und $R_{96}$, welche gleich oder voneinander verschieden sein können, jeweils unabhängig voneinander ein Wasserstoffatom oder einen Substituenten bedeuten; und alle von $R_{91}$, $R_{92}$, $R_{93}$, $R_{94}$, $R_{95}$, $R_{96}$ und $R_{100}$ nicht gleichzeitig ein Wasserstoffatom bedeuten können, und die Gesamtzahl der Kohlenstoffatome 10 oder mehr beträgt; und

wobei, in Formel (TS-II), $R_{101}$, $R_{102}$, $R_{103}$ und $R_{104}$ jeweils unabhängig voneinander ein Wasserstoffatom, eine substituierte oder unsubstituierte Alkylgruppe oder eine substituierte oder unsubstituierte Alkenylgruppe bedeuten; jede Kombination von $R_{101}$ und $R_{102}$, und/oder $R_{103}$ und $R_{104}$ unter Bildung eines 5- bis 7-gliedrigen Rings aneinander gebunden sein können; $X_{101}$, ein Wasserstoffatom, eine substituierte oder unsubstituierte Alkylgruppe, eine substituierte oder unsubstituierte Alkenylgruppe, eine substituierte oder unsubstituierte Alkoxygruppe, eine substituierte oder unsubstituierte Alkenyloxygruppe, eine substituierte oder unsubstituierte Alkyl- oder Alkenyl-oxycarbonylgruppe, eine substituierte oder unsubstituierte Aryloxycarbonylgruppe, eine substituierte oder unsubstituierte Acylgruppe, eine substituierte oder unsubstituierte Acyloxygruppe, eine substituierte oder unsubstituierte Alkyloxycarbonyloxygruppe, eine substituierte oder unsubstituierte Alkenyloxycarbonyloxygruppe, eine substituierte oder unsubstituierte Aryloxycarbonyloxygruppe, eine substituierte oder unsubstituierte Alkyl- oder Alkenyl-sulfonylgruppe, eine substituierte oder unsubstituierte Arylsulfonylgruppe, eine substituierte oder unsubstituierte Alkyl- oder Alkenyl-sulfinylgruppe, eine substituierte oder unsubstituierte Arylsulfinylgruppe, eine substituierte oder unsubstituierte Sulfamoylgruppe, eine substituierte oder unsubstituierte Carbamoylgruppe, eine Hydroxygruppe oder eine Oxyradikalgruppe bedeutet; und $X_{102}$ eine Gruppe von Heteroatomen bedeutet, die zum Bilden eines 5- bis 7-gliedrigen Rings erforderlich ist;

wobei der Gesamtgehalt des Ultraviolettabsorptionsmittels, das durch Formel (2) oder (B-1) wiedergegeben ist, mehr als 0 Massenprozent und 80 Massenprozent oder weniger der gesamten Zusammensetzung beträgt.

**2.** Ultraviolettabsorptionsmittelzusammensetzung nach Anspruch 1, wobei das durch Formel (2) wiedergegebene Ultraviolettabsorptionsmittel ein Ultraviolettabsorptionsmittel ist, das durch Formel (3) wiedergegeben ist:

[Chemische Formel 4]

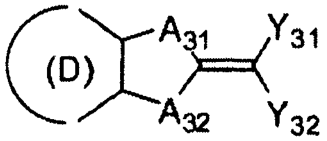

Formel (3)

wobei $A_{31}$ und $A_{32}$ jeweils unabhängig voneinander ein Heteroatom, ausgewählt aus der Gruppe bestehend aus einem Sauerstoffatom, einem Stickstoffatom und einem Schwefelatom, bedeuten; $Y_{31}$ und $Y_{32}$ jeweils unabhängig voneinander ein Wasserstoffatom oder einen einwertigen Substituenten bedeuten; wenigstens eines von $Y_3$, und $Y_{32}$ einen Substituenten mit einer Hammett-Substituentenkonstante $\sigma p$ von 0,2 oder mehr bedeutet, $Y_{31}$ und $Y_{32}$ unter Bildung eines Rings aneinander gebunden sein können; und (D) eine Gruppe von Atomen bedeutet, die zum Bilden eines fünf- oder sechs-gliedrigen Rings mit den Kohlenstoffatomen erforderlich ist.

**3.** Ultraviolettabsorptionsmittelzusammensetzung nach Anspruch 2, wobei das durch Formel (3) wiedergegebene Ultraviolettabsorptionsmittel ein Ultraviolettabsorptionsmittel ist, das durch Formel (4) wiedergegeben ist:

[Chemische Formel 5]

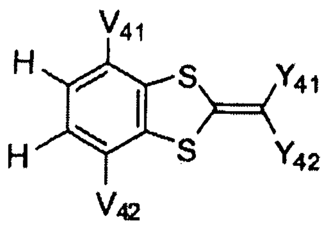

Formel (4)

wobei $Y_{41}$ und $Y_{42}$ jeweils unabhängig voneinander einen einwertigen Substituenten bedeuten; wenigstens eines von $Y_{41}$ und $Y_{42}$ eine Cyanogruppe bedeutet, und das andere eine substituierte oder unsubstituierte Alkylcarbonylgruppe, eine substituierte oder unsubstituierte Arylcarbonylgruppe, eine substituierte oder unsubstituierte heterocyclische Carbonylgruppe, eine substituierte oder unsubstituierte Alkylsulfonylgruppe oder eine substituierte oder unsubstituierte Arylsulfonylgruppe bedeutet; und $V_{41}$ und $V_{42}$ jeweils unabhängig voneinander ein Wasserstoffatom oder einen einwertigen Substituenten bedeuten.

4. Ultraviolettabsorptionsmittelzusammensetzung nach Anspruch 1, wobei das durch Formel (B-I) wiedergegebene Ultraviolettabsorptionsmittel ein Ultraviolettabsorptionsmittel ist, das durch Formel (B-Ia) wiedergegeben ist:

[Chemische Formel 6]

Formel (B-Ia)

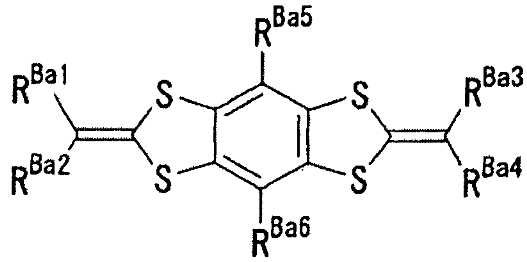

wobei $R^{Ba1}$, $R^{Ba2}$, $R^{Ba3}$ und $R^{Ba4}$ jeweils unabhängig voneinander einen einwertigen Substituenten bedeuten; wenigstens eines von $R^{Ba1}$, $R^{Ba2}$, $R^{Ba3}$ und $R^{Ba4}$ eine Cyanogruppe, eine substituierte oder unsubstituierte Alkoxycarbonylgruppe, eine substituierte oder unsubstituierte Aryloxycarbonylgruppe, eine substituierte oder unsubstituierte Carbamoylgruppe, eine substituierte oder unsubstituierte Alkylcarbonylgruppe, eine substituierte oder unsubstituierte Arylcarbonylgruppe, eine substituierte oder unsubstituierte Alkylsulfonylgruppe oder eine substituierte oder unsubstituierte Arylsulfonylgruppe bedeutet und die anderen eine Cyanogruppe, eine substituierte oder unsubstituierte Carbamoylgruppe, eine substituierte oder unsubstituierte Sulfamoylgruppe, eine Nitrogruppe, eine substituierte oder unsubstituierte Acylgruppe, eine substituierte oder unsubstituierte Alkylsulfonylgruppe, eine substituierte oder unsubstituierte Arylsulfonylgruppe, eine substituierte oder unsubstituierte Alkylsulfinylgruppe, eine substituierte oder unsubstituierte Arylsulfinylgruppe, eine substituierte oder unsubstituierte Alkoxycarbonylgruppe, eine substituierte oder unsubstituierte Aryloxycarbonylgruppe, eine substituierte oder unsubstituierte Alkylgruppe, eine substituierte oder unsubstituierte Arylgruppe oder eine substituierte oder unsubstituierte heterocyclische Gruppe sind; und $R^{Ba5}$ und $R^{Ba6}$ jeweils unabhängig voneinander eine substituierte oder unsubstituierte Alkoxygruppe, eine substituierte oder unsubstituierte Aryloxygruppe, eine substituierte oder unsubstituierte Acyloxygruppe, eine substituierte oder unsubstituierte Alkoxycarbonyloxygruppe, eine substituierte oder unsubstituierte Aryloxycarbonyloxygruppe, eine substituierte oder unsubstituierte Carbamoyloxygruppe, eine substituierte oder unsubstituierte Aminogruppe, eine substituierte oder unsubstituierte Acylaminogruppe oder eine substituierte oder unsubstituierte Carbamoylaminogruppe bedeuten.

5. Ultraviolettabsorptionsmittelzusammensetzung nach einem der Ansprüche 1 bis 4, wobei der Gesamtgehalt der durch Formel (TS-I) oder (TS-II) wiedergegebenen Verbindung mehr als 0 Massenprozent und 80 Massenprozent oder weniger der gesamten Zusammensetzung beträgt.

6. Ultraviolettabsorptionsmittelzusammensetzung nach einem der Ansprüche 1 bis 5, wobei ein Mischungsverhältnis des durch Formel (2) oder (B-1) wiedergegebenen Ultraviolettabsorptionsmittels und der durch Formel (TS-1) oder (TS-II) wiedergegebenen Verbindung 1:5 bis 5:1 beträgt.

7. Ultraviolettabsorptionsmittelzusammensetzung nach einem der Ansprüche 1 bis 6, umfassend die durch Formel (TS-II) wiedergegebene Verbindung.

8. Ultraviolettabsorptionsmittelzusammensetzung nach einem der Ansprüche 1 bis 7, wobei die durch Formel (TS-II) wiedergegebene Verbindung eine Verbindung ist, die durch Formel (TS-IIa) wiedergegeben ist:

[Chemische Formel 7]

Formel (TS-IIa)

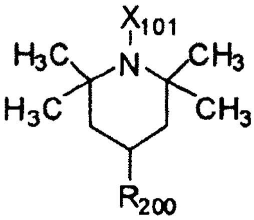

wobei $X_{101}$ ein Wasserstoffatom, eine substituierte oder unsubstituierte Alkylgruppe, eine substituierte oder unsubstituierte Alkenylgruppe, eine substituierte oder unsubstituierte Alkoxygruppe, eine substituierte oder unsubstituierte Alkenyloxygruppe, eine substituierte oder unsubstituierte Alkyl- oder Alkenyl-oxycarbonylgruppe, eine substituierte oder unsubstituierte Aryloxycarbonylgruppe, eine substituierte oder unsubstituierte Acylgruppe, eine substituierte oder unsubstituierte Acyloxygruppe, eine substituierte oder unsubstituierte Alkyloxycarbonyloxygruppe, eine substituierte oder unsubstituierte Alkenyloxycarbonyloxygruppe, eine substituierte oder unsubstituierte Aryloxycarbonyloxygruppe, eine substituierte oder unsubstituierte Alkyl- oder Alkenyl-sulfonylgruppe, eine substituierte oder unsubstituierte Arylsulfonylgruppe, eine substituierte oder unsubstituierte Alkyl- oder Alkenyl-sulfinylgruppe, eine substituierte oder unsubstituierte Arylsulfinylgruppe, eine substituierte oder unsubstituierte Suifamoytgruppe, eine substituierte oder unsubstituierte Carbamoylgruppe, eine Hydroxygruppe oder eine Oxyradikalgruppe bedeutet; und $R_{200}$ einen einwertigen Substituenten bedeutet.

**9.** Ultraviolettabsorptionsmitteldispersion, umfassend die Ultraviolettabsorptionsmittelzusammensetzung nach einem der Ansprüche 1 bis 8.

**10.** Ultraviolettabsorptionsmittellösung, umfassend die Ultraviolettabsorptionsmittelzusammensetzung nach einem der Ansprüche 1 bis 8.

**11.** Polymermaterial, umfassend die Ultraviolettabsorptionsmittelzusammensetzung nach einem der Ansprüche 1 bis 8.

## Revendications

**1.** Composition absorbant l'ultraviolet, comprenant au moins un composé absorbant l'ultraviolet représenté par la formule (2) ou (B-I), et au moins un composé représenté par la formule (TS-I) ou (TS-II) :

[Formule chimique 1]

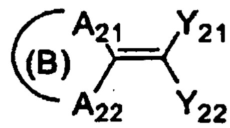

Formule (2)

dans laquelle $A_{21}$ et $A_{22}$ représentent chacun un hétéroatome ; $Y_{21}$ et $Y_{22}$ représentent chacun indépendamment un atome d'hydrogène ou un substituant monovalent ; au moins un groupe $Y_{21}$ ou $Y_{22}$ représente un substituant ayant une constante de substituant de Hammett σp supérieure ou égale à 0,2 ; $Y_{21}$ et $Y_{22}$ peuvent être reliés entre eux pour former un anneau ; et (B) représente un groupe d'atomes nécessaires pour former un anneau à cinq ou six éléments avec $A_{21}$, $A_{22}$ et l'atome de carbone ;

[Formule chimique 2]

Formule (B– I)

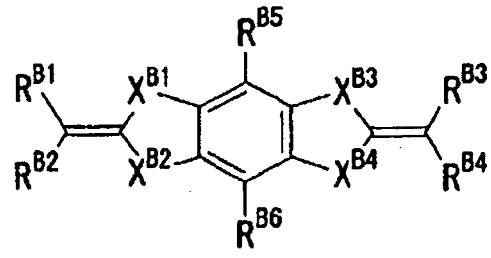

dans laquelle $R^{B1}$, $R^{B2}$, $R^{83}$ et $R^{B4}$ représentent chacun indépendamment un atome d'hydrogène ou un substituant monovalent ; $R^{B5}$ et $R^{B6}$ représentent chacun indépendamment un atome d'hydrogène ou un substituant monovalent ; et $X^{B1}$, $X^{B2}$, $X^{B3}$ et $X^{B4}$ représentent chacun indépendamment un hétéroatome ;

[Formule chimique 3]

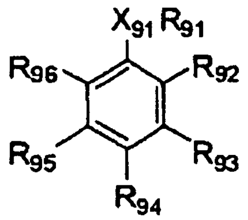

(TS-I)

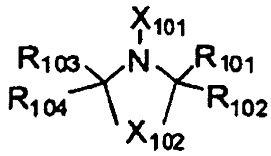

(TS-II)

dans laquelle, dans la formule (TS-I), $R_{91}$ représente un atome d'hydrogène, un groupe alkyle substitué ou non substitué, un groupe alcényle substitué ou non substitué, un groupe aryle substitué ou non substitué, un groupe hétérocyclique substitué ou non substitué, un groupe acyle substitué ou non substitué, un groupe alkyl- ou alcényl-oxycarbonyle substitué ou non substitué, un groupe aryloxycarbonyle substitué ou non substitué, un groupe alkylsulfonyle substitué ou non substitué, un groupe arylsulfonyle substitué ou non substitué, ou -Si ($R_{97}$) ($R_{98}$) ($R_{99}$), dans lequel $R_{97}$, $R_{98}$ et $R_{99}$, qui peuvent être identiques ou différents entre eux, représentent chacun indépendamment un groupe alkyle, un groupe alcényle, un groupe aryle, un groupe alcoxyle, un groupe alcényloxy, ou un groupe aryloxy ; - $X_{91}$- représente -O-, -S- ou -N(-$R_{100}$)-, dans lequel $R_{100}$ a la même signification que $R_{91}$ ; $R_{92}$, $R_{93}$, $R_{94}$, $R_{95}$ et $R_{96}$, qui peuvent être identiques ou différents entre eux, représentant chacun indépendamment un atome d'hydrogène ou un substituant ; et les groupes $R_{91}$, $R_{92}$, $R_{93}$, $R_{94}$, $R_{95}$, $R_{96}$ et $R_{100}$ ne peuvent pas tous représenter simultanément un atome d'hydrogène, respectivement, et le nombre total d'atomes de carbone est supérieur ou égal à 10 ; et

dans laquelle, dans la formule (TS-II), $R_{101}$, $R_{102}$, $R_{103}$ et $R_{104}$ représentent chacun indépendamment un atome d'hydrogène, un groupe alkyle substitué ou non substitué, ou un groupe alcényle substitué ou non substitué ; chaque combinaison de $R_{101}$ et $R_{102}$ et/ou $R_{103}$ et $R_{104}$ peuvent être reliés entre eux pour former un anneau de 5 à 7 éléments ; $X_{101}$ représente un atome d'hydrogène, un groupe alkyle substitué ou non substitué, un groupe alcényle substitué ou non substitué, un groupe alcoxyle substitué ou non substitué, un groupe alcényloxy substitué ou non substitué, un groupe alkyl- ou alcényl-oxycarbonyle substitué ou non substitué, un groupe aryloxycarbonyle substitué ou non substitué, un groupe acyle substitué ou non substitué, un groupe acyloxy substitué ou non substitué, un groupe alkyloxycarbonyloxy substitué ou non substitué, un groupe alcényloxycarbonyloxy substitué ou non substitué, un groupe aryloxycarbonyloxy substitué ou non substitué, un groupe alkyl- ou alcényl-sulfonyle substitué ou non substitué, un groupe arylsulfonyle substitué ou non substitué, un groupe alkyl- ou alcényl-sulfinyle substitué ou non substitué, un groupe arylsulfinyle substitué ou non substitué, un groupe sulfamoyle substitué ou non substitué, un groupe carbamoyle substitué ou non substitué, un groupe hydroxy ou un groupe à radical oxy ; et $X_{102}$ représente un groupe d'hétéroatomes nécessaires pour former un anneau de 5 à 7 éléments ;

dans laquelle le contenu total du composé absorbant l'ultraviolet représenté par la formule (2) ou (B-I) est supérieur à 0 % en masse et inférieur ou égal à 80 % en masse de la composition totale.

**2.** Composition absorbant l'ultraviolet selon la revendication 1, dans laquelle le composé absorbant l'ultraviolet représenté par la formule (2) est un composé absorbant l'ultraviolet représenté par la formule (3) :

[Formule chimique 4]

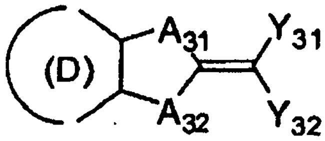

Formule (3)

dans laquelle $A_{31}$ et $A_{32}$ représentent chacun indépendamment un hétéroatome sélectionné parmi le groupe constitué par un atome d'oxygène, un atome d'azote et un atome de soufre ; $Y_{31}$ et $Y_{32}$ représentent chacun indépendamment un atome d'hydrogène ou un substituant monovalent ; au moins un groupe $Y_{31}$ ou $Y_{32}$ représente un substituant présentant une constante de substituant de Hammett σp supérieure ou égale à 0,2 ; $Y_{31}$ et $Y_{32}$ peuvent être reliés entre eux pour former un anneau ; et (D) représente un groupe d'atomes nécessaires pour former un anneau à cinq ou six éléments avec les atomes de carbone.

**3.** Composition absorbant l'ultraviolet selon la revendication 2, dans laquelle le composé absorbant l'ultraviolet représenté par la formule (3) est un composé absorbant l'ultraviolet représenté par la formule (4) :

[Formule chimique 5]

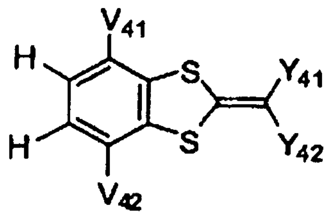

Formule (4)

dans laquelle $Y_{41}$ et $Y_{42}$ représentent chacun indépendamment un substituant monovalent ; au moins un des groupes $Y_{41}$ et $Y_{42}$ représente un groupe cyano, et l'autre représente un groupe alkylcarbonyle substitué ou non substitué, un groupe arylcarbonyle substitué ou non substitué, un groupe carbonyle hétérocyclique substitué ou non substitué, un groupe alkylsulfonyle substitué ou non substitué, ou un groupe arylsulfonyle substitué ou non substitué ; et $V_{41}$ et $V_{42}$ représentent chacun indépendamment un atome d'hydrogène ou un substituant monovalent.

**4.** Composition absorbant l'ultraviolet selon la revendication 1, dans laquelle le composé absorbant l'ultraviolet représenté par la formule (B-I) est un composé absorbant l'ultraviolet représenté par la formule (B-Ia) :

[Formule chimique 6]

Formule (B-Ia)

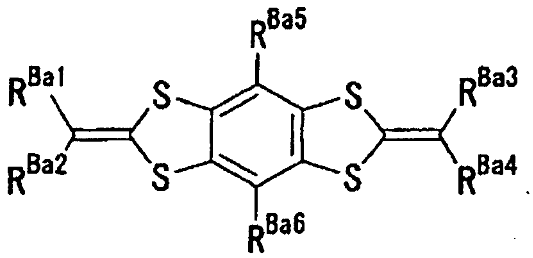

dans laquelle $R^{Ba1}$, $R^{Ba2}$, $R^{Ba3}$ et $R^{Ba4}$ représentent chacun indépendamment un substituant monovalent ; au moins un des groupes $R^{Ba1}$, $R^{Ba2}$, $R^{Ba3}$ et $R^{Ba4}$ représente un groupe cyano, un groupe alkoxycarbonyle substitué ou non substitué, un groupe aryloxycarbonyle substitué ou non substitué, un groupe carbamoyle substitué ou non substitué, un groupe alkylcarbonyle substitué ou non substitué, un groupe arylcarbonyle substitué ou non substitué, un groupe alkylsulfonyle substitué ou non substitué, ou un groupe arylsulfonyle substitué ou non substitué, et les autres sont

un groupe cyano, un groupe carbamoyle substitué ou non substitué, un groupe sulfamoyle substitué ou non substitué, un groupe nitro, un groupe acyle substitué ou non substitué, un groupe alkylsulfonyle substitué ou non substitué, un groupe arylsulfonyle substitué ou non substitué, un groupe alkylsulfinyle substitué ou non substitué, un groupe arylsulfinyle substitué ou non substitué, un groupe alkoxycarbonyle substitué ou non substitué, un groupe aryloxycarbonyle substitué ou non substitué, un groupe alkyle substitué ou non substitué, un groupe aryle substitué ou non substitué, ou un groupe hétérocyclique substitué ou non substitué ; et $R^{Ba5}$ et $R^{Ba6}$ représentent chacun indépendamment un groupe alcoxyle substitué ou non substitué, un groupe aryloxy substitué ou non substitué, un groupe acyloxy substitué ou non substitué, un groupe alkoxycarbonyloxy substitué ou non substitué, un groupe aryloxycarbonyloxy substitué ou non substitué, un groupe carbamoyloxy substitué ou non substitué, un groupe amine substitué ou non substitué, un groupe acylamino substitué ou non substitué, ou un groupe carbamoylamino substitué ou non substitué.

5. Composition absorbant l'ultraviolet selon l'une quelconque des revendications 1 à 4, dans laquelle le contenu total du composé représenté par la formule (TS-I) ou (TS-II) est supérieur à 0 % en masse et inférieur ou égal à 80 % en masse de la composition totale.

6. Composition absorbant l'ultraviolet selon l'une quelconque des revendications 1 à 5, dans laquelle un rapport de mélange du composé absorbant l'ultraviolet représenté par la formule (2) ou (B-I) par le composé représenté par la formule (TS-I) ou (TS-II) est compris entre 1:5 et 5:1.

7. Composition absorbant l'ultraviolet selon l'une quelconque des revendications 1 à 6, comprenant le composé représenté par la formule (TS-II).

8. Composition absorbant l'ultraviolet selon l'une quelconque des revendications 1 à 7, dans laquelle le composé représenté par la formule (TS-II) est un composé représenté par la formule (TS-IIa) :

[Formule chimique 7]

Formule (TS-IIa)

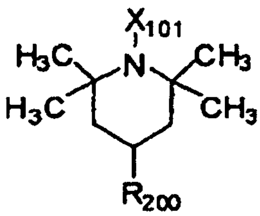

dans laquelle $X_{101}$ représente un atome d'hydrogène, un groupe alkyle substitué ou non substitué, un groupe alcényle substitué ou non substitué, un groupe alcoxyle substitué ou non substitué, un groupe alcényloxy substitué ou non substitué, un groupe alkyl- ou alcényl-oxycarbonyle substitué ou non substitué, un groupe aryloxycarbonyle substitué ou non substitué, un groupe acyle substitué ou non substitué, un groupe acyloxy substitué ou non substitué, un groupe alkyloxycarbonyloxy substitué ou non substitué, un groupe alcényloxycarbonyloxy substitué ou non substitué, un groupe aryloxycarbonyloxy substitué ou non substitué, un groupe alkyl- ou alcényl-sulfonyle substitué ou non substitué, un groupe arylsulfonyle substitué ou non substitué, un groupe alkyl- ou alcényl-sulfinyle substitué ou non substitué, un groupe arylsulfinyle substitué ou non substitué, un groupe sulfamoyle substitué ou non substitué, un groupe carbamoyle substitué ou non substitué, un groupe hydroxy ou un groupe à radical oxy ; et $R_{200}$ représente un substituant monovalent.

9. Dispersion absorbant l'ultraviolet, comprenant la composition absorbant l'ultraviolet selon l'une quelconque des revendications 1 à 8.

10. Solution absorbant l'ultraviolet, comprenant la composition absorbant l'ultraviolet selon l'une quelconque des revendications 1 à 8.

11. Matériau polymère comprenant la composition absorbant l'ultraviolet selon l'une quelconque des revendications 1 à 8.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5339033 A
- JP 5345639 A
- JP 6056466 A
- JP 6145387 A
- JP 2003177235 A
- JP 2005517787 T
- JP 7285927 A
- JP 60170842 A
- JP 49011155 B
- JP 2008052041 A
- JP 2004117997 A
- JP 49001115 A
- JP 4338759 A
- JP 3054566 A
- JP 63225382 A
- JP 6080672 A
- DE 3728452
- JP 51100097 A
- JP 5506428 T
- JP 1053455 B
- JP 61189530 A
- JP 62260152 A
- JP 63053544 A
- JP 63056651 A
- EP 27242 A
- WO 2006009451 A
- JP 2037575 B
- JP 2050457 B
- JP 2066541 A
- JP 2139544 A
- JP 3200758 A
- JP 3048845 A
- JP 3266836 A
- JP 3096944 A
- JP 2032298 B
- JP 3039296 B
- JP 3040373 B
- JP 2049762 A
- JP 2208653 A
- JP 2217845 A
- US 4906555 A
- EP 309400 A2
- EP 309401 A1
- EP 309402 A1
- JP 55129136 A
- JP 58209735 A
- JP 63264748 A
- JP 4191851 A
- JP 8272058 A
- GB 2016017 A
- JP 2002053824 A
- US 5807932 A
- US 4259467 A
- US 4355147 A
- JP 8208765 A
- JP 8151455 A
- JP 8245849 A
- JP 10168292 A
- JP 2004285189 A
- JP 2001323082 A
- JP 10298397 A
- JP 11315175 A
- JP 2001026081 A
- JP 2005305745 A
- JP 2003524019 T
- JP 2004050460 A
- JP 2004243674 A
- JP 2006240734 A
- JP 11034261 A
- JP 2003237825 A
- JP 8080928 A
- JP 2004051174 A
- JP 8301363 A
- JP 11276550 A
- JP 2006271781 A
- JP 7287353 A
- JP 2000056433 A
- JP 2005178832 A
- JP 2003200966 A
- JP 2006323339 A
- JP 2006224317 A
- JP 2002160321 A
- JP 2005156220 A
- JP 2005146278 A
- JP 2006130807 A
- JP 2005 A
- JP 305745 A
- JP 9142539 A
- JP 9157626 A
- JP 8324572 A
- JP 2001048153 A
- JP 2005105004 A
- JP 2006001568 A
- JP 2000238857 A
- JP 2001088815 A
- JP 7216152 A
- JP 2001270531 A
- JP 2004083858 A

- JP 2001114262 A
- JP 2001213427 A
- JP 7242444 A
- JP 8133787 A
- JP 2005320408 A
- JP 5139434 A
- JP 7289665 A
- JP 9295664 A
- JP 9058687 A
- JP 8155007 A
- JP 2006298456 A
- JP 9086570 A
- JP 9113494 A
- JP 9239910 A
- JP 11180474 A
- JP 2002068322 A
- JP 2005278678 A
- JP 11290420 A
- JP 2001106218 A
- WO 0493775 A
- JP 5305975 A
- JP 7040954 A
- JP 10237312 A
- JP 2000152974 A
- JP 2002264979 A
- JP 2005255736 A
- JP 2002370723 A
- JP 9241407 A
- JP 8091385 A
- JP 9048935 A
- JP 11514387 T
- JP 2000066603 A
- JP 2005105032 A
- WO 9929490 A
- JP 11255925 A
- JP 7026177 A
- JP 9169950 A
- JP 9221631 A
- JP 2002080788 A
- JP 10088039 A
- JP 2001055541 A
- JP 8081643 A
- JP 2000186234 A
- JP 7166112 A
- JP 2002294165 A
- JP 2000273362 A
- JP 2001279189 A
- JP 2002271227 A
- JP 2001009357 A
- JP 2001316630 A
- JP 2002356655 A
- JP 2004000937 A
- JP 2004002700 A
- JP 2004169182 A
- JP 2004107700 A
- JP 6049368 A
- JP 2002038084 A
- JP 2005307161 A
- JP 5078606 A
- JP 5185031 A
- JP 10140089 A
- JP 2000509082 T
- JP 2004520284 T
- WO 2006097201 A
- JP 6001945 A
- JP 6313148 A
- JP 7003189 A
- JP 7082454 A
- JP 7118576 A
- JP 2004217727 A
- JP 2005314495 A
- JP 10298493 A
- JP 9241534 A
- JP 2002235028 A
- JP 2000345109 A
- JP 6346022 A
- JP 2002167545 A
- JP 8324576 A
- JP 9012924 A
- JP 9157581 A
- JP 9059539 A
- JP 2001181558 A
- JP 10183057 A
- JP 2001115080 A
- JP 2001262056 A
- JP 9263729 A
- JP 2001288410 A
- JP 2002069331 A
- JP 2002080781 A
- JP 2003525325 T
- JP 2004162021 A
- JP 2006233010 A
- JP 11514689 T
- JP 2001059068 A
- JP 2006160847 A
- JP 8003502 A
- JP 2006521941 T
- JP 2005533915 T
- JP 11504954 T
- JP 5254277 A
- JP 2006030596 A
- JP 11199808 A
- WO 9967337 A
- JP 2005325150 A
- JP 2005350559 A
- JP 2006008811 A
- JP 2006514130 T
- JP 2006257165 A
- JP 8108650 A
- JP 2005023111 A
- JP 2004075888 A
- JP 7164729 A
- JP 2006022300 A
- JP 2006070190 A
- JP 2002127596 A
- JP 5117508 A

- JP 7119036 A
- JP 7196631 A
- JP 8188921 A
- JP 10237760 A
- JP 2000054287 A
- JP 2006299428 A
- JP 2006299438 A
- JP 2002322360 A
- JP 2006265770 A
- JP 7076580 A
- JP 2001348785 A
- JP 2003041434 A
- JP 2003239136 A
- WO 032661 A
- JP 10251981 A
- JP 6228816 A
- JP 2005517822 T
- JP 6228818 A
- JP 5009870 A
- JP 10001587 A
- JP 2002212884 A
- JP 2006016710 A
- JP 5148703 A
- JP 2004 A
- JP 285516 A
- JP 2004285517 A
- JP 2003339503 A
- JP 2004011062 A
- JP 11302982 A
- JP 7289097 A
- JP 10001868 A
- JP 5256464 A
- JP 5193037 A
- JP 6114991 A
- JP 11247028 A
- JP 2000144583 A
- JP 7018584 A
- JP 8041785 A
- JP 8193136 A
- JP 8269850 A
- JP 8284063 A
- JP 9057889 A
- JP 9137335 A
- JP 10165045 A
- JP 11247027 A
- JP 7310283 A
- JP 2003528974 T
- JP 2001030861 A
- JP 7324283 A
- JP 8020579 A
- JP 2003147617 A
- JP 10006451 A
- JP 10016152 A
- JP 2002161158 A
- JP 2003049065 A
- JP 2003160724 A
- JP 10205056 A
- JP 8151457 A
- JP 2001172531 A
- JP 7003955 A
- JP 2006266042 A
- JP 8197511 A
- JP 9183159 A
- JP 11236734 A
- JP 11300880 A
- JP 2001009811 A
- JP 2003328523 A
- JP 2002226764 A
- JP 2006306020 A
- JP 9277414 A
- JP 7269016 A
- JP 2003211538 A
- JP 9239921 A
- JP 9254345 A
- JP 10044352 A
- JP 8073825 A
- JP 8207218 A
- JP 2003082608 A
- JP 2001139700 A
- JP 5253559 A
- JP 20052941780 A
- JP 2000226778 A
- JP 2003 A
- JP 211538 A
- JP 2003211606 A
- JP 2004003191 A
- JP 9309260 A
- JP 2002178625 A
- JP 2002212237 A
- JP 2003266926 A
- JP 2003266927 A
- JP 2004181813 A
- JP 10203033 A
- JP 2001249430 A
- JP 8258415 A
- JP 9095055 A
- JP 2003145949 A
- JP 2006167996 A
- JP 2002367227 A
- JP 2006301268 A
- JP 2006293155 A
- JP 9306344 A
- JP 2000223271 A
- JP 2005189645 A
- JP 2000174296 A
- JP 2006282970 A
- JP 2006310461 A
- JP 2006257144 A
- JP 2006210906 A
- JP 2003168814 A
- JP 2005129713 A
- JP 227843 A
- JP 2004168057 A
- JP 11040833 A
- JP 2005129926 A
- JP 2000091611 A

- JP 2005346999 A
- JP 2000091610 A
- JP 11261085 A
- JP 11214736 A
- JP 2001261904 A
- JP 8102296 A
- JP 2000067629 A
- JP 2005353554 A
- JP 5272076 A
- JP 2003239181 A
- JP 2006063162 A
- JP 2007093649 A
- JP 2001214121 A
- JP 2001214122 A
- JP 2001315263 A
- JP 2003206422 A
- JP 2003025478 A
- JP 2004137457 A
- JP 2005132999 A
- JP 2002036441 A
- JP 10250004 A
- JP 2002036452 A
- JP 2003039607 A
- JP 2004114355 A
- JP 2002113937 A
- JP 2002293706 A
- JP 2006274179 A
- JP 2005326761 A
- JP 2006335855 A
- JP 10034841 A
- JP 2002114879 A
- JP 2004532306 T
- JP 2004530024 T
- JP 2004525273 T
- JP 10194796 A
- JP 10287804 A
- JP 2000071626 A
- JP 2001159228 A
- JP 2002127310 A
- JP 2002189415 A
- JP 2002130591 A
- JP 2002307619 A
- JP 2002307845 A
- JP 2006316395 A
- JP 2004352847 A
- JP 2000224942 A
- JP 8208976 A
- JP 8318592 A
- JP 2005504735 A
- JP 2005037642 A
- JP 2005055615 A
- JP 9300537 A
- JP 2000025180 A
- JP 2003019776 A
- JP 2005074735 A
- JP 2001207144 A
- JP 2002543265 T
- JP 2002543266 T
- US 6225384 B
- JP 2004352783 A
- JP 7268253 A
- JP 2003253265 A
- JP 2005105131 A
- JP 2005300962 A
- JP 3915339 B
- JP 2005304340 A
- JP 2005044154 A
- JP 2006274197 A
- JP 2006089697 A
- JP 2000231044 A
- JP 2002527559 T
- JP 320408 A
- JP 2003020966 A
- JP 2006266402 A
- JP 2002207845 A
- JP 20025443265 T
- JP 2007093061 A
- JP 2007213951 A

**Non-patent literature cited in the description**

- Lange's Handbook of Chemistry. McGraw-Hill, 1979
- Kagaku no Ryoiki. Nankodo, 1979, 96-103
- *Chem.Rev.,* 1991, vol. 91, 165-195
- *Chem. Rev.,* 1991, vol. 91, 165-195
- *Journal of Chemical Crystallography,* 1997, vol. 27, 516
- *Bioorganic & Medicinal Chemistry Letters,* 1997, vol. 7, 652
- *Journal of Organic Chemistry,* 1978, vol. 43, 2153
- *Synthesis,* 1986, 968
- *Liebigs Ann. Chem,* 1969, vol. 726, 103-109
- *Journal of Organic Chemistry,* 1990, vol. 55, 5347-5350
- *JOURNAL OF ORGANIC CHEMISTRY,* 1994, vol. 59, 3077-3081
- *Tetrahedron Letters,* 1991, vol. 32, 4897-4900
- *TETRAHEDRON LETTERS,* 1977, vol. 26, 2225
- *Tetrahedron,* 1993, vol. 49, 3035-3042
- *Journal of the American Chemical Society,* 1958, vol. 80, 1662-1664
- *JOURNAL OF THE AMERICAN CHEMICAL SOCIETY,* 1958, vol. 117, 9995-10002
- *Phosphorus, Sulfur, and Silicon,* 2004, vol. 120, 121, 121-143
- *Chem. Commun.,* 2004, 1758-1759
- Development of Polymer Additives and Environmental Measures. CMC Publishing, 2003

- New Trend of Functional Polymer Additives. Toray Research Center Inc, 1999
- Fine Chemicals. Toray Research Center Inc, 2004, 28-32
- New Trend of Functional Polymer Additives. Toray Research Center Inc, 96-140
- Development of Polymer Additives and Environmental Measures. CMC Publishing, 2003, 54-64
- Methods for Improving the Photostability of Polymers. CMC Publishing, 2000, 85-107
- Basis and Physical Properties of High Functional Coatings. CMC Publishing, 2003, 314-359
- Durability of Polymer Materials and Composite Material Products. CMC Publishing, 2005
- Elongation of Lifetime of Polymer Materials and Environmental Measures. CMC Publishing, 2000
- Plastics Additives Handbook. Hanser Publishers, 238-244
- Basic Seminar 2. Science of Plastic Packaging Container. Tadahiko Kutsura. Society of packaging Science & Technology, 2003